# EUROPEAN PATENT APPLICATION

(11) **EP 4 394 510 A1**
(43) Date of publication of application: **03.07.2024**
(21) Application number: 22861257.8
(22) Date of filing: 19.08.2022
(51) Int. Cl.: G03F 7/038, G03F 7/039, G03F 7/20, G03F 7/32, H01L 21/027

(54) **CHEMICAL SOLUTION AND PATTERN FORMATION METHOD**

(30) Priority: 25.08.2021 JP 2021137202
(71) Applicant: FUJIFILM Corporation, Tokyo 106-8620 (JP)
(72) Inventor: TAKAHASHI, Satomi, Haibara-gun, Shizuoka 421-0396 (JP); SHIMIZU, Tetsuya, Haibara-gun, Shizuoka 421-0396 (JP); SHIRAKAWA, Michihiro, Haibara-gun, Shizuoka 421-0396 (JP)
(74) Representative: HGF
(86) International application number: PCT/JP2022/031332
(87) International publication number: WO 2023/026969

(57) **Abstract**

The present invention provides a chemical liquid that provides a pattern with good resolution and that also has a good ability to suppress the occurrence of defects when the pattern is formed using the chemical liquid as a developer or a rinsing liquid. The chemical liquid according to the present invention is a chemical liquid including an aromatic hydrocarbon, an organic solvent other than the aromatic hydrocarbon, and metal X. The aromatic hydrocarbon is composed only of hydrogen atoms and carbon atoms. A content of the aromatic hydrocarbon is 1 mass% or less relative to a total mass of the chemical liquid. The organic solvent includes an aliphatic hydrocarbon. The metal X is at least one metal selected from the group consisting of Al, Fe, and Ni. A mass ratio of the content of the aromatic hydrocarbon to a content of the metal X is 5.0 × 10⁴ to 2.0 × 10¹⁰.

## Description

### BACKGROUND OF THE INVENTION

### 1. Field of the Invention

The present invention relates to a chemical liquid and a pattern forming method.

### 2. Description of the Related Art

Hitherto, in a process for producing a semiconductor device such as an integrated circuit (IC) or a large scale integrated circuit (LSIC), microfabrication by a photolithography process using a photoresist composition has been performed.

In such a photolithography process, for example, after a coating film is formed using a photoresist composition (an actinic ray-sensitive or radiation-sensitive resin composition), the resulting coating film is exposed and then developed with a developer to obtain a pattern, and furthermore, the cured film after the development is cleaned with a rinsing liquid.

For example, JP2011-065105A discloses a developer including, as organic solvents, a solvent (S-1) serving as a good solvent for a resist film before exposure and a solvent (S-2) serving as a poor solvent for the resist film before exposure.

### SUMMARY OF THE INVENTION

The inventors of the present invention have found that when a pattern is formed using a developer as described in JP2011-065105A as a developer or a rinsing liquid, it is difficult to achieve both the resolution of the obtained pattern and the suppression of the occurrence of defects. In particular, it is difficult to achieve both the above two performances in the formation of a pattern with higher resolution.

Accordingly, an object of the present invention is to provide a chemical liquid that provides a pattern with good resolution and that also has a good ability to suppress the occurrence of defects when the pattern is formed using the chemical liquid as a developer or a rinsing liquid.

As a result of intensive studies to achieve the above object, the inventors of the present invention have found that the above object can be achieved by the following configurations.
[1] A chemical liquid including an aromatic hydrocarbon; an organic solvent other than the aromatic hydrocarbon; and metal X,
   wherein the aromatic hydrocarbon is composed only of hydrogen atoms and carbon atoms,
   a content of the aromatic hydrocarbon is 1 mass% or less relative to a total mass of the chemical liquid,
   the organic solvent includes an aliphatic hydrocarbon,
   the metal X is at least one metal selected from the group consisting of Al, Fe, and Ni, and,
   a mass ratio of the content of the aromatic hydrocarbon to a content of the metal X is 5.0 × 10⁴ to 2.0 × 10¹⁰.
[2] The chemical liquid according to [1], wherein the chemical liquid is used as a developer or a rinsing liquid.
[3] The chemical liquid according to [1] or [2], wherein the aromatic hydrocarbon includes at least one selected from the group consisting of C₁₀H₁₄, C₁₁H₁₆, and C₁₀H₁₂, and
   the content of the aromatic hydrocarbon is 5 to 2,000 mass ppm relative to the total mass of the chemical liquid.
[4] The chemical liquid according to any one of [1] to [3], further including:
   a sulfur-containing compound,
   wherein the aromatic hydrocarbon includes at least one selected from the group consisting of C₁₀H₁₄, C₁₁H₁₆, and C₁₀H₁₂, and
   a content of the C₁₀H₁₄, a content of the C₁₁H₁₆, and a content of the C₁₀H₁₂ are each higher than a content of the sulfur-containing compound.
[5] The chemical liquid according to any one of [1] to [4], further including:
   a sulfur-containing compound,
   wherein a mass ratio of the content of the aromatic hydrocarbon to a content of the sulfur-containing compound is 1 or more.
[6] The chemical liquid according to any one of [1] to [5], including three or more of the aromatic hydrocarbons.
[7] The chemical liquid according to any one of [1] to [6], further including:
   water,
   wherein a content of the water is 20 to 1,000 mass ppm relative to the total mass of the chemical liquid.
[8] The chemical liquid according to any one of [1] to [7], wherein a content of at least one of the Al, the Fe, or the Ni is 0.1 to 100 mass ppt relative to the total mass of the chemical liquid.
[9] The chemical liquid according to any one of [1] to [8], wherein the aliphatic hydrocarbon includes at least one selected from the group consisting of decane, undecane, dodecane, and methyldecane.
[10] The chemical liquid according to any one of [1] to [9], further including:
   an alcohol compound,
   wherein a mass ratio of the content of the aromatic hydrocarbon to a content of the alcohol compound is 0.001 to 200.
[11] The chemical liquid according to [10], wherein the alcohol compound includes at least one selected from the group consisting of ethanol, 1-propanol, 2-propanol, 1-butanol, 2-butanol, tert-butanol, 1-pentanol, 2-pentanol, 3-pentanol, and 2-methyl-1-butanol.
[12] The chemical liquid according to any one of [1] to [11], wherein the organic solvent further includes an ester-based solvent.
[13] The chemical liquid according to any one of [1] to [12],
   wherein, in a pattern forming method including a resist film-forming step of forming a resist film using an actinic ray-sensitive or radiation-sensitive resin composition,
   an exposure step of exposing the resist film, and
   a developing step of developing the exposed resist film with a developer,
   the chemical liquid is used as the developer.
[14] The chemical liquid according to any one of [1] to [12],
   wherein, in a pattern forming method including a resist film-forming step of forming a resist film using an actinic ray-sensitive or radiation-sensitive resin composition,
   an exposure step of exposing the resist film,
   a developing step of developing the exposed resist film with butyl acetate, and
   a cleaning step of performing cleaning with a rinsing liquid after the developing step,
   the chemical liquid is used as the rinsing liquid.
[15] The chemical liquid according to any one of [1] to [12],
   wherein, in a pattern forming method including a resist film-forming step of forming a resist film using an actinic ray-sensitive or radiation-sensitive resin composition,
   an exposure step of exposing the resist film,
   a developing step of developing the exposed resist film with a developer, and
   a cleaning step of performing cleaning with a rinsing liquid after the developing step,
   the chemical liquid is used as the developer and the rinsing liquid.
[16] A pattern forming method including:
   a resist film-forming step of forming a resist film using an actinic ray-sensitive or radiation-sensitive resin composition;
   an exposure step of exposing the resist film;
   a developing step of developing the exposed resist film with a developer; and
   a cleaning step of performing cleaning with a rinsing liquid after the developing step,
   wherein the chemical liquid according to any one of [1] to [12] is used as the developer and the rinsing liquid, and
   a content of the aliphatic hydrocarbon relative to the organic solvent in the chemical liquid used as the rinsing liquid is higher than a content of the aliphatic hydrocarbon relative to the organic solvent in the chemical liquid used as the developer.

The present invention can provide a chemical liquid that provides a pattern with good resolution and that also has a good ability to suppress the occurrence of defects when the pattern is formed using the chemical liquid as a developer or a rinsing liquid.

### DESCRIPTION OF THE PREFERRED EMBODIMENTS

The present invention will be described in detail below.

The constituent features described below may be described based on representative embodiments of the present invention; however the present invention is not limited to such embodiments.

With respect to expressions of groups (atomic groups) in the present specification, unless otherwise specified, an expression without the term of substituted or unsubstituted encompasses groups having no substituent and also groups having a substituent. For example, "alkyl group" encompasses not only an alkyl group having no substituent (unsubstituted alkyl group) but also an alkyl group having a substituent (substituted alkyl group). In the present specification, "organic group" refers to a group including at least one carbon atom.

The substituent is preferably a monovalent substituent unless otherwise specified.

In the present specification, "actinic ray" or "radiation" means, for example, an emission-line spectrum of a mercury lamp, far ultraviolet rays represented by an excimer laser, extreme ultraviolet rays (EUV light: Extreme Ultraviolet), X-rays, or an electron beam (EB: Electron Beam). In the present specification, "light" means an actinic ray or a radiation.

In the present specification, "exposure" includes, unless otherwise specified, not only exposure with, for example, an emission-line spectrum of a mercury lamp, far ultraviolet rays represented by an excimer laser, extreme ultraviolet rays, X-rays, or EUV light but also patterning with an electron beam or a corpuscular beam such as an ion beam.

In the present specification, a range of numerical values expressed with "to" mean a range that includes a numerical value before "to" as a lower limit and a numerical value after "to" as an upper limit.

The bonding direction of a divalent group expressed in the present specification is not limited unless otherwise specified. For example, in a compound represented by a formula "X-Y-Z" where Y is -COO-, Y may be -CO-O- or -O-CO-. Furthermore, the compound may be "X-CO-O-Z" or "X-O-CO-Z".

In the present specification, "(meth)acrylate" is a concept encompassing both acrylate and methacrylate. "(Meth)acrylic" is a concept encompassing both acrylic and methacrylic.

In the present specification, a weight-average molecular weight (Mw), a number-average molecular weight (Mn), and a dispersity (Mw/Mn, hereinafter, also referred to as a "molecular weight distribution") of a resin are polystyrene equivalent values determined, using a GPC (Gel Permeation Chromatography) apparatus (HLC-8120GPC, manufactured by Tosoh Corporation), by GPC measurement (solvent: tetrahydrofuran, amount of flow (amount of sample injected): 10 µL, column: TSK gel Multipore HXL-M (manufactured by Tosoh Corporation), column temperature: 40°C, flow rate: 1.0 mL/min, detector: differential refractive index detector (Refractive Index Detector)).

In the present specification, "ppm" means "parts-per-million(10⁻⁶)", "ppb" means "parts-per-billion (10⁻⁹)", and "ppt" means "parts-per-trillion (10⁻¹²)".

In the present specification, the acid dissociation constant (pKa) represents pKa in an aqueous solution, and specifically, a value based on the Hammett's substituent constants and the database of values in publicly known documents can be determined by calculation using the following software package 1. All the values of pKa described in the present specification are values determined by calculation using this software package.

### Software package 1: Advanced Chemistry Development (ACD/Labs) Software V8.14 for Solaris (1994-2007 ACD/Labs)

Alternatively, pKa can also be determined by a molecular orbital calculation method. A specific method thereof may be a method of achieving the determination by calculating H⁺ dissociation free energy in an aqueous solution on the basis of a thermodynamic cycle. With regard to the method of calculating H⁺ dissociation free energy, for example, the calculation can be performed by DFT (density functional theory); however, various other methods have been reported in documents etc., and the method is not limited to this. Software capable of performing DFT is, for example, Gaussian 16.

As described above, pKa in the present specification refers to a value determined by calculation using the software package 1 on the basis of the Hammett's substituent constants and the database of values in publicly known documents; however, when pKa cannot be calculated by this method, a value determined using Gaussian 16 on the basis of DFT (density functional theory) is employed.

In addition, as described above, pKa in the present specification refers to "pKa in an aqueous solution"; however, when pKa in an aqueous solution cannot be calculated, "pKa in a dimethyl sulfoxide (DMSO) solution" is employed.

In the present specification, examples of halogen atoms include a fluorine atom, a chlorine atom, a bromine atom, and an iodine atom.

In the present specification, "solid content" means a component forming a resist film and does not include solvents. Even when a component has the form of liquid, the component is regarded as a solid content as long as it is a component forming the resist film.

### [Chemical liquid]

A chemical liquid is
a chemical liquid including an aromatic hydrocarbon, an organic solvent other than the aromatic hydrocarbon, and metal X,
wherein the aromatic hydrocarbon is composed only of hydrogen atoms and carbon atoms,
a content of the aromatic hydrocarbon is 1 mass% or less relative to a total mass of the chemical liquid,
the organic solvent includes an aliphatic hydrocarbon,
the metal X is at least one metal selected from the group consisting of Al, Fe, and Ni, and
a mass ratio of the content of the aromatic hydrocarbon to a content of the metal X is 5.0 × 10⁴ to 2.0 × 10¹⁰.

The details of the operation mechanism that use of the chemical liquid having the above configuration achieves good resolution of a pattern and has a good ability to suppress the occurrence of defects are not clear, but the inventors of the present invention presume as follows.

A feature of the above chemical liquid is, for example, the mass ratio of the content of the aromatic hydrocarbon to the content of the metal X.

In the case where the mass ratio is within the predetermined range, when a pattern is formed using the chemical liquid as a developer or a rinsing liquid, for example, an increase in the number of defects due to the metal X can be suppressed while the degradation of the resolution due to the aromatic hydrocarbon is suppressed; therefore, it is presumed that both the resolution of the pattern and the ability to suppress the occurrence of defects can be combined.

Hereinafter, providing a better effect of at least one of good resolution of a pattern or good ability to suppress the occurrence of defects is also referred to as "providing a better effect of the present invention".

The chemical liquid is preferably used in a developing step described later and a rinsing step described later. Specifically, the chemical liquid is preferably used as a developer or a rinsing liquid.

Various components which can be included in the chemical liquid will be described in detail below.

### <<First Embodiment>>

A first embodiment of the chemical liquid will be described in detail below.

The first embodiment of the chemical liquid is preferably used as a developer.

### [Aromatic hydrocarbon]

The chemical liquid includes an aromatic hydrocarbon.

The "aromatic hydrocarbon" means a hydrocarbon composed only of hydrogen atoms and carbon atoms and having an aromatic ring. The aromatic hydrocarbon is not included in an organic solvent.

The content of the aromatic hydrocarbon is 1 mass% or less, preferably 1 to 5,000 mass ppm, more preferably 5 to 2,000 mass ppm, still more preferably 5 to 200 mass ppm relative to the total mass of the chemical liquid. When the aromatic hydrocarbon includes two or more aromatic hydrocarbons, the total content of the two or more aromatic hydrocarbons is preferably within the range described above.

The number of carbon atoms of the aromatic hydrocarbon is preferably 6 to 30, more preferably 6 to 20, still more preferably 10 to 12.

The aromatic ring included in the aromatic hydrocarbon may be monocyclic or polycyclic.

The number of ring members of the aromatic ring included in the aromatic hydrocarbon is preferably 6 to 12, more preferably 6 to 8, still more preferably 6.

The aromatic ring included in the aromatic hydrocarbon may further have a substituent. The substituent may be, for example, an alkyl group, an alkenyl group, or a group provided by combining the foregoing. The alkyl group and the alkenyl group may be linear, branched, or cyclic. The number of carbon atoms of the alkyl group and the alkenyl group is preferably 1 to 10, more preferably 1 to 5.

Examples of the aromatic ring included in the aromatic hydrocarbon include a benzene ring that may have a substituent, a naphthalene ring that may have a substituent, and an anthracene ring that may have a substituent. A benzene ring that may have a substituent is preferred.

In other words, the aromatic hydrocarbon is preferably benzene that may have a substituent.

The aromatic hydrocarbon preferably includes at least one selected from the group consisting of C₁₀H₁₄, C₁₁H₁₆, and C₁₀H₁₂.

The aromatic hydrocarbon is also preferably a compound represented by Formula (c).

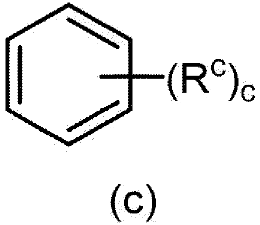

In Formula (c), R^{c} represents a substituent. c represents an integer of 0 to 6.

R^{c} represents a substituent.

The substituent represented by R^{c} is preferably an alkyl group or an alkenyl group.

The alkyl group and the alkenyl group may be linear, branched, or cyclic.

The number of carbon atoms of the alkyl group and the alkenyl group is preferably 1 to 10, more preferably 1 to 5.

When a plurality of R^{c}'s are present, the plurality of R^{c}'s may be the same or different from each other, and R^{c}'s may be bonded together to form a ring.

R^{c} (when a plurality of R^{c}'s are present, some or all of the plurality of R^{c}'s) and the benzene ring in Formula (c) may be fused to form a fused ring.

c represents an integer of 0 to 6.

c is preferably an integer of 1 to 5, more preferably an integer of 1 to 4.

The molecular weight of the aromatic hydrocarbon is preferably 50 or more, more preferably 100 or more, still more preferably 120 or more. The upper limit is preferably 1,000 or less, more preferably 300 or less, still more preferably 150 or less.

Examples of the aromatic hydrocarbon include C₁₀H₁₄ such as 1,2,4,5-tetramethyl-benzene, 1-ethyl-3,5-dimethyl-benzene, 1,2,3,5-tetramethyl-benzene, and 1-ethyl-2,4-dimethylbenzene; C₁₁H₁₆ such as 1-methyl-4-(1-methylpropyl)-benzene and (1-methybutyl)-benzene; and C₁₀H₁₂ such as 1-methyl-2-(2-propenyl)-benzene and 1,2,3,4-tetrahydro-naphthalene.

The aromatic hydrocarbon is preferably 1,2,4,5-tetramethyl-benzene, 1-ethyl-3,5-dimethyl-benzene, 1,2,3,5-tetramethyl-benzene, 1-methyl-4-(1-methylpropyl)-benzene, and C₁₀H₁₂, and more preferably 1-ethyl-3,5-dimethyl-benzene or 1,2,3,5-tetramethyl-benzene.

The aromatic hydrocarbons may be used alone or in combination of two or more thereof.

The chemical liquid preferably includes two or more aromatic hydrocarbons, more preferably includes three or more aromatic hydrocarbons, still more preferably includes three to eight aromatic hydrocarbons, particularly preferably includes three or four aromatic hydrocarbons.

The method for measuring the content of the aromatic hydrocarbon is, for example, a method for measuring the content of an organic solvent described later.

Examples of the method for adjusting the content of the aromatic hydrocarbon include a method of selecting, as raw materials constituting various components, raw materials having a low content of an aromatic hydrocarbon, a method of performing distillation under conditions in which contamination is reduced by, for example, lining the interior of apparatuses with Teflon (registered trademark), and a method of adding an aromatic hydrocarbon.

### [Organic solvent]

The chemical liquid includes an organic solvent other than the above-described aromatic hydrocarbon.

In the present specification, the organic solvent is an organic solvent that is other than the aromatic hydrocarbon described above and that is included at a content of 8,000 mass ppm or more relative to the total mass of the chemical liquid. In addition, an organic solvent included at a content of less than 8,000 mass ppm relative to the total mass of the chemical liquid corresponds to an organic impurity and does not correspond to the organic solvent. In other words, an alcohol compound described later is not included in the organic solvent but corresponds to an organic impurity.

### <Aliphatic hydrocarbon>

The organic solvent includes an aliphatic hydrocarbon.

The "aliphatic hydrocarbon" means a hydrocarbon composed only of hydrogen atoms and carbon atoms and having no aromatic ring.

The aliphatic hydrocarbon may be linear, branched, or cyclic (monocyclic or polycyclic) and is preferably linear. The aliphatic hydrocarbon may be a saturated aliphatic hydrocarbon or an unsaturated aliphatic hydrocarbon.

The number of carbon atoms of the aliphatic hydrocarbon is often 2 or more, preferably 5 or more, more preferably 10 or more. The upper limit is preferably 30 or less, more preferably 20 or less, still more preferably 15 or less, particularly preferably 13 or less. Specifically, the number of carbon atoms of the aliphatic hydrocarbon is preferably 11.

Examples of the aliphatic hydrocarbon include pentane, isopentane, hexane, isohexane, cyclohexane, ethylcyclohexane, methylcyclohexane, heptane, octane, isooctane, nonane, decane, methyldecane, undecane, dodecane, tridecane, tetradecane, pentadecane, hexadecane, heptadecane, 2,2,4-trimethylpentane, and 2,2,3-trimethylhexane.

The aliphatic hydrocarbon preferably includes an aliphatic hydrocarbon having 5 or more carbon atoms (preferably 20 or less carbon atoms), more preferably includes an aliphatic hydrocarbon having 10 or more carbon atoms (preferably 13 or less carbon atoms), still more preferably includes at least one selected from the group consisting of decane, undecane, dodecane, and methyldecane, and particularly preferably includes undecane.

The content of the aliphatic hydrocarbon is preferably 0.8 mass% or more and less than 100 mass%, more preferably 1 to 50 mass%, still more preferably 3 to 30 mass%, particularly preferably 8 to 18 mass% relative to the total mass of the chemical liquid.

The content of the aliphatic hydrocarbon is preferably 0.8 mass% or more and 100 mass% or less, more preferably 1 to 100 mass%, still more preferably 2 to 100 mass%, even more preferably 2 to 50 mass%, particularly preferably 3 to 30 mass%, most preferably 8 to 18 mass% relative to the total mass of the organic solvent.

### <Ester-based solvent>

The organic solvent preferably further includes an ester-based solvent.

The ester-based solvent may be linear, branched, or cyclic (monocyclic or polycyclic) and is preferably linear.

The number of carbon atoms of the ester-based solvent is often 2 or more, preferably 3 or more, more preferably 4 or more, still more preferably 6 or more. The upper limit is often 20 or less, preferably 10 or less, more preferably 8 or less, particularly preferably 7 or less. Specifically, the number of carbon atoms of the ester-based solvent is preferably 6.

Examples of the ester-based solvent include butyl acetate, isobutyl acetate, tert-butyl acetate, methyl acetate, ethyl acetate, propyl acetate, isopropyl acetate, hexyl acetate, methoxybutyl acetate, amyl acetate, isoamyl acetate, methyl formate, ethyl formate, butyl formate, propyl formate, amyl formate, isoamyl formate, methyl lactate, ethyl lactate, butyl lactate, propyl lactate, methyl 2-hydroxyisobutyrate, ethyl butyrate, ethyl isobutyrate, ethyl propionate, propyl propionate, isopropyl propionate, butyl propionate, and isobutyl propionate.

The ester-based solvent preferably includes at least one selected from the group consisting of butyl acetate, isobutyl acetate, ethyl acetate, and hexyl acetate, more preferably includes butyl acetate.

The content of the ester-based solvent is preferably 10 mass% or more and less than 100 mass%, more preferably 60 to 99 mass%, still more preferably 60 to 95 mass%, particularly preferably 80 to 90 mass% relative to the total mass of the chemical liquid.

The content of the ester-based solvent is preferably 10 mass% or more and less than 100 mass%, more preferably 60 to 99 mass%, still more preferably 60 to 95 mass%, particularly preferably 80 to 90 mass% relative to the total mass of the organic solvent.

The organic solvent preferably includes an aliphatic hydrocarbon and an ester-based solvent and is more preferably composed only of an aliphatic hydrocarbon and an ester-based solvent.

In the case where the organic solvent includes an aliphatic hydrocarbon and an ester-based solvent, the content of the ester-based solvent relative to the content of the aliphatic hydrocarbon (content of ester-based solvent/content of aliphatic hydrocarbon) is preferably 0.01 or more, more preferably 1 to 35, still more preferably 4 to 20.

The total content of the aliphatic hydrocarbon and the ester-based solvent is preferably 10 mass% or more and less than 100 mass%, more preferably 80 mass% or more and less than 100 mass%, still more preferably 95 mass% or more and less than 100 mass% relative to the total mass of the chemical liquid.

The total content of the aliphatic hydrocarbon and the ester-based solvent is preferably 10 to 100 mass%, more preferably 80 to 100 mass%, still more preferably 95 to 100 mass%, particularly preferably 99 to 100 mass% relative to the total mass of the organic solvent.

### <Other solvents>

The organic solvent may include other solvents in addition to those described above.

Examples of the other solvents include a ketone-based solvent, an amide-based solvent, and an ether-based solvent.

The organic solvents may be used alone or in combination of two or more thereof.

The content of the organic solvent is preferably 90 mass% or more, more preferably 95 mass% of more, still more preferably 98 mass% or more relative to the total mass of the chemical liquid. The upper limit is often less than 100 mass% relative to the total mass of the chemical liquid.

Examples of the method for measuring the content of the organic solvent include a method using gas chromatography (GC) and a method using gas chromatography mass spectrometry (GC-MS).

### [Metal X]

The chemical liquid includes metal X.

The metal X is at least one metal selected from the group consisting of Al, Fe, and Ni. The chemical liquid preferably includes all metals of Al, Fe, and Ni.

In the chemical liquid, the metal X may be present in an ionic state or may be present at a valence of 0.

Such metals constituting the metal X may be used alone or in combination of two or more thereof.

The content of the metal X is preferably 0.01 to 500 mass ppt, more preferably 0.1 to 100 mass ppt, still more preferably 0.1 to 50 mass ppt relative to the total mass of the chemical liquid. When the chemical liquid includes two or more metals, the total content of the two or more metals is preferably within the above range.

The content of at least one of Al, Fe, or Ni in the metal X is preferably 0.1 to 100 mass ppt relative to the total mass of the chemical liquid.

The mass ratio of the content of the aromatic hydrocarbon to the content of the metal X (content of aromatic hydrocarbon/content of metal X) is 5.0 × 10⁴ to 2.0 × 10¹⁰, preferably 3.0 × 10⁵ to 1.0 × 10⁹, more preferably 3.0 × 10⁵ to 2.5 × 10⁸.

The method for measuring the content of the metal X is, for example, a publicly known measurement method such as ICP-MS (ICP mass spectrometry).

Examples of the method for adjusting the content of the metal X include the method of filtration using a filter, a method of selecting, as raw materials constituting various components, raw materials having a low content of the metal X, a method of performing distillation under conditions in which contamination is reduced by, for example, lining the interior of apparatuses with Teflon (registered trademark), and a method of adding the metal X or a compound including the metal X.

### [Sulfur-containing compound]

The chemical liquid may include a sulfur-containing compound.

The sulfur-containing compound is not included in the organic solvent.

Examples of the sulfur-containing compound include a thiol compound, a sulfide compound, and a thiophene compound.

Examples of the thiol compound include methanethiol, ethanethiol, 3-methyl-2-butene-1-thiol, 2-methyl-3-furanthiol, furfuryl thiol, 3-mercapto-3-methylbutyl formate, phenyl mercaptan, methylfurfuryl mercaptan, ethyl 3-mercaptobutanoate, 3-mercapto-3-methylbutanol, and 4-mercapto-4-methyl-2-pentanone.

Examples of the sulfide compound include dimethyl sulfide, dimethyl trisulfide, diisopropyl trisulfide, and bis(2-methyl-3-furyl) disulfide.

Examples of the thiophene compound include an alkylthiophene compound, a benzothiophene compound, a dibenzothiophene compound, a phenanthrothiophene compound, a benzonaphthothiophene compound, and a thiophene sulfide compound.

The sulfur-containing compound is preferably a sulfide compound or a thiophene compound, more preferably dimethyl sulfide or benzothiophene.

Such sulfur-containing compounds may be used alone or in combination of two or more thereof.

The content of the sulfur-containing compound is preferably 0.001 mass ppm or more, more preferably 0.01 mass ppm or more relative to the total mass of the chemical liquid. The upper limit is often less than 0.8 mass%, preferably 100 mass ppm or less, more preferably 5 mass ppm or less relative to the total mass of the chemical liquid.

The mass ratio of the content of the aromatic hydrocarbon to the content of the sulfur-containing compound (content of aromatic hydrocarbon/content of sulfur-containing compound) is preferably 1 or more, more preferably 100 or more, still more preferably 200 or more. The upper limit is preferably 100,000 or less, more preferably 50,000, still more preferably 10,000 or less.

The content of C₁₀H₁₄, the content of C₁₁H₁₆, and the content of C₁₀H₁₂ are all preferably higher than the content of the sulfur-containing compound. In other words, it is preferable to satisfy all of the conditions that the content of C₁₀H₁₄ is higher than the content of the sulfur-containing compound, the content of C₁₁H₁₆ is higher than the content of the sulfur-containing compound, and the content of C₁₀H₁₂ is higher than the content of the sulfur-containing compound.

The C₁₀H₁₄, the C₁₁H₁₆, the C₁₀H₁₂, and the sulfur-containing compound are as described above.

The content of the sulfur-containing compound can be measured, for example, in accordance with JISK2541-6: 2013.

Examples of the method for adjusting the content of the sulfur-containing compound include a method of selecting, as raw materials constituting various components, raw materials having a low content of a sulfur-containing compound, a method of performing distillation under conditions in which contamination is reduced by, for example, lining the interior of apparatuses with Teflon (registered trademark), and a method of adding a sulfur-containing compound.

### [Alcohol compound]

The chemical liquid may include an alcohol compound.

The alcohol compound is not included in the organic solvent but corresponds to an organic impurity. In other words, the content of the alcohol compound is less than 8,000 mass ppm relative to the total mass of the chemical liquid.

The alcohol compound is a compound having an alcoholic hydroxy group.

The alcoholic hydroxy group may be any of primary, secondary, and tertiary groups.

Examples of the alcohol compound include publicly known alcohol compounds.

The number of carbon atoms of the alcohol compound is preferably 1 to 20, more preferably 1 to 5, still more preferably 2 to 5.

The alcohol compound preferably includes at least one selected from the group consisting of ethanol, 1-propanol, 2-propanol, 1-butanol, 2-butanol, tert-butanol, 1-pentanol, 2-pentanol, 3-pentanol, and 2-methyl-1-butanol, more preferably includes at least one selected from the group consisting of 1-butanol and methanol, still more preferably includes 1-butanol.

Such alcohol compounds may be used alone or in combination of two or more thereof.

The content of the alcohol compound is preferably 0.001 mass ppm or more and less than 8,000 mass ppm, more preferably 0.1 to 5,000 mass ppm, still more preferably 1 to 500 mass ppm, particularly preferably 1 to 100 mass ppm relative to the total mass of the chemical liquid.

The mass ratio of the content of the aromatic hydrocarbon to the content of the alcohol compound (content of aromatic hydrocarbon/content of alcohol compound) is preferably 1.0 × 10⁻⁴ to 1.0 × 10⁵, more preferably 0.001 to 200, still more preferably 0.01 to 100.

The method for measuring the content of the alcohol compound is, for example, the above-described method for measuring the content of the organic solvent.

Examples of the method for adjusting the content of the alcohol compound include a method of selecting, as raw materials constituting various components, raw materials having a low content of an alcohol compound, a method of performing distillation under conditions in which contamination is reduced by, for example, lining the interior of apparatuses with Teflon (registered trademark), and a method of adding an alcohol compound.

### [Water]

Preferably, the chemical liquid includes substantially no water.

Specifically, the content of water is preferably 1 mass% or less, more preferably 1 to 1,000 mass ppm, still more preferably 20 to 1,000 mass ppm relative to the total mass of the chemical liquid.

The method for measuring the content of water is, for example, the above-described method for measuring the content of the organic solvent.

Examples of the method for adjusting the content of water include a method of selecting, as raw materials constituting various components, raw materials having a low content of water, a method of performing distillation under conditions in which contamination is reduced by, for example, lining the interior of apparatuses with Teflon (registered trademark), and a method of adding water.

### [Other components]

The chemical liquid may include other components in addition to the components described above.

Examples of the other components include publicly known surfactants.

The content of the surfactant is preferably 0.001 to 5 mass%, more preferably 0.005 to 2 mass%, still more preferably 0.01 to 0.5 mass% relative to the total mass of the chemical liquid.

### <<Second Embodiment>>

A second embodiment of the chemical liquid will be described in detail below.

The second embodiment of the chemical liquid is preferably used as a rinsing liquid.

The second embodiment of the chemical liquid is the same as the first embodiment of the chemical liquid except for the points described in detail below, and preferred embodiments are also the same.

### [Organic solvent]

### <Aliphatic hydrocarbon>

The aliphatic hydrocarbon preferably includes an aliphatic hydrocarbon having 5 or more carbon atoms (preferably 15 or less carbon atoms), more preferably includes an aliphatic hydrocarbon having 10 or more carbon atoms (preferably 13 or less carbon atoms), still more preferably includes at least one selected from the group consisting of hexane, decane, undecane, dodecane, and methyldecane, particularly preferably includes at least one selected from the group consisting of decane, undecane, dodecane, and methyldecane, and most preferably includes undecane.

The content of the aliphatic hydrocarbon is preferably 0.8 mass% or more and less than 100 mass%, more preferably 5 to 90 mass%, still more preferably 10 to 60 mass% relative to the total mass of the chemical liquid.

The content of the aliphatic hydrocarbon is preferably 0.8 mass% or more and 100 mass%, more preferably 1 to 100 mass%, still more preferably 5 to 90 mass%, particularly preferably 10 to 60 mass% relative to the total mass of the organic solvent.

### <Ester-based solvent>

The content of the ester-based solvent is preferably 1 mass% or more and less than 100 mass%, more preferably 50 to 97 mass%, still more preferably 50 to 92 mass% relative to the total mass of the chemical liquid.

The content of the ester-based solvent is preferably 1 mass% or more and less than 100 mass%, more preferably 50 to 97 mass%, still more preferably 50 to 92 mass% relative to the total mass of the organic solvent.

### [Method for producing chemical liquid]

The method for producing the chemical liquid is not particularly limited, and the chemical liquid can be produced by mixing the various components described above.

Note that high-purity grade products are preferably used as the various components.

After the various components are mixed, the mixture may be subjected to purification treatment, if necessary.

Examples of the purification treatment include distillation treatment and filtering treatment.

The chemical liquid is preferably used as a developer or a rinsing liquid in a pattern forming method.

The pattern forming method is preferably a pattern forming method described below.

### [Pattern forming method]

A pattern forming method includes a resist film-forming step of forming a resist film using an actinic ray-sensitive or radiation-sensitive resin composition (hereinafter, also referred to as a "resist composition"), which will be described later,
an exposure step of exposing the resist film, and
a developing step of developing the exposed resist film with a developer.

The pattern forming method preferably includes the resist film-forming step, the exposure step, and the developing step in this order.

Hereinafter, each step in the pattern forming method will be described in detail.

### [Resist film-forming step]

The resist film-forming step is a step of forming a resist film using a resist composition.

The method for forming a resist film using a resist composition is, for example, a method of applying a resist composition onto a substrate. The resist composition will be described later.

Examples of the method of applying the resist composition onto a substrate include a method in which the resist composition is applied onto a substrate (for example, silicon or the like) used in the production of a semiconductor device such as an integrated circuit using a device such as a spinner or a coater.

The coating method is preferably spin-coating using a spinner. The rotational speed during spin coating is preferably 1,000 to 3,000 rpm.

The substrate coated with the resist composition may be dried to form a resist film.

The drying method may be, for example, a method of performing heating. The heating may be performed using means included in a publicly known exposure device and/or a publicly known developing device, or may be performed using a hot plate.

The heating temperature is preferably 80°C to 150°C, more preferably 80°C to 140°C, still more preferably 80°C to 130°C. The heating time is preferably 30 to 1,000 seconds, more preferably 30 to 800 seconds, still more preferably 40 to 600 seconds. The heating may be performed once or twice or more.

The film thickness of the resist film is preferably 10 to 90 nm, more preferably 10 to 65 nm, still more preferably 15 to 50 nm from the viewpoint that a fine pattern with higher accuracy can be formed.

In addition, an underlying film (for example, an inorganic film, an organic film, or an antireflection film) may be formed between the substrate and the resist film.

An underlying film-forming resist composition preferably includes a publicly known organic material or a publicly known inorganic material.

The film thickness of the underlying film is preferably 10 to 90 nm, more preferably 10 to 50 nm, still more preferably 10 to 30 nm.

Examples of the underlying film-forming resist composition include AL412 (manufactured by Brewer Science, Inc.) and SHB series (for example, SHB-A940, manufactured by Shin-Etsu Chemical Co., Ltd.).

A topcoat may be formed on a surface of the resist film on a side opposite from the substrate using a topcoat resist composition.

Preferably, the topcoat resist composition does not mix with the resist film and can be uniformly applied to the surface of the resist film on the side opposite from the substrate.

The topcoat resist composition preferably includes a resin, an additive, and a solvent.

Examples of the method for forming the topcoat include publicly known methods for forming a topcoat, and specific examples thereof include methods for forming a topcoat described in paragraphs [0072] to [0082] of JP2014-059543A.

The method for forming the topcoat preferably includes forming a topcoat including a basic compound described in JP2013-061648A on the surface of the resist film on the side opposite from the substrate. Examples of the basic compound also include basic compounds described in WO2017/002737A.

It is also preferable that the topcoat include a compound having at least one selected from the group consisting of -O-, -S-, a hydroxy group, a thiol group, -CO-, and -COO-.

### [Exposure step]

The exposure step is a step of exposing the resist film.

The exposure step is preferably a step of performing pattern exposure through a photo mask.

The photo mask may be, for example, a publicly known photo mask. The photo mask may be in contact with the resist film.

Examples of the exposure light for exposing the resist film include infrared light, visible light, ultraviolet light, far ultraviolet light, extreme ultraviolet light (EUV), X-rays, and electron beams.

The exposure light preferably has a wavelength of 250 nm or less, more preferably has a wavelength of 220 nm or less, and still more preferably has a wavelength of 1 to 200 nm. Specifically, KrF excimer laser (wavelength 248 nm), ArF excimer laser (wavelength 193 nm), F₂ excimer laser (wavelength 157 nm), X-rays, EUV (wavelength 13 nm), or an electron beam is preferred, KrF excimer laser, ArF excimer laser, EUV, or an electron beam is more preferred, and EUV or an electron beam is still more preferred.

The exposure dose can be appropriately adjusted in accordance with the desired pattern shape.

The exposure method in the exposure step may be liquid immersion exposure.

The exposure step may be performed once or twice or more.

After the exposure step, post exposure bake (PEB) may be performed before the developing step described below.

The heating temperature of the post exposure bake is preferably 80°C to 150°C, more preferably 80°C to 140°C, still more preferably 80°C to 130°C. The heating time is preferably 10 to 1,000 seconds, more preferably 10 to 180 seconds, still more preferably 30 to 120 seconds.

The post exposure bake may be performed using means included in a publicly known exposure device and/or developing device, or may be performed using a hot plate. The post exposure bake may be performed once or twice or more.

### [Developing step]

The developing step is a step of developing the exposed resist film with a developer.

The developer may be a publicly known developer, and is preferably the chemical liquid described above, more preferably the chemical liquid of the first embodiment.

The chemical liquid is as described above.

The developer other than the chemical liquid is preferably, for example, at least one selected from the group consisting of a ketone-based solvent, an ester-based solvent, an alcohol-based solvent, an amide-based solvent, an ether-based solvent, and a hydrocarbon-based solvent, more preferably an ester-based solvent.

Examples of the ester-based solvent include butyl acetate, isobutyl acetate, tert-butyl acetate, amyl acetate, isoamyl acetate, propyl propionate, isopropyl propionate, butyl propionate, isobutyl propionate, ethyl butyrate, ethyl isobutyrate, amyl formate, and isoamyl formate. The ester-based solvent may be an ester-based solvent that can be included in the chemical liquid.

The developing method may be, for example, a publicly known developing method.

Specific examples thereof include a method of immersing an exposed resist film for a predetermined time in a tank filled with the developer (dipping method), a method of puddling the developer over a surface of an exposed resist film using surface tension and allowing the developer to stand for a predetermined time to perform development (puddling method), a method of spraying the developer onto a surface of an exposed resist film (spraying method), and a method of continuously ejecting the developer over a substrate having an exposed resist film and rotating at a constant rate, while scanning a nozzle through which the developer is ejected at a constant rate (dynamic dispensing method).

After the developing step, a step of stopping the development using another solvent other than the developer may be performed.

The development time is preferably 10 to 300 seconds, more preferably 20 to 120 seconds. The temperature of the developer during development is preferably 0°C to 50°C, more preferably 15°C to 35°C.

### [Other steps]

The pattern forming method may include other steps in addition to the above-described steps.

Examples of the other steps include a rinsing step.

### <Rinsing step>

The pattern forming method preferably includes, after the developing step, a rinsing step of performing cleaning with a rinsing liquid.

The developer may be a publicly known developer, and is preferably the chemical liquid described above, more preferably the chemical liquid of the second embodiment.

The chemical liquid is as described above.

The developer other than the chemical liquid is preferably, for example, at least one selected from the group consisting of a ketone-based solvent, an ester-based solvent, an alcohol-based solvent, an amide-based solvent, an ether-based solvent, and a hydrocarbon-based solvent.

Examples of the rinsing method include the dipping method, the puddling method, the spraying method, and the dynamic dispensing method in the developing method.

The pattern forming method may include a heating step (post bake) after the rinsing step. Through the heating step, the developer and the rinsing liquid remaining between patterns and inside patterns can be removed, and roughening of surfaces of the patterns can be suppressed.

The heating temperature in the heating step is preferably 40°C to 250°C, more preferably 80°C to 200°C. The heating time is preferably 10 to 180 seconds, more preferably 30 to 120 seconds.

One preferred embodiment of the pattern forming method according to the present invention is a pattern forming method including a resist film-forming step of forming a resist film using an actinic ray-sensitive or radiation-sensitive resin composition;
an exposure step of exposing the resist film;
a developing step of developing the exposed resist film with a developer; and
a cleaning step of performing cleaning with a rinsing liquid after the developing step,
in which the above-described chemical liquids are used as the developer and the rinsing liquid, and
the content of the aliphatic hydrocarbon relative to the organic solvent in the chemical liquid used as the rinsing liquid is higher than the content of the aliphatic hydrocarbon relative to the organic solvent in the chemical liquid used as the developer.

### <Etching step>

The pattern forming method may include an etching step of etching the substrate using the formed pattern as a mask.

The etching method may be, for example, a publicly known etching method. Specific examples thereof include the methods described in Proceedings of International Society for Optics and Photonics (Proc. of SPIE), Vol. 6924, 692420 (2008), "Chapter 4 Etching" of "Semiconductor Process Textbook, 4th edition, issued in 2007, publisher: SEMI Japan", and JP2009-267112A.

### <Purification step>

The pattern forming method may include a purification step of purifying the resist composition, the developer, the rinsing liquid, and/or various other components (for example, an antireflection film-forming resist composition and a topcoat-forming resist composition) used in the pattern forming method.

The purification method may be, for example, a publicly known purification method and is preferably a method of filtration using a filter or a purification method using an adsorbing material.

The pore size of the filter is preferably less than 100 nm, more preferably 10 nm or less, still more preferably 5 nm or less. The lower limit is often 0.01 nm or more.

The material of the filter is preferably polytetrafluoroethylene, polyethylene, or nylon. The filter may be made of a composite material obtained by combining the above filter material and an ion exchange medium. The filter used may be a filter washed with an organic solvent in advance.

In the method of filtration using a filter, a plurality of types of filters may be connected in series or in parallel and used. When a plurality of types of filters are used, filters having different pore sizes and/or made of different materials may be used in combination. In addition, the substance to be purified may be filtered once or twice or more. In a method in which filtration is performed twice or more, the filtration may be performed while circulating.

In the method using an adsorbing material, only an adsorbing material may be used, or the above-described filter and an adsorbing material may be used in combination.

The adsorbing material may be a publicly known adsorbing material, and specific examples thereof include inorganic adsorbing materials such as silica gel and zeolite, and organic adsorbing materials such as activated carbon.

In the production of the resist composition, for example, it is preferable that each component such as a resin which can be included in the resist composition be dissolved in an organic solvent, and the resulting solution be then filtered while being circulated using a plurality of filters made of different materials. Specifically, it is preferable that a polyethylene filter having a pore size of 50 nm, a nylon filter having a pore size of 10 nm, and a polyethylene filter having a pore size of 3 nm be connected in order, and circulation filtration be performed 10 times or more.

The pressure difference between the filters is preferably small. Specifically, the pressure difference between the filters is preferably 0.1 MPa or less, more preferably 0.05 MPa or less, still more preferably 0.01 MPa or less. The lower limit is often more than 0 MPa.

The pressure difference between the filter and a filling nozzle is also preferably small. Specifically, the pressure difference is preferably 0.5 MPa or less, more preferably 0.2 MPa or less, still more preferably 0.1 MPa or less. The lower limit is often more than 0 MPa.

After the resist composition is filtered through a filter, the resist composition is preferably filled into a clean container. From the viewpoint of suppressing deterioration with time, the container filled with the resist composition is preferably stored under refrigeration. The time from the completion of filling of the resist composition into the container to the start of storage under refrigeration is preferably short. Specifically, the time is preferably within 24 hours, more preferably within 16 hours, still more preferably within 12 hours, particularly preferably within 10 hours.

The temperature during storage under refrigeration is preferably 0°C to 15°C, more preferably 0°C to 10°C, still more preferably 0°C to 5°C.

Preferably, the resist composition, the developer, and the various other components do not include impurities.

Examples of impurities include metal impurities. Specific examples thereof include Na, K, Ca, Fe, Cu, Mg, Al, Li, Cr, Ni, Sn, Ag, As, Au, Ba, Cd, Co, Pb, Ti, V, W, and Zn.

The content of impurities in the resist composition relative to the total mass of the resist composition, the content of impurities in the developer relative to the total mass of the developer, or the content of impurities in another component relative to the total mass of the other component (for example, the content of impurities in a rinsing liquid relative to the total mass of the rinsing liquid) is preferably 1 mass ppm or less, more preferably 10 mass ppb or less, still more preferably 100 mass ppt or less, particularly preferably 10 mass ppt or less, most preferably 1 mass ppt or less. The lower limit is often 0 mass ppt or more.

The method for determining the impurities may be, for example, a publicly known measurement method such as ICP-MS (ICP mass spectrometry).

Examples of the method of reducing the content of impurities include the method of filtration using a filter, a method of selecting, as raw materials constituting various materials, raw materials having a low content of impurities, and a method of performing distillation under conditions in which contamination is minimized by, for example, lining the interior of apparatuses with Teflon (registered trademark).

Liquids including an organic solvent, such as the developer and the rinsing liquid, may include a conductive compound from the viewpoint of preventing failure of a chemical liquid pipe and various parts (such as a filter, an O-ring, and a tube) caused by electrostatic charging and electrostatic discharging.

The conductive compound is, for example, methanol. From the viewpoint of maintaining the developing performance or the rinsing performance, the content of the conductive compound in the developer relative to the total mass of the developer, or the content of the conductive compound in the rinsing liquid relative to the total mass of the rinsing liquid is preferably 10 mass% or less, more preferably 5 mass% or less. The lower limit is often 0.01 mass% or more.

Examples of the chemical liquid pipe include various pipes made of SUS (stainless steel) or a material coated with polyethylene, polypropylene, or a fluororesin (such as polytetrafluoroethylene or a perfluoroalkoxy resin) subjected to antistatic treatment.

Examples of the filter and the O-ring include those made of a material coated with polyethylene, polypropylene, or a fluororesin (such as polytetrafluoroethylene or a perfluoroalkoxy resin) subjected to antistatic treatment.

Embodiments of the chemical liquid are preferably the following embodiments.

Each term in the following embodiments has the same definition and preferred embodiments as in the term described above.

### <<First Embodiment>>

A chemical liquid used, in a pattern forming method including a resist film-forming step of forming a resist film using an actinic ray-sensitive or radiation-sensitive resin composition,
an exposure step of exposing the resist film, and
a developing step of developing the exposed resist film with a developer,
as the developer.

### <<Second Embodiment>>

A chemical liquid used, in a pattern forming method including a resist film-forming step of forming a resist film using an actinic ray-sensitive or radiation-sensitive resin composition,
an exposure step of exposing the resist film,
a developing step of developing the exposed resist film with butyl acetate, and
a cleaning step of performing cleaning with a rinsing liquid after the developing step,
as the rinsing liquid.

### <<Third Embodiment>>

A chemical liquid used, in a pattern forming method including a resist film-forming step of forming a resist film using an actinic ray-sensitive or radiation-sensitive resin composition,
an exposure step of exposing the resist film,
a developing step of developing the exposed resist film with a developer, and
a cleaning step of performing cleaning with a rinsing liquid after the developing step,
as the developer and the rinsing liquid.

In the third embodiment, the chemical liquid used as the developer and the chemical liquid used as the rinsing liquid may be the same or different, and are preferably different. The same chemical liquids mean that the types and contents of components included in the chemical liquids are all the same.

In the third embodiment, the content of the aliphatic hydrocarbon (preferably, undecane) relative to the total mass of the organic solvent included in the chemical liquid used as the rinsing liquid is preferably higher than the content of the aliphatic hydrocarbon (preferably, undecane) relative to the total mass of the organic solvent included in the chemical liquid used as the developer.

Specifically, the content of the aliphatic hydrocarbon (preferably, undecane) included in the chemical liquid used as the developer is preferably 1 to 30 mass%, more preferably 2 to 20 mass%, still more preferably 5 to 15 mass% relative to the total mass of the organic solvent.

The content of the aliphatic hydrocarbon (preferably, undecane) included in the chemical liquid used as the rinsing liquid is preferably 5 to 100 mass% relative to the total mass of the organic solvent.

### [Resist composition]

Hereinafter, components that can be included in the resist composition will be described in detail.

The resist composition preferably includes a resin that is decomposed by the action of an acid to undergo an increase in polarity (hereinafter also referred to as a "resin (A)") and a photoacid generator that generates an acid upon irradiation with an actinic ray or a radiation (hereinafter also referred to as a "photoacid generator").

The resist composition is preferably a negative resist composition. The resist composition is also preferably a resist composition for organic solvent development.

The resist composition is typically a chemical amplification resist composition.

### [Resin (A)]

The resist composition preferably includes the resin (A).

In the pattern forming method, typically, when a developer including an organic solvent is used as the developer, a negative-type pattern is suitably formed.

In general, the resin (A) preferably includes a group that is decomposed by the action of an acid to undergo an increase in polarity (hereinafter also referred to as an "acid-decomposable group"), more preferably includes a repeating unit having an acid-decomposable group.

The repeating unit having an acid-decomposable group is preferably (Repeating unit having acid-decomposable group including unsaturated bond), which will be described later, in addition to (Repeating unit having acid-decomposable group), which will be described later.

### <Repeating unit having acid-decomposable group>

### (Repeating unit having acid-decomposable group)

The acid-decomposable group is preferably a group that is decomposed by the action of an acid to generate a polar group.

The acid-decomposable group preferably has a structure in which a polar group is protected with a leaving group that leaves due to the action of an acid. That is, the resin (A) preferably has a repeating unit having a group that is decomposed by the action of an acid to generate a polar group. The resin having the repeating unit undergoes an increase in polarity due to the action of an acid to have an increased degree of solubility in an alkali developer and a decreased degree of solubility in an organic solvent.

The polar group is preferably an alkali soluble group, and examples thereof include acidic groups such as a carboxy group, a phenolic hydroxy group, fluorinated alcohol groups, a sulfonic group, a phosphate group, a sulfonamide group, a sulfonylimide group, (alkylsulfonyl)(alkylcarbonyl)methylene groups, (alkylsulfonyl)(alkylcarbonyl)imide groups, bis(alkylcarbonyl)methylene groups, bis(alkylcarbonyl)imide groups, bis(alkylsulfonyl)methylene groups, bis(alkylsulfonyl)imide groups, tris(alkylcarbonyl)methylene groups, and tris(alkylsulfonyl)methylene groups, and an alcoholic hydroxy group.

The polar group is preferably a carboxy group, a phenolic hydroxy group, a fluorinated alcohol group (preferably a hexafluoroisopropanol group), or a sulfonic group.

The resin (A) preferably includes at least one selected from the group consisting of a group in which a hydrogen atom of a carboxy group is substituted with an acid-decomposable group, a group in which a hydrogen atom of an alcoholic hydroxy group is substituted with an acid-decomposable group, and a group in which a hydrogen atom of a phenolic hydroxy group is substituted with an acid-decomposable group.

The repeating unit having an acid-decomposable group is also preferably a repeating unit represented by Formula (A).

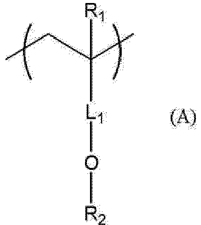

L₁ represents a divalent linking group that may have a fluorine atom or an iodine atom; R₁ represents a hydrogen atom, a fluorine atom, an iodine atom, an alkyl group that may have a fluorine atom or an iodine atom, or an aryl group that may have a fluorine atom or an iodine atom; and R₂ represents a leaving group that leaves due to the action of an acid and that may have a fluorine atom or an iodine atom. Note that at least one of L₁, R₁, or R₂ has a fluorine atom or an iodine atom.

L₁ represents a divalent linking group that may have a fluorine atom or an iodine atom. Examples of the divalent linking group that may have a fluorine atom or an iodine atom include -CO-, -O-, -S-, -SO-, -SO₂-, hydrocarbon groups that may have a fluorine atom or an iodine atom (for example, an alkylene group, a cycloalkylene group, an alkenylene group, and an arylene group), and a linking group provided by linking a plurality of these together. L₁ is preferably -CO-, an arylene group, or an -arylene group-alkylene group having a fluorine atom or an iodine atom-, more preferably -CO- or an -arylene group-alkylene group having a fluorine atom or an iodine atom-.

The arylene group is preferably a phenylene group.

The alkylene group may be linear or branched. The number of carbon atoms of the alkylene group is preferably 1 to 10, more preferably 1 to 3.

In the alkylene group having a fluorine atom or an iodine atom, the total number of fluorine atoms and iodine atoms is preferably 2 or more, more preferably 2 to 10, still more preferably 3 to 6.

R₁ represents a hydrogen atom, a fluorine atom, an iodine atom, an alkyl group that may have a fluorine atom or an iodine atom, or an aryl group that may have a fluorine atom or an iodine atom.

The alkyl group may be linear or branched. The number of carbon atoms of the alkyl group is preferably 1 to 10, more preferably 1 to 3.

In the alkyl group having a fluorine atom or an iodine atom, the total number of fluorine atoms and iodine atoms is preferably 1 or more, more preferably 1 to 5, still more preferably 1 to 3.

The alkyl group may include a heteroatom other than halogen atoms, such as an oxygen atom.

R₂ represents a leaving group that leaves due to the action of an acid and that may have a fluorine atom or an iodine atom. Examples of the leaving group that may have a fluorine atom or an iodine atom include leaving groups that are represented by Formulae (Y1) to (Y4) above and that have a fluorine atom or an iodine atom.

Examples of the repeating unit having an acid-decomposable group include those described in paragraphs [0031] to [0063] of WO2020/004306A, and these contents are incorporated herein by reference.

The content of the repeating unit having an acid-decomposable group is preferably 15 mol% or more, more preferably 20 mol% or more, still more preferably 30 mol% or more relative to all the repeating units in the resin (A). The upper limit is preferably 90 mol% or less, more preferably 80 mol% or less, still more preferably 70 mol% or less, particularly preferably 60 mol% or less relative to the total repeating units in the resin (A).

Examples of the repeating unit having an acid-decomposable group include the following repeating units. In the following formulae, Xa₁ represents H, CH₃, CF₃, or CH₂OH. Rxa and Rxb each independently represent a linear or branched alkyl group having 1 to 5 carbon atoms.

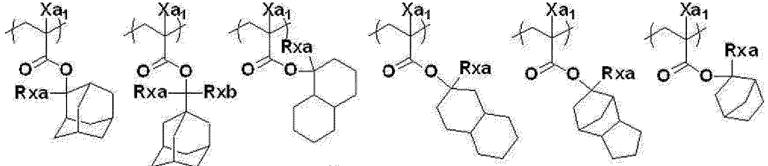

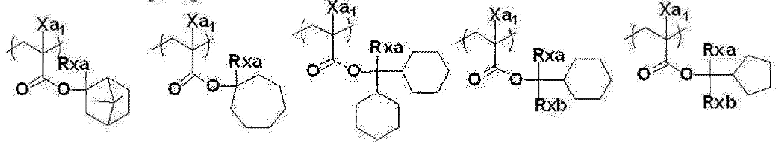

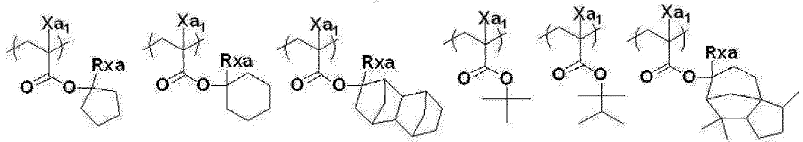

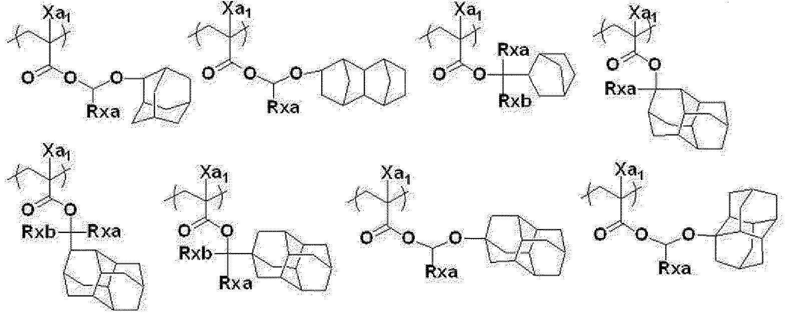

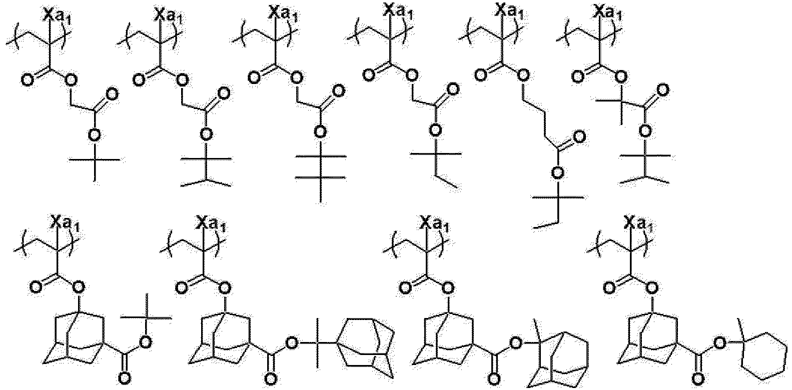

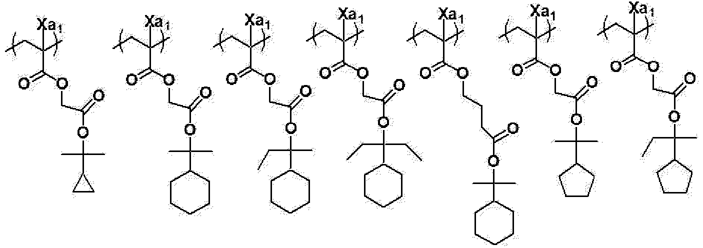

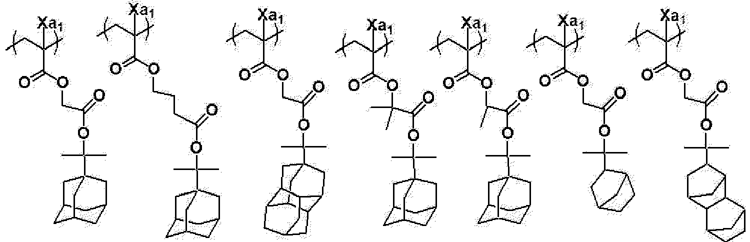

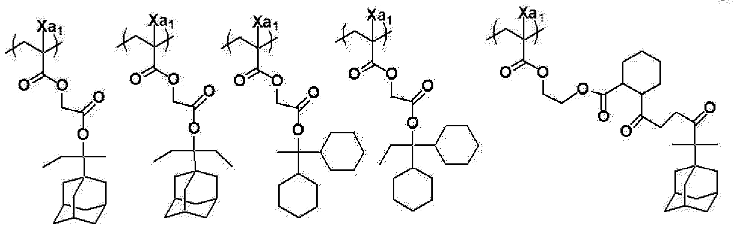

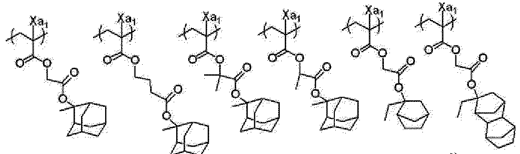

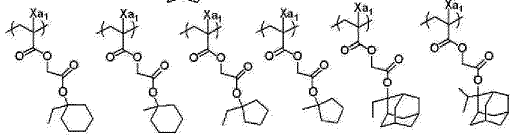

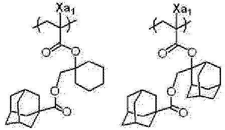

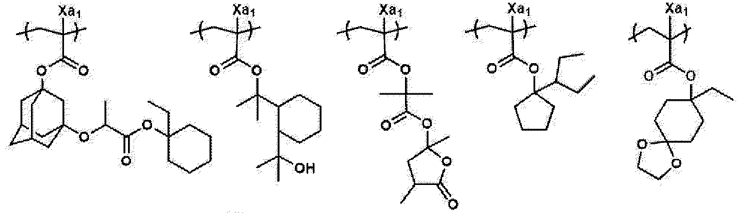

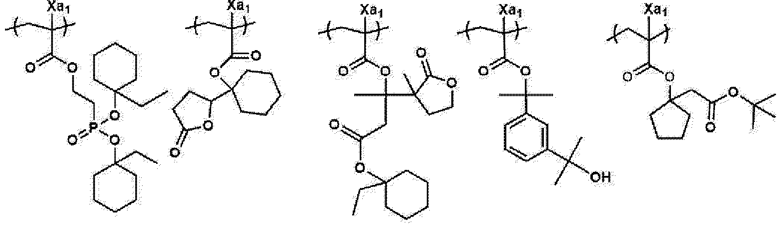

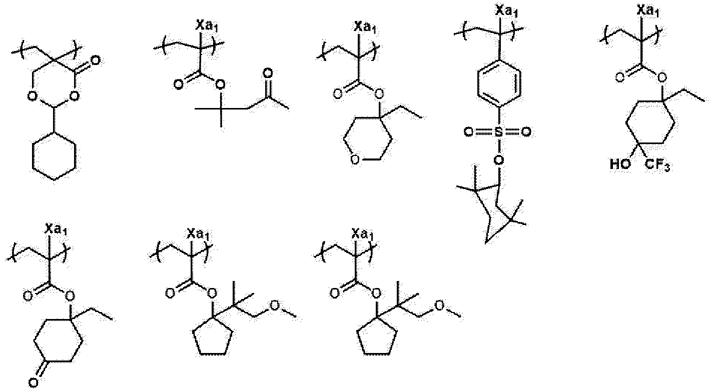

### (Repeating unit having acid-decomposable group including unsaturated bond)

The resin (A) may have a repeating unit having an acid-decomposable group including an unsaturated bond.

The repeating unit having an acid-decomposable group including an unsaturated bond is preferably a repeating unit represented by Formula (B).

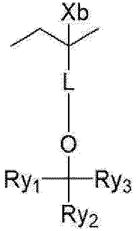

In Formula (B), Xb represents a hydrogen atom, a halogen atom, or an alkyl group that may have a substituent. L represents a single bond or a divalent linking group that may have a substituent. Ryi to Rys each independently represent a linear or branched alkyl group, a monocyclic or polycyclic cycloalkyl group, an alkenyl group, an alkynyl group, or a monocyclic or polycyclic aryl group. Note that at least one of Ryi to Rys represents an alkenyl group, an alkynyl group, a monocyclic or polycyclic cycloalkenyl group, or a monocyclic or polycyclic aryl group. Two of Ryi to Rys may be bonded together to form a monocyclic or polycyclic ring (such as a monocyclic or polycyclic cycloalkyl group or cycloalkenyl group).

The alkyl group that may have a substituent and that is represented by Xb may be, for example, a methyl group or a group represented by -CH₂-R₁₁. R₁₁ represents a halogen atom (such as a fluorine atom), a hydroxy group, or a monovalent organic group, such as an alkyl group that has 5 or less carbon atoms and that may be substituted with a halogen atom, an acyl group that has 5 or less carbon atoms and that may be substituted with a halogen atom, or an alkoxy group that has 5 or less carbon atoms and that may be substituted with a halogen atom, and is preferably an alkyl group having 3 or less carbon atoms, more preferably a methyl group. Xb is preferably a hydrogen atom, a fluorine atom, a methyl group, a trifluoromethyl group, or a hydroxymethyl group.

The divalent linking group in L may be an -Rt- group, a -CO- group, a -COO-Rt- group, a -COO-Rt-CO- group, an -Rt-CO- group, or an -O-Rt- group. In the formulae, Rt represents an alkylene group, a cycloalkylene group, or an aromatic ring group and is preferably an aromatic ring group.

L is preferably an -Rt- group, a -CO- group, a -COO-Rt-CO- group, or an -Rt-CO- group. Rt may have, for example, a substituent such as a halogen atom, a hydroxy group, or an alkoxy group. Rt is preferably an aromatic ring group.

The alkyl group in Ryi to Rys is preferably an alkyl group having 1 to 4 carbon atoms such as a methyl group, an ethyl group, an n-propyl group, an isopropyl group, an n-butyl group, an isobutyl group, or a t-butyl group.

The cycloalkyl group in Ryi to Rys is preferably a monocyclic cycloalkyl group such as a cyclopentyl group or a cyclohexyl group, or a polycyclic cycloalkyl group such as a norbornyl group, a tetracyclodecanyl group, a tetracyclododecanyl group, or an adamantyl group.

The aryl group in Ryi to Rys is preferably an aryl group having 6 to 10 carbon atoms and may be, for example, a phenyl group, a naphthyl group, or an anthryl group.

The alkenyl group in Ry₁ to Ry₃ is preferably a vinyl group.

The alkynyl group in Ry₁ to Ry₃ is preferably an ethynyl group.

The cycloalkenyl group in Ry₁ to Ry₃ preferably has a structure in which a monocyclic cycloalkyl group, such as a cyclopentyl group or a cyclohexyl group, partially includes a double bond.

The cycloalkyl group formed by bonding two of Ryi to Rys together is preferably a monocyclic cycloalkyl group such as a cyclopentyl group or a cyclohexyl group. In addition, a polycyclic cycloalkyl group such as a norbornyl group, a tetracyclodecanyl group, a tetracyclododecanyl group, or an adamantyl group is preferred. A monocyclic cycloalkyl group having 5 to 6 carbon atoms is more preferred.

In the cycloalkyl group or the cycloalkenyl group formed by bonding two of Ryi to Rys together, for example, one of methylene groups forming the ring may be replaced by a heteroatom such as an oxygen atom, a group including a heteroatom such as a carbonyl group, an -SO₂- group, or an -SO₃- group, a vinylidene group, or a combination of thereof. In the cycloalkyl group or the cycloalkenyl group, one or more ethylene groups forming the cycloalkane ring or the cycloalkene ring may be replaced by vinylene groups.

The repeating unit represented by Formula (B) preferably has a form in which, for example, Ry₁ is a methyl group, an ethyl group, a vinyl group, an allyl group, or an aryl group, and Ry₂ and Rx₃ are bonded together to form the above-described cycloalkyl group or cycloalkenyl group.

When the above-described groups each have a substituent, examples of the substituent include an alkyl group (having 1 to 4 carbon atoms), a halogen atom, a hydroxy group, an alkoxy group (having 1 to 4 carbon atoms), a carboxy group, and an alkoxycarbonyl group (having 2 to 6 carbon atoms). The number of carbon atoms in the substituent is preferably 8 or less.

The repeating unit represented by Formula (B) is preferably an acid-decomposable (meth)acrylic acid tertiary ester-based repeating unit (a repeating unit in which Xb represents a hydrogen atom or a methyl group, and L represents a -CO- group), an acid-decomposable hydroxystyrene tertiary alkyl ether-based repeating unit (a repeating unit in which Xb represents a hydrogen atom or a methyl group, and L represents a phenyl group), or an acid-decomposable styrenecarboxylic acid tertiary ester-based repeating unit (a repeating unit in which Xb represents a hydrogen atom or a methyl group, and L represents an -Rt-CO- group (where Rt is an aromatic ring group)).

The content of the repeating unit having an acid-decomposable group including an unsaturated bond is preferably 15 mol% or more, more preferably 20 mol% or more, still more preferably 30 mol% or more relative to all the repeating units in the resin (A). The upper limit is preferably 80 mol% or less, more preferably 70 mol% or less, particular preferably 60 mol% or less relative to all the repeating units in the resin (A).

The following are specific examples of the repeating unit having an acid-decomposable group including an unsaturated bond, but the present invention is not limited thereto. In the following formulae, Xb and L1 represent the above-described substituent or linking group; Ar represents an aromatic ring group; R represents a substituent such as a hydrogen atom, an alkyl group, a cycloalkyl group, an aryl group, an aralkyl group, an alkenyl group, a hydroxy group, an alkoxy group, an acyloxy group, a cyano group, a nitro group, an amino group, a halogen atom, an ester group (-OCOR‴ or -COOR‴: R‴ is an alkyl group or a fluorinated alkyl group having 1 to 20 carbon atoms), or a carboxy group; R' represents a linear or branched alkyl group, a monocyclic or polycyclic cycloalkyl group, an alkenyl group, an alkynyl group, or a monocyclic or polycyclic aryl group; Q represents a heteroatom such as an oxygen atom, a group including a heteroatom such as a carbonyl group, an -SO₂- group, or an -SO₃- group, a vinylidene group, or a combination thereof; and n and m represent an integer of 0 or more.

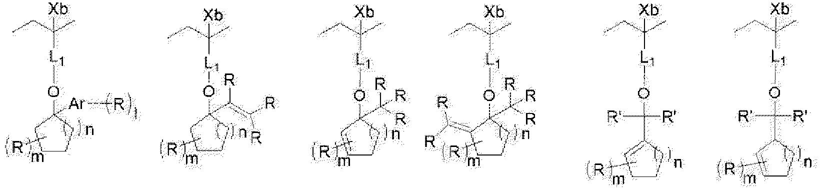

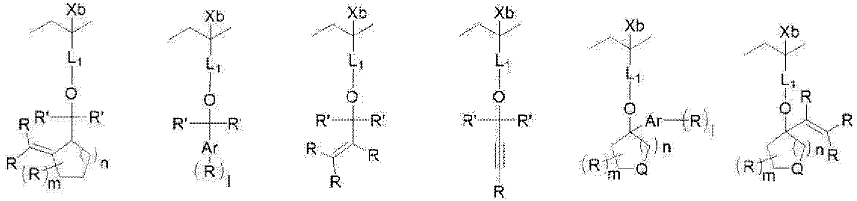

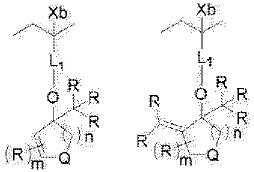

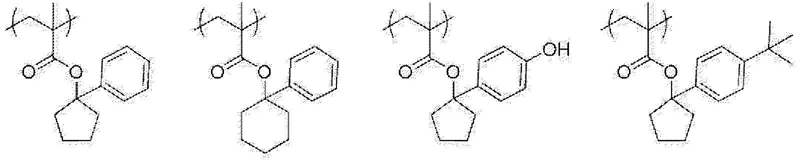

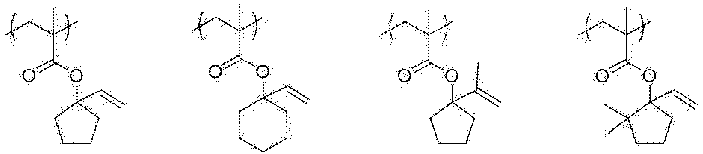

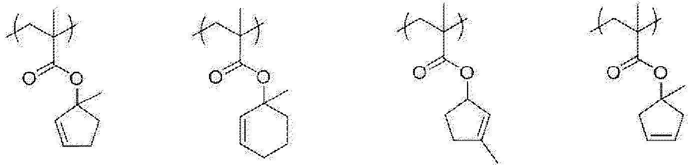

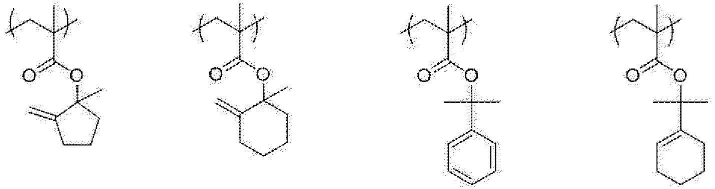

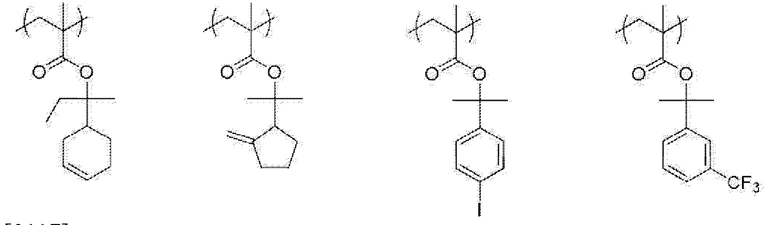

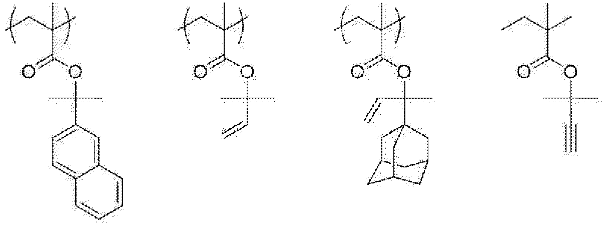

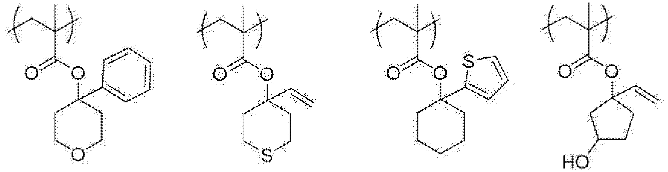

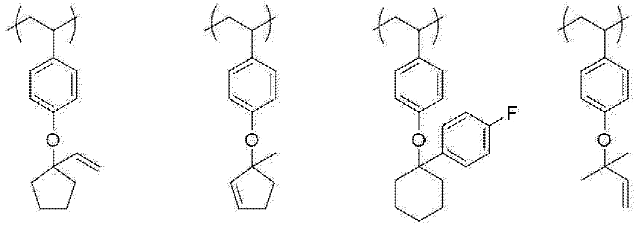

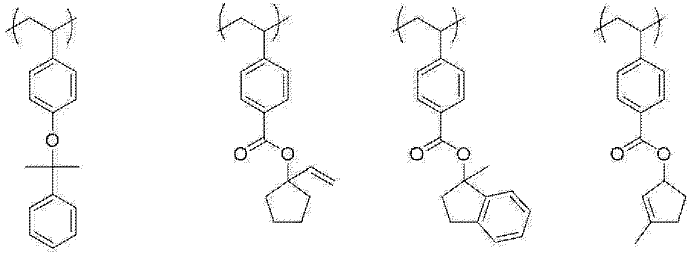

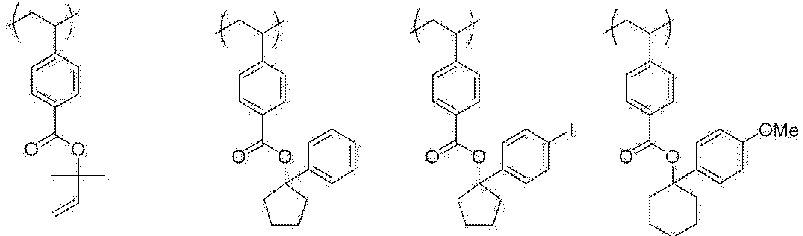

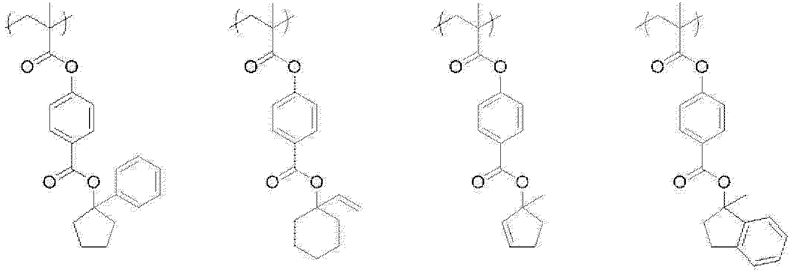

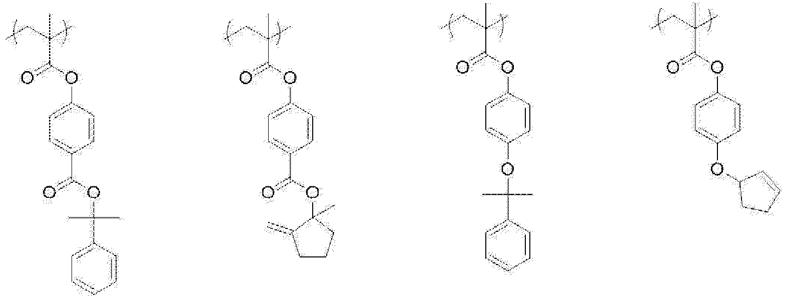

The resin (A) may include a repeating unit other than the above-described repeating units.

For example, the resin (A) may include at least one repeating unit selected from the group consisting of the following Group A and/or at least one repeating unit selected from the group consisting of the following Group B.
Group A: Group consisting of the following repeating units (20) to (29)
   (20) A repeating unit having an acid group, which will be described later
   (21) A repeating unit having a fluorine atom or an iodine atom, which will be described later
   (22) A repeating unit having a lactone group, a sultone group, or a carbonate group, which will be described later
   (23) A repeating unit having a photoacid generating group, which will be described later
   (24) A repeating unit represented by Formula (V-1) or Formula (V-2), which will be described later
   (25) A repeating unit represented by Formula (A), which will be described later
   (26) A repeating unit represented by Formula (B), which will be described later
   (27) A repeating unit represented by Formula (C), which will be described later
   (28) A repeating unit represented by Formula (D), which will be described later
   (29) A repeating unit represented by Formula (E), which will be described later
Group B: Group consisting of the following repeating units (30) to (32)
   (30) A repeating unit having at least one group selected from the group consisting of a lactone group, a sultone group, a carbonate group, a hydroxy group, a cyano group, and an alkali-soluble group, which will be described later
   (31) A repeating unit that has an alicyclic hydrocarbon structure and that does not exhibit acid decomposability, which will be described later
   (32) A repeating unit having neither a hydroxy group nor a cyano group and represented by Formula (III), which will be described later

The resin (A) preferably has an acid group and preferably includes a repeating unit having an acid group, as described later. The definition of the acid group will be described in a later part together with preferred embodiments of the repeating unit having an acid group. When the resin (A) has an acid group, a better interaction between the resin (A) and the acid generated from the photoacid generator is provided. As a result, the diffusion of the acid is further suppressed, and a pattern to be formed can have a more rectangular sectional shape.

When the resist composition is used as an actinic ray-sensitive or radiation-sensitive resin composition for EUV, the resin (A) preferably has at least one repeating unit selected from the group consisting of Group A above.

When the resist composition is used as an actinic ray-sensitive or radiation-sensitive resin composition for EUV, the resin (A) preferably includes at least one of a fluorine atom or an iodine atom. When the resin (A) includes both a fluorine atom and an iodine atom, the resin (A) may have one type of repeating unit including both a fluorine atom and an iodine atom, or the resin (A) may include two types of repeating units including a repeating unit having a fluorine atom and a repeating unit including an iodine atom.

When the resist composition is used as an actinic ray-sensitive or radiation-sensitive resin composition for EUV, the resin (A) also preferably has a repeating unit having an aromatic ring group.

When the resist composition is used as an actinic ray-sensitive or radiation-sensitive resin composition for ArF, the resin (A) preferably has at least one repeating unit selected from the group consisting of Group B above.

When the resist composition is used as an actinic ray-sensitive or radiation-sensitive resin composition for ArF, the resin (A) preferably does not include a fluorine atom or a silicon atom.

When the resist composition is used as an actinic ray-sensitive or radiation-sensitive resin composition for ArF, the resin (A) preferably does not have an aromatic ring group.

The resin (A) preferably has at least one selected from the group consisting of a lactone group, a carbonate group, a sultone group, and a cyclic group having a hydroxy group. The lactone group, the carbonate group, and the sultone group will be described later. The cyclic group having a hydroxy group is preferably an alicyclic group having a hydroxy group, and specific examples thereof include those described as examples in the repeating unit having an acid group described later.

### <Repeating unit having acid group>

The resin (A) preferably has a repeating unit having an acid group.

The acid group is preferably an acid group having a pKa of 13 or less. The acid group preferably has a pKa of 13 or less, more preferably 3 to 13, still more preferably 5 to 10.

When the resin (A) has an acid group having a pKa of 13 or less, the content of the acid group in the resin (A) is often 0.2 to 6.0 mmol/g, preferably 0.8 to 6.0 mmol/g, more preferably 1.2 to 5.0 mmol/g, still more preferably 1.6 to 4.0 mmol/g. When the content of the acid group is within the above range, development suitably proceeds, a pattern to be formed has a good pattern shape, and thus high resolution is also achieved.

The acid group is preferably, for example, a carboxy group, a phenolic hydroxy group, a fluorinated alcohol group (preferably a hexafluoroisopropanol group), a sulfonic group, a sulfonamide group, or an isopropanol group.

In the hexafluoroisopropanol group, one or more (preferably one or two) of the fluorine atoms may be substituted with groups other than fluorine atoms (such as alkoxycarbonyl groups). The acid group is also preferably -C(CF₃)(OH)-CF₂- formed in this manner. Alternatively, one or more of the fluorine atoms may be substituted with groups other than fluorine atoms to form a ring including -C(CF₃)(OH)-CF₂-.

The repeating unit having an acid group is preferably a repeating unit different from the above-described repeating unit having a structure in which a polar group is protected with a leaving group that leaves due to the action of an acid and repeating units having a lactone group, a sultone group, or a carbonate group described later.

The repeating unit having an acid group may have a fluorine atom or an iodine atom.

The repeating unit having an acid group may be any of the following repeating units.

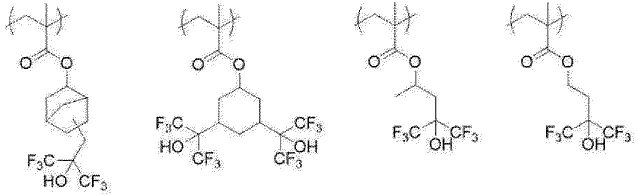

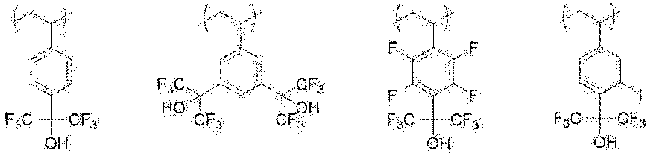

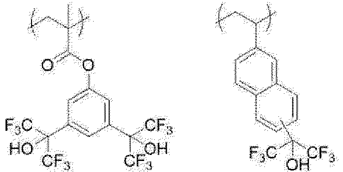

The repeating unit having an acid group is preferably a repeating unit represented by Formula (Y).

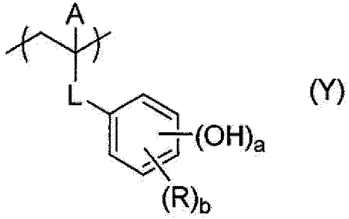

In Formula (Y), A represents a hydrogen atom, an alkyl group, a cycloalkyl group, a halogen atom, or a cyano group.

L represents a single bond or a divalent linking group having an oxygen atom. L is preferably a single bond.

R represents a halogen atom, an alkyl group, a cycloalkyl group, an aryl group, an alkenyl group, an aralkyl group, an alkoxy group, an alkylcarbonyloxy group, an alkylsulfonyloxy group, an alkyloxycarbonyl group, or an aryloxycarbonyl group; when a plurality of R's are present, the plurality of R's may be the same or different. When Formula (Y) has a plurality of R's, the plurality of R's may be bonded together to form a ring. R is preferably a hydrogen atom.
a represents an integer of 1 to 3.
b represents an integer of 0 to (5 - a).

Examples of the repeating unit having an acid group are as follows. In the following formulae, a represents 1 or 2.

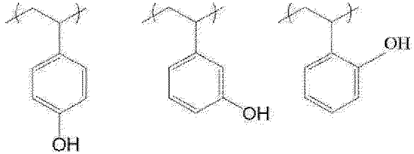

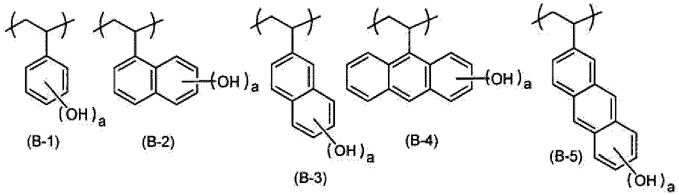

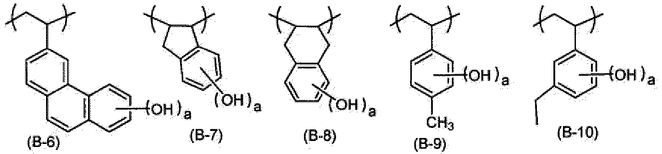

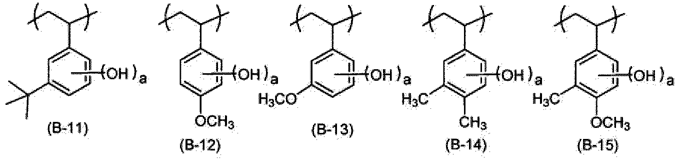

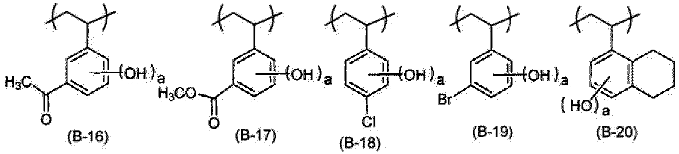

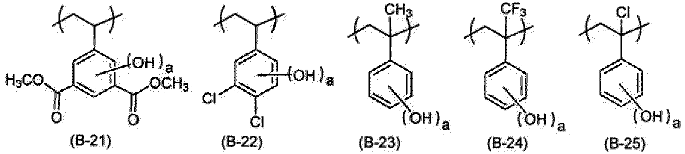

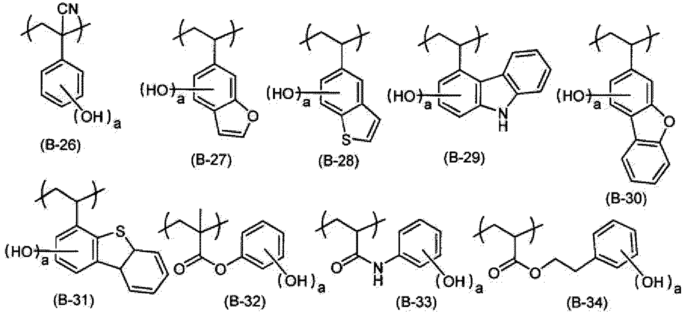

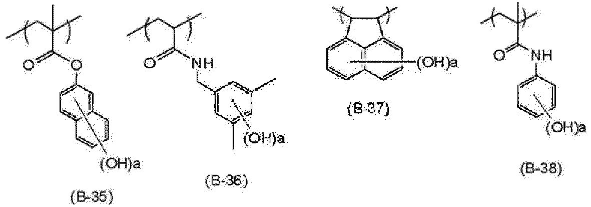

Among the above repeating units, repeating units specifically described below are preferred. In the following formulae, R represents a hydrogen atom or a methyl group, and a represents 2 or 3.

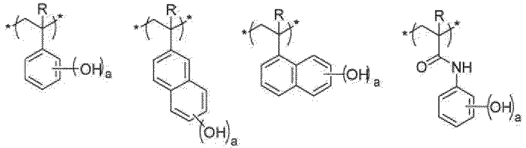

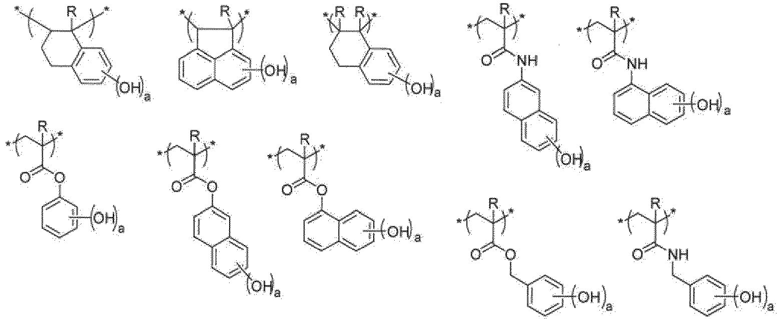

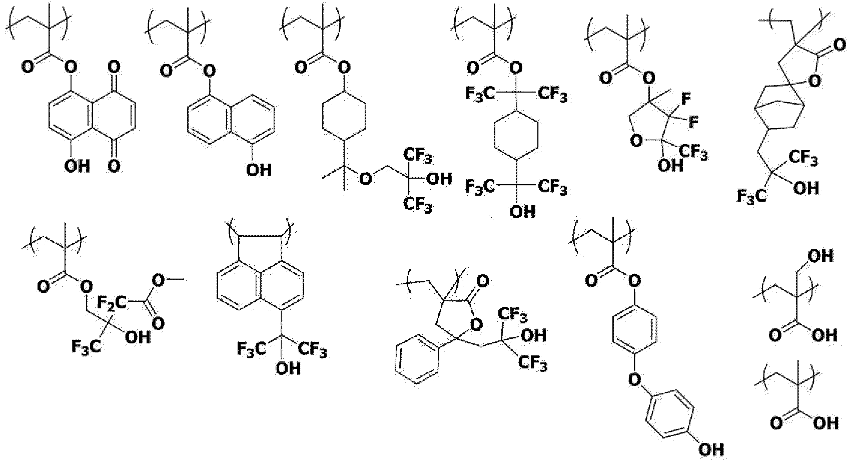

The content of the repeating unit having an acid group is preferably 10 mol% or more, more preferably 15 mol% or more relative to all the repeating units in the resin (A). The upper limit is preferably 70 mol% or less, more preferably 65 mol% or less, still more preferably 60 mol% or less relative to all the repeating units in the resin (A).

### <Repeating unit having fluorine atom, bromine atom, or iodine atom>

The resin (A) may have a repeating unit having a fluorine atom, a bromine atom, or an iodine atom in addition to the above-described <Repeating unit having acid-decomposable group> and <Repeating unit having acid group>. Herein, the <Repeating unit having fluorine atom, bromine atom, or iodine atom> is preferably different from other repeating units belonging to Group A such as <Repeating unit having lactone group, sultone group, or carbonate group> and <Repeating unit having photoacid generating group>, which will be described later.

The repeating unit having a fluorine atom, a bromine atom, or an iodine atom is preferably a repeating unit represented by Formula (C).

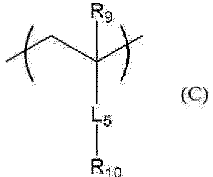

L₅ represents a single bond or an ester group.

R₉ represents a hydrogen atom or an alkyl group that may have a fluorine atom, a bromine atom, or an iodine atom.

R₁₀ represents a hydrogen atom, an alkyl group that may have a fluorine atom, a bromine atom, or an iodine atom, a cycloalkyl group that may have a fluorine atom, a bromine atom, or an iodine atom, an aryl group that may have a fluorine atom, a bromine atom, or an iodine atom, or a group provided by combining the foregoing.

Examples of the repeating unit having a fluorine atom or an iodine atom are as follows.

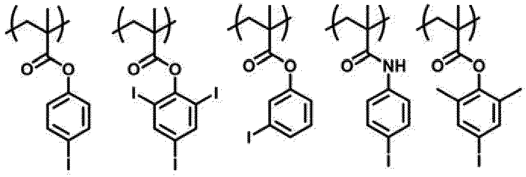

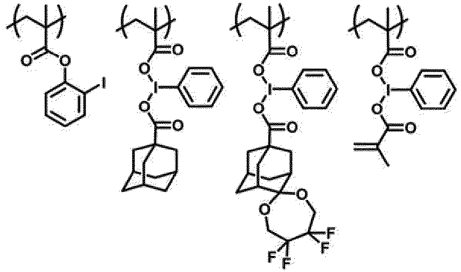

The content of the repeating unit having a fluorine atom, a bromine atom, or an iodine atom is preferably 0 mol% or more, more preferably 5 mol% or more, still more preferably 10 mol% or more relative to all the repeating units in the resin (A). The upper limit is preferably 50 mol% or less, more preferably 45 mol% or less, still more preferably 40 mol% or less relative to all the repeating units in the resin (A).

As described above, since the repeating unit having a fluorine atom, a bromine atom, or an iodine atom does not include the above-described <Repeating unit having acid-decomposable group> and <Repeating unit having acid group>, the content of the repeating unit having a fluorine atom, a bromine atom, or an iodine atom also means the content of the repeating unit having a fluorine atom, a bromine atom, or an iodine atom excluding the <Repeating unit having acid-decomposable group> and <Repeating unit having acid group>.

Among the repeating units of the resin (A), the total content of repeating units including at least one of a fluorine atom, a bromine atom, or an iodine atom is preferably 10 mol% or more, more preferably 20 mol% or more, still more preferably 30 mol% or more, particularly preferably 40 mol% or more relative to all the repeating units in the resin (A). The upper limit is, for example, 100 mol% or less relative to all the repeating units in the resin (A).

Note that examples of the repeating units including at least one of a fluorine atom, a bromine atom, or an iodine atom include a repeating unit having a fluorine atom, a bromine atom, or an iodine atom and having an acid-decomposable group, a repeating unit having a fluorine atom, a bromine atom, or an iodine atom and having an acid group, and a repeating unit having a fluorine atom, a bromine atom, or an iodine atom.

### <Repeating unit having at least one group selected from the group consisting of lactone group, sultone group, carbonate group, hydroxy group, cyano group, and alkali-soluble group>

The resin (A) may have a repeating unit having at least one group selected from the group consisting of a lactone group, a sultone group, a carbonate group, a hydroxy group, a cyano group, and an alkali-soluble group.

First, a repeating unit having at least one selected from the group consisting of a lactone group, a sultone group, and a carbonate group (hereinafter, also collectively referred to as a "repeating unit having a lactone group, a sultone group, or a carbonate group") will be described.

It is also preferable that the repeating unit having a lactone group, a sultone group, or a carbonate group do not have acid groups such as a hydroxy group and a hexafluoropropanol group.

The lactone group or the sultone group at least has a lactone structure or a sultone structure. The lactone structure or the sultone structure is preferably a five- to seven-membered lactone structure or a five- to seven-membered sultone structure. More preferred is a five- to seven-membered lactone structure to which another ring structure is fused so as to form a bicyclo structure or a spiro structure, or a five- to seven-membered sultone structure to which another ring structure is fused so as to form a bicyclo structure or a spiro structure.

The resin (A) preferably has a repeating unit having a lactone group or a sultone group formed by removing, from ring-member atoms of the lactone structure represented by any one of Formulae (LC1-1) to (LC1-21) below or the sultone structure represented by any one of Formulae (SL1-1) to (SL1-3) below, one or more hydrogen atoms.

A lactone group or a sultone group may be directly bonded to the main chain. For example, ring-member atoms of a lactone group or a sultone group may constitute the main chain of the resin (A).

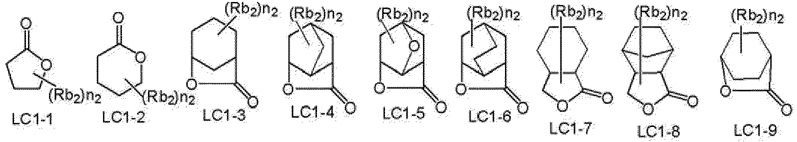

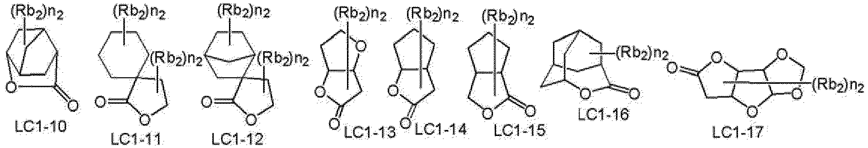

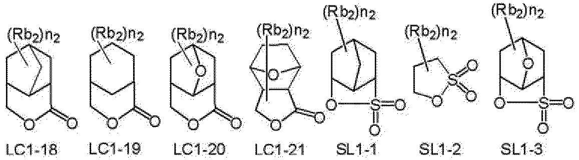

The lactone or sultone structural moiety may have a substituent (Rb₂). Preferred examples of the substituent (Rb₂) include an alkyl group having 1 to 8 carbon atoms, a cycloalkyl group having 4 to 7 carbon atoms, an alkoxy group having 1 to 8 carbon atoms, an alkoxycarbonyl group having 1 to 8 carbon atoms, a carboxy group, a halogen atom, a cyano group, and an acid-decomposable group. n2 represents an integer of 0 to 4. When n2 is 2 or more, a plurality of Rb₂'s may be different and a plurality of Rb₂'s may be bonded together to form a ring.

The repeating unit having a group including the lactone structure represented by any one of Formulae (LC1-1) to (LC1-21) or the sultone structure represented by any one of Formulae (SL1-1) to (SL1-3) is, for example, a repeating unit represented by Formula (AI).

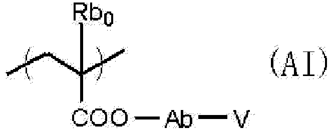

In Formula (AI), Rb₀ represents a hydrogen atom, a halogen atom, or an alkyl group having 1 to 4 carbon atoms.

A preferred substituent that the alkyl group in Rb₀ may have is, for example, a hydroxy group or a halogen atom.

Examples of the halogen atom in Rb₀ include a fluorine atom, a chlorine atom, a bromine atom, and an iodine atom. Rb₀ is preferably a hydrogen atom or a methyl group.

Ab represents a single bond, an alkylene group, a divalent linking group having a monocyclic or polycyclic alicyclic hydrocarbon structure, an ether group, an ester group, a carbonyl group, a carboxy group, or a divalent group provided by combining the foregoing. A single bond or a linking group represented by -Ab₁-CO₂- is preferred. Ab₁ is a linear or branched alkylene group or a monocyclic or polycyclic cycloalkylene group, and preferably a methylene group, an ethylene group, a cyclohexylene group, an adamantylene group, or a norbomylene group.

V represents a group provided by abstracting one hydrogen atom from a ring member atom of the lactone structure represented by any one of Formulae (LC1-1) to (LC1-21) or a group provided by abstracting one hydrogen atom from a ring-member atom of the sultone structure represented by any one of Formulae (SL1-1) to (SL1-3).

When the repeating unit having a lactone group or a sultone group has an optical isomer, any optical isomer may be used. A single optical isomer may be used alone, or a plurality of optical isomers may be used in combination. When a single optical isomer is mainly used, its optical purity (ee) is preferably 90 or more, more preferably 95 or more.

The carbonate group is preferably a cyclic carbonate group.

The repeating unit having a cyclic carbonate group is preferably a repeating unit represented by Formula (A-1).

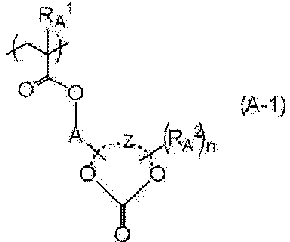

In Formula (A-1), R_{A}¹ represents a hydrogen atom, a halogen atom, or a monovalent organic group (preferably a methyl group).

n represents an integer of 0 or more.

R_{A}² represents a substituent. When n is 2 or more, a plurality of R_{A}²'s may be the same or different from each other.

A represents a single bond or a divalent linking group. The divalent linking group is preferably an alkylene group, a divalent linking group having a monocyclic or polycyclic alicyclic hydrocarbon structure, an ether group, an ester group, a carbonyl group, a carboxyl group, or a divalent group provided by combining the foregoing.

Z represents an atomic group that forms a monocyclic ring or a polycyclic ring together with the group represented by -O-CO-O- in the formula.

Examples of the repeating unit having a lactone group, a sultone group, or a carbonate group are as follows.

(In the following formulae, Rx represents H, CH₃, CH₂OH, or CF₃.)

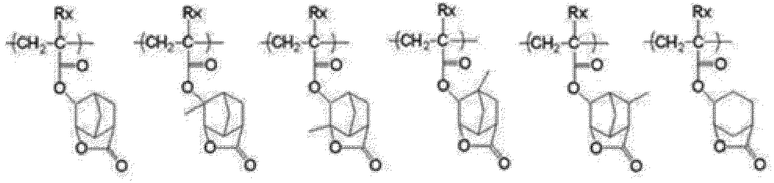

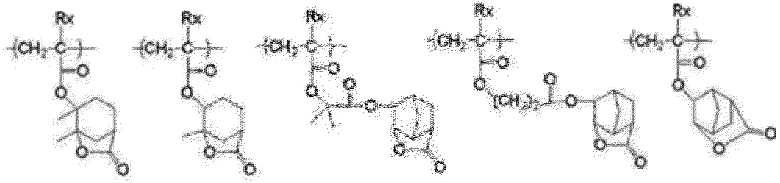

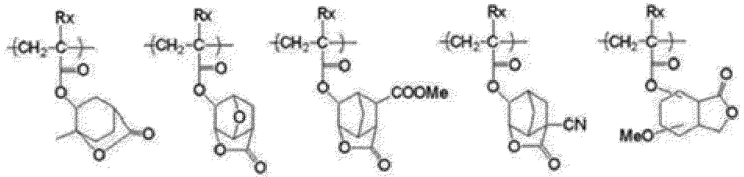

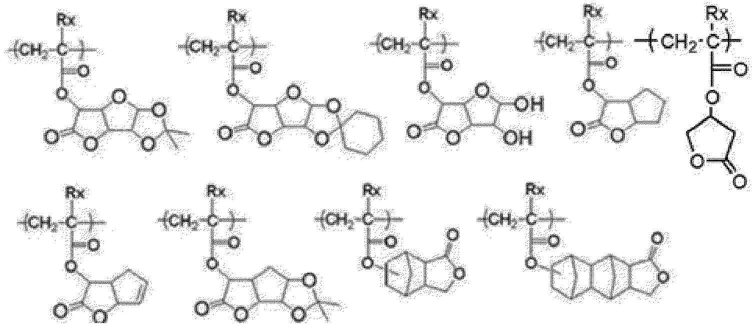

(In the following formulae, Rx represents H, CH₃, CH₂OH, or CF₃.)

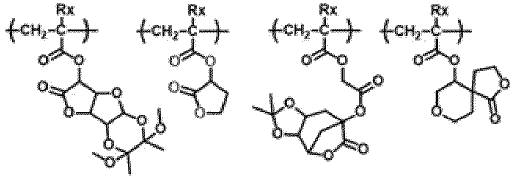

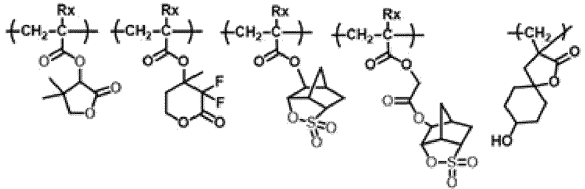

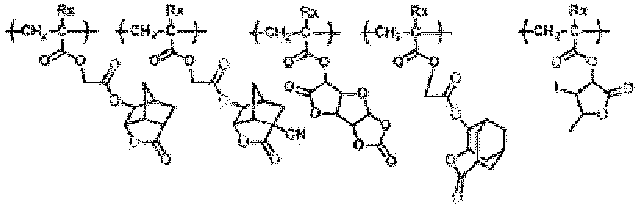

(In the following formulae, Rx represents H, CH₃, CH₂OH, or CF₃.)

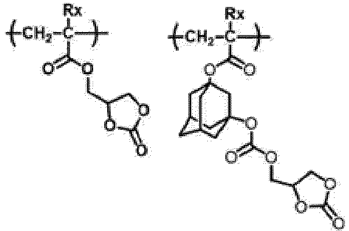

Next, a repeating unit having a hydroxy group or a cyano group will be described.

The resin (A) may have a repeating unit having a hydroxy group or a cyano group. This results in improvement in adhesiveness to a substrate and affinity for a developer.

The repeating unit having a hydroxy group or a cyano group is preferably a repeating unit having an alicyclic hydrocarbon structure substituted with a hydroxy group or a cyano group.

Preferably, the repeating unit having a hydroxy group or a cyano group has no acid-decomposable group. Examples of the repeating unit having a hydroxy group or a cyano group include those described in paragraphs [0081] to [0084] of JP2014-098921A.

Next, a repeating unit having an alkali-soluble group will be described.

The resin (A) may have a repeating unit having an alkali-soluble group.

The alkali-soluble group may be a carboxy group, a sulfonamide group, a sulfonylimide group, a bissulfonylimide group, or an aliphatic alcohol substituted with an electron-withdrawing group at the α-position (for example, a hexafluoroisopropanol group) and is preferably a carboxy group. When the resin (A) includes a repeating unit having an alkali-soluble group, the resolution is increased in contact hole applications. Examples of the repeating unit having an alkali-soluble group include those described in paragraphs [0085] and [0086] of JP2014-098921A.

The content of the repeating unit having at least one group selected from the group consisting of a lactone group, a sultone group, a carbonate group, a hydroxy group, a cyano group, and an alkali-soluble group is preferably 1 mol% or more, more preferably 10 mol% or more relative to all the repeating units in the resin (A). The upper limit is preferably 85 mol% or less, more preferably 80 mol% or less, still more preferably 70 mol% or less, particularly preferably 60 mol% or less relative to all the repeating units in the resin (A).

### <Repeating unit having photoacid generating group>

The resin (A) may have a repeating unit having a group that generates an acid upon irradiation with an actinic ray or a radiation (hereinafter, also referred to as a "photoacid generating group") as a repeating unit other than the above repeating units.

Examples of the repeating unit having a photoacid generating group are as follows.

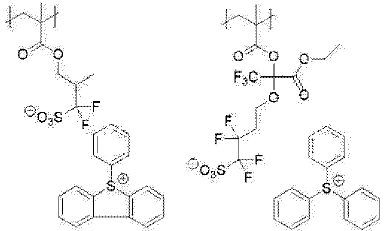

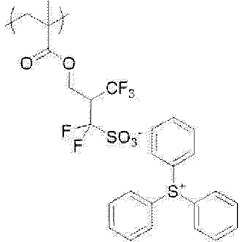

Examples of the repeating unit having a photoacid generating group include the repeating units described in paragraphs [0094] to [0105] of JP2014-041327A and the repeating units described in paragraph [0094] of WO2018/193954A.

The content of the repeating unit having a photoacid generating group is preferably 1 mol% or more, more preferably 5 mol% or more relative to all the repeating units in the resin (A). The upper limit is preferably 40 mol% or less, more preferably 35 mol% or less, still more preferably 30 mol% or less relative to all the repeating units in the resin (A).

### <Repeating unit represented by Formula (V-1) or Formula (V-2)>

The resin (A) may have a repeating unit represented by Formula (V-1) or Formula (V-2).

The repeating units represented by Formula (V-1) and Formula (V-2) are preferably repeating units different from the repeating units described above.

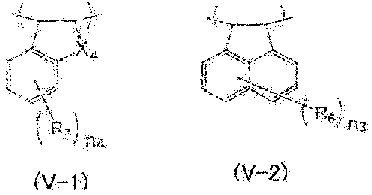

In the formulae, R₆ and R₇ each independently represent a hydrogen atom, a hydroxy group, an alkyl group, an alkoxy group, an acyloxy group, a cyano group, a nitro group, an amino group, a halogen atom, an ester group (-OCOR or -COOR: R represents an alkyl group or fluorinated alkyl group having 1 to 6 carbon atoms), or a carboxy group. The alkyl group is preferably a linear, branched, or cyclic alkyl group having 1 to 10 carbon atoms.

n₃ represents an integer of 0 to 6.

n₄ represents an integer of 0 to 4.

X⁴ is a methylene group, an oxygen atom, or a sulfur atom.

Examples of the repeating unit represented by Formula (V-1) or (V-2) include the repeating units described in paragraph [0100] of WO2018/193954A.

### <Repeating unit for decreasing mobility of main chain>

The resin (A) preferably has a high glass transition temperature (Tg) from the viewpoint that excessive diffusion of the generated acid or pattern collapse during development can be suppressed. Tg is preferably higher than 90°C, more preferably higher than 100°C, still more preferably higher than 110°C, particularly preferably higher than 125°C. Note that since an excessive increase in Tg leads to a decrease in the dissolution rate in developers, Tg is preferably 400°C or lower, more preferably 350°C or lower.

In the present specification, the glass transition temperature (Tg) of a polymer such as the resin (A) (hereinafter, "Tg of repeating units") is calculated by the following method. First, Tg's of homopolymers composed only of the repeating units included in the polymer are calculated by the Bicerano method. Next, the mass ratios (%) of the repeating units relative to all the repeating units in the polymer are calculated. Next, Tg's at the mass ratios are calculated using the Fox equation (described in, for example, Materials Letters 62 (2008) 3152), and the sum total of the Tg's is defined as the Tg (°C) of the polymer.

The Bicerano method is described in Prediction of polymer properties, Marcel Dekker Inc., New York (1993). The calculation of Tg by the Bicerano method can be performed using software for estimating physical properties of polymers, MDL Polymer (MDL Information Systems, Inc.).

In order to increase Tg of the resin (A) (preferably, to make Tg higher than 90°C), the mobility of the main chain of the resin (A) is preferably decreased. Examples of the method for decreasing the mobility of the main chain of the resin (A) include the following methods (a) to (e): (a) introduction of a bulky substituent into the main chain, (b) introduction of a plurality of substituents into the main chain, (c) introduction of substituents that induce an interaction between molecules of the resin (A) at positions near the main chains, (d) formation of the main chain with a ring structure, and (e) linking of a ring structure to the main chain.

The resin (A) preferably has a repeating unit whose homopolymer has a Tg of 130°C or higher.

The type of the repeating unit whose homopolymer has a Tg of 130°C or higher may be any repeating unit whose homopolymer has a Tg of 130°C or higher as calculated by the Bicerano method. Note that repeating units represented by Formula (A) to Formula (E), which will be described later, may, depending on the types of functional groups, correspond to the repeating unit whose homopolymer has a Tg of 130°C or higher.

### (Repeating unit represented by Formula (A))

An example of specific means for achieving (a) above is a method of introducing a repeating unit represented by Formula (A) into the resin (A).

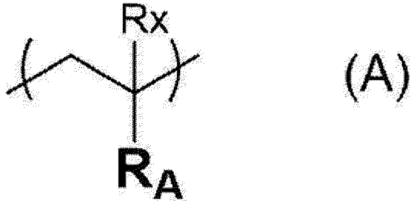

Formula (A), R_{A} represents a group including a polycyclic structure. Rₓ represents a hydrogen atom, a methyl group, or an ethyl group. The group including a polycyclic structure is a group including a plurality of ring structures, and the plurality of ring structures may be fused together or may not be fused together.

Examples of the repeating unit represented by Formula (A) include those described in paragraphs [0107] to [0119] of WO2018/193954A.

### (Repeating unit represented by Formula (B))

An example of specific means for achieving (b) above is a method of introducing a repeating unit represented by Formula (B) into the resin (A).

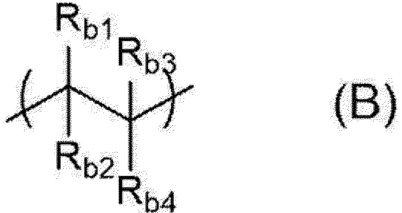

In Formula (B), R_{b1} to R_{b4} each independently represent a hydrogen atom or an organic group, and at least two or more of R_{b1} to R_{b4} represent organic groups.

When at least one of the organic groups is a group whose ring structure is directly linked to the main chain in the repeating unit, the types of other organic groups are not particularly limited.

When none of the organic groups is a group whose ring structure is directly linked to the main chain in the repeating unit, at least two or more of the organic groups are substituents in which the number of constituent atoms excluding hydrogen atoms is 3 or more.

Examples of the repeating unit represented by Formula (B) include those described in paragraphs [0113] to [0115] of WO2018/193954A.

### (Repeating unit represented by Formula (C))

An example of specific means for achieving (c) above is a method of introducing a repeating unit represented by Formula (C) into the resin (A).

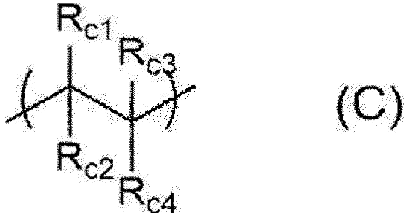

In Formula (C), R_{c1} to R_{c4} each independently represent a hydrogen atom or an organic group, and at least one of R_{c1} to R_{c4} is a group including a hydrogen-bond-forming hydrogen atom positioned within three atoms from a carbon atom in the main chain. From the viewpoint of inducing the interaction between the main chains of the resin (A), it is preferable to have a hydrogen-bond-forming hydrogen atom positioned within two atoms (closer to the main chain).

Examples of the repeating unit represented by Formula (C) include those described in paragraphs [0119] to [0121] of WO2018/193954A.

### (Repeating unit represented by Formula (D))

An example of specific means for achieving (d) above is a method of introducing a repeating unit represented by Formula (D) into the resin (A).

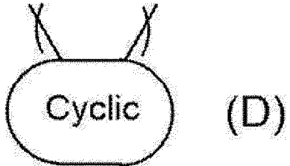

In Formula (D), "cylic" represents a group that forms the main chain with a ring structure. The number of atoms constituting the ring is not particularly limited.

Examples of the repeating unit represented by Formula (D) include those described in paragraphs [0126] and [0127] of WO2018/193954A.

### (Repeating unit represented by Formula (E))

An example of specific means for achieving (e) above is a method of introducing a repeating unit represented by Formula (E) into the resin (A).

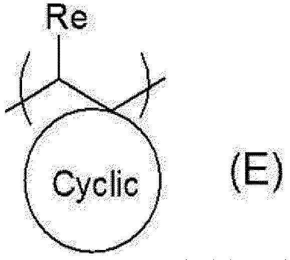

In Formula (E), each Re independently represents a hydrogen atom or an organic group. The organic group may be, for example, an alkyl group, cycloalkyl group, aryl group, aralkyl group, or alkenyl group that may have a substituent.

"Cylic" is a cyclic group including a carbon atom of the main chain. The number of atoms included in the cyclic group is not particularly limited.

Examples of the repeating unit represented by Formula (E) include those described in paragraphs [0131] to [0133] of WO2018/193954A.

### <Repeating unit that has alicyclic hydrocarbon structure and that does not exhibit acid decomposability>

The resin (A) may have a repeating unit that has an alicyclic hydrocarbon structure and that does not exhibit acid decomposability. This makes it possible to reduce leaching of low-molecular-weight components, during liquid immersion exposure, from the resist film into the immersion liquid. Examples of such a repeating unit include repeating units derived from 1-adamantyl (meth)acrylate, diamantyl (meth)acrylate, tricyclodecanyl (meth)acrylate, or cyclohexyl (meth)acrylate.

### <Repeating unit having neither hydroxy group nor cyano group and represented by Formula (III)>

The resin (A) may have a repeating unit having neither a hydroxy group nor a cyano group and represented by Formula (III).

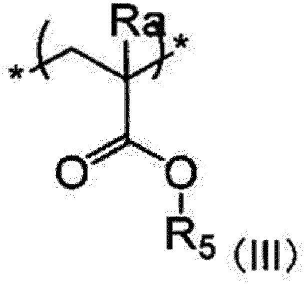

In Formula (III), R₅ represents a hydrocarbon group having at least one ring structure and having neither a hydroxy group nor a cyano group.

Ra represents a hydrogen atom, an alkyl group, or a -CH₂-O-Ra₂ group. In the formula, Ra₂ represents a hydrogen atom, an alkyl group, or an acyl group.

Examples of the repeating unit having neither a hydroxy group nor a cyano group and represented by Formula (III) include those described in paragraphs [0087] to [0094] of JP2014-098921A.

### <Other repeating units>

Furthermore, the resin (A) may have a repeating unit other than the above-described repeating units.

For example, the resin (A) may have a repeating unit selected from the group consisting of a repeating unit having an oxathiane ring group, a repeating unit having an oxazolone ring group, a repeating unit having a dioxane ring group, and a repeating unit having a hydantoin ring group.

Examples of such repeating units are as follows.

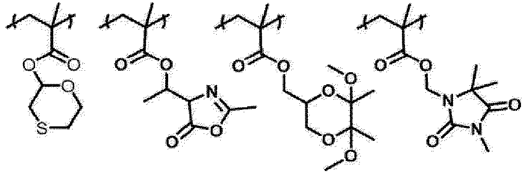

The resin (A) may have, in addition to the repeating units described above, various repeating units for the purpose of adjusting, for example, dry etching resistance, suitability for a standard developer, substrate adhesiveness, resist profile, resolution, heat resistance, and sensitivity.

For the resin (A), (in particular, when the resist composition is used as an actinic ray-sensitive or radiation-sensitive resin composition for ArF), all the repeating units are preferably constituted by repeating units derived from compounds having ethylenically unsaturated bonds. In particular, all the repeating units are also preferably constituted by (meth)acrylate-based repeating units. In this case, all the repeating units may be methacrylate-based repeating units, all the repeating units may be acrylate-based repeating units, or all the repeating units may be methacrylate-based repeating units and acrylate-based repeating units, and acrylate-based repeating units preferably account for 50 mol% or less of all the repeating units.

The resin (A) can be synthesized by an ordinary method (for example, radical polymerization).

The resin (A) preferably has a weight-average molecular weight of 30,000 or less, preferably 1,000 to 30,000, more preferably 3,000 to 30,000, still more preferably 5,000 to 15,000 in terms of polystyrene as determined by the GPC method.

The dispersity (molecular weight distribution) of the resin (A) is usually 1 to 5, preferably 1 to 3, more preferably 1.2 to 3.0, still more preferably 1.2 to 2.0. The smaller the dispersity, the better the resolution and the resist profile, the soother the sidewalls of the resist pattern, and the better the roughness performance.

In the resist composition, the content of the resin (A) is preferably 40.0 to 99.9 mass%, more preferably 60.0 to 90.0 mass% relative to the total solid content of the resist composition.

Such resins (A) may be used alone or in combination of two or more thereof.

### [Photoacid generator]

The resist composition preferably includes a compound that generates an acid upon irradiation with an actinic ray or a radiation (photoacid generator).

A preferred embodiment of the photoacid generator may be a compound (I) or a compound (II) described below.

The compound (I) and the compound (II) (hereinafter, the "compound (I) and compound (II)" are also simply referred to as "photoacid generator PG1") will be described below.

### <Compound (I)>

The compound (I) is a compound having one or more of the following structural moiety X and one or more of the following structural moiety Y and is a compound that generates an acid including the following first acidic moiety derived from the following structural moiety X and the following second acidic moiety derived from the following structural moiety Y upon irradiation with an actinic ray or a radiation.

Structural moiety X: A structural moiety that is constituted by an anionic moiety A₁⁻ and a cationic moiety M₁⁺ and that forms the first acidic moiety represented by HA₁ upon irradiation with an actinic ray or a radiation

Structural Moiety Y: A structural moiety that is constituted by an anionic moiety A₂⁻ and a cationic moiety M₂⁺ and that forms the second acidic moiety represented by HA₂ upon irradiation with an actinic ray or a radiation

Here, the compound (I) satisfies the following condition I.

Condition I: A compound PI in which, in the compound (I), the cationic moiety M₁⁺ in the structural moiety X and the cationic moiety M₂⁺ in the structural moiety Y are replaced by H⁺ has an acid dissociation constant a1 derived from an acidic moiety represented by HA₁ in which the cationic moiety M₁⁺ in the structural moiety X is replaced by H⁺ and an acid dissociation constant a2 derived from an acidic moiety represented by HA₂ in which the cationic moiety M₂⁺ in the structural moiety Y is replaced by H⁺, and the acid dissociation constant a2 is larger than the acid dissociation constant a1.

The condition I will be more specifically described below.

When the compound (I) is, for example, a compound that generates an acid having a single first acidic moiety derived from the structural moiety X and a single second acidic moiety derived from the structural moiety Y, the compound PI corresponds to a "compound having HA₁ and HA₂".

The acid dissociation constant a1 and the acid dissociation constant a2 of such a compound PI are more specifically described as follows. In determination of the acid dissociation constants of the compound PI, the pKa determined when the compound PI is turned into a "compound having A₁⁻ and HA₂" is the acid dissociation constant a1, and the pKa determined when the "compound having A₁⁻ and HA₂" is turned into a "compound having A₁⁻and A₂⁻" is the acid dissociation constant a2.

When the compound (I) is, for example, a compound that generates an acid having two first acidic moieties derived from the structural moiety X and a single second acidic moiety derived from the structural moiety Y, the compound PI corresponds to a "compound having two HA₁ and a single HA₂".

In determination of the acid dissociation constants of such a compound PI, the acid dissociation constant determined when the compound PI is turned into a "compound having a single A₁⁻, a single HA₁, and a single HA₂" and the acid dissociation constant determined when the "compound having a single A₁⁻, a single HA₁, and a single HA₂" is turned into a "compound having two A₁⁻ and a single HA₂" correspond to the above-described acid dissociation constant a1. The acid dissociation constant determined when the "compound having two A₁⁻ and a single HA₂" is turned into a "compound having two A₁⁻ and A₂⁻" corresponds to the acid dissociation constant a2. That is, as in such a compound PI, when there are a plurality of acid dissociation constants derived from acidic moieties represented by HA₁ in which the cationic moiety M₁⁺ in the structural moiety X is replaced by H⁺, the value of the acid dissociation constant a2 is larger than the maximum value of the plurality of acid dissociation constants a1. Note that, when the acid dissociation constant determined when the compound PI is turned into a "compound having a single A₁⁻, a single HA₁, and a single HA₂" is defined as aa and the acid dissociation constant determined when the "compound having a single A₁⁻, a single HA₁, and a single HA₂" is turned into a "compound having two A₁⁻ and a single HA₂" is defined as ab, the relation between aa and ab satisfies aa < ab.

The acid dissociation constant a1 and the acid dissociation constant a2 can be determined by the above-described method of measuring an acid dissociation constant.

The compound PI corresponds to an acid generated when the compound (I) is irradiated with an actinic ray or a radiation.

When the compound (I) has two or more structural moieties X, the structural moieties X may be the same or different. The two or more A₁⁻ and the two or more M₁⁺ may be individually the same or different.

In the compound (I), the A₁⁻ and the A₂⁻, and the M₁⁺ and the M₂⁺ may be individually the same or different, but the A₁⁻ and the A₂⁻ are preferably different.

From the viewpoint of a better LWR performance of the pattern to be formed, in the compound PI, the difference between the acid dissociation constant a1 (in the case where a plurality of acid dissociation constants a1 are present, the maximum value thereof) and the acid dissociation constant a2 is preferably 0.1 or more, more preferably 0.5 or more, still more preferably 1.0 or more. The upper limit of the difference between the acid-dissociation constant a1 (in the case where a plurality of acid dissociation constants a1 are present, the maximum value thereof) and the acid-dissociation constant a2 is, for example, 16 or less.

From the viewpoint of a better LWR performance of the pattern to be formed, in the compound PI, the acid dissociation constant a2 is, for example, 20 or less, preferably 15 or less. The lower limit of the acid dissociation constant a2 is preferably -4.0 or more.

From the viewpoint of a better LWR performance of the pattern to be formed, in the compound PI, the acid dissociation constant a1 is preferably 2.0 or less, more preferably 0 or less. The lower limit of the acid dissociation constant a1 is preferably -20.0 or more.

The anionic moiety A₁⁻ and the anionic moiety A₂⁻ are structural moieties including a negatively charged atom or atomic group and are, for example, structural moieties selected from the group consisting of Formulae (AA-1) to (AA-3) and Formulae (BB-1) to (BB-6) below. The anionic moiety A₁⁻ is preferably one that can form an acidic moiety having a small acid dissociation constant, and preferably any one of Formulae (AA-1) to (AA-3). The anionic moiety A₂⁻ is preferably one that can form an acidic moiety having a larger acid dissociation constant than the anionic moiety A₁⁻ and is preferably selected from the group consisting of Formulae (BB-1) to (BB-6). In Formulae (AA-1) to (AA-3) and Formulae (BB-1) to (BB-6) below, * represents a bonding site. R^{A} each represent a monovalent organic group. The monovalent organic groups represented by R^{A} may be a cyano group, a trifluoromethyl group, or a methanesulfonyl group.

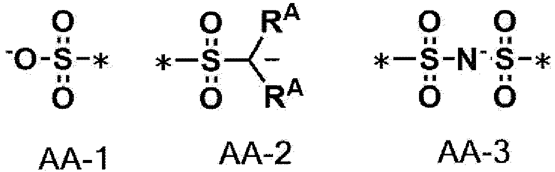

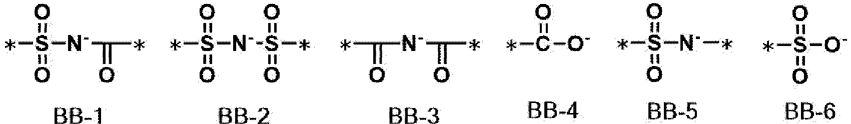

The cationic moiety M₁⁺ and the cationic moiety M₂⁺ are structural moieties including a positively charged atom or atomic group and are, for example, organic cations having a charge number of 1. The organic cations may be, for example, the same organic cations as those represented by M₁₁⁺ and M₁₂⁺ in Formula (Ia-1) described below.

Examples of the specific structure of the compound (I) include compounds represented by Formula (Ia-1) to Formula (Ia-5) described below.

First, the compound represented by Formula (Ia-1) will be described below. The compound represented by Formula (Ia-1) is as follows.

M₁₁⁺A₁₁⁻-L₁-A₁₂⁻M₁₂⁺ (Ia-1)

The compound (Ia-1) generates an acid represented by HA₁₁-L₁-A₁₂H upon irradiation with an actinic ray or a radiation.

In Formula (Ia-1), M₁₁⁺ and M₁₂⁺ each independently represent an organic cation. A₁₁⁻ and A₁₂⁻ each independently represent a monovalent anionic functional group.

L₁ represents a divalent linking group.

M₁₁⁺ and M₁₂⁺ may be the same or different.

A₁₁⁻ and A₁₂⁻ may be the same or different, but are preferably different from each other.

Note that, in a compound PIa (HA₁₁-L₁-A₁₂H) in which, in Formula (Ia-1) above, the organic cations represented by M₁₁⁺ and M₁₂⁺ are replaced by H⁺, the acid dissociation constant a2 derived from the acidic moiety represented by A₁₂H is larger than the acid dissociation constant a1 derived from the acidic moiety represented by HA₁₁. Preferred values of the acid dissociation constant a1 and the acid dissociation constant a2 are the same as those described above. The compound PIa is the same as the acid generated from the compound represented by Formula (Ia-1) upon irradiation with an actinic ray or a radiation.

At least one of M₁₁⁺, M₁₂⁺, A₁₁⁻, A₁₂⁻, or L₁ may have an acid-decomposable group as a substituent.

In Formula (Ia-1), the organic cations represented by M₁₁⁺ and M₁₂⁺ are as described below.

The monovalent anionic functional group represented by A₁₁⁻ means a monovalent group including the above-described anionic moiety A₁⁻. The monovalent anionic functional group represented by A₁₂⁻ means a monovalent group including the above-described anionic moiety A₂⁻.

The monovalent anionic functional groups represented by A₁₁⁻ and A₁₂⁻ are preferably monovalent anionic functional groups including the above-described anionic moiety of any one of Formulae (AA-1) to (AA-3) and Formulae (BB-1) to (BB-6), more preferably monovalent anionic functional groups selected from the group consisting of Formulae (AX-1) to (AX-3) and Formulae (BX-1) to (BX-7). The monovalent anionic functional group represented by A₁₁⁻ is preferably the monovalent anionic functional group represented by any one of Formulae (AX-1) to (AX-3). The monovalent anionic functional group represented by A₁₂⁻ is preferably the monovalent anionic functional group represented by any one of Formulae (BX-1) to (BX-7), more preferably the monovalent anionic functional group represented by any one of Formulae (BX-1) to (BX-6).

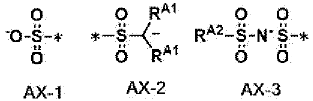

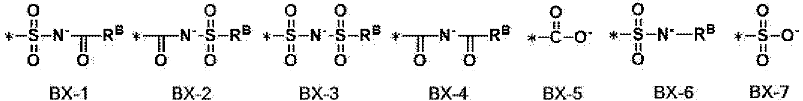

In Formulae (AX-1) to (AX-3), R^{A1} and R^{A2} each independently represent a monovalent organic group. * represents a bonding site.

The monovalent organic groups represented by R^{A1} may be a cyano group, a trifluoromethyl group, or a methanesulfonyl group.

The monovalent organic group represented by R^{A2} is preferably a linear, branched, or cyclic alkyl group or an aryl group.

The number of carbon atoms of the alkyl group is preferably 1 to 15, more preferably 1 to 10, still more preferably 1 to 6.

The alkyl group may have a substituent. The substituent is preferably a fluorine atom or a cyano group, more preferably a fluorine atom. When the alkyl group has a fluorine atom as a substituent, the alkyl group may be a perfluoroalkyl group.

The aryl group is preferably a phenyl group or a naphthyl group, more preferably a phenyl group.

The aryl group may have a substituent. The substituent is preferably a fluorine atom, an iodine atom, a perfluoroalkyl group (for example, preferably having 1 to 10 carbon atoms, more preferably 1 to 6 carbon atoms), or a cyano group, more preferably a fluorine atom, an iodine atom, or a perfluoroalkyl group.

In Formulae (BX-1) to (BX-4) and Formula (BX-6), R^{B} represent a monovalent organic group. * represents a bonding site.

The monovalent organic groups represented by R^{B} are preferably a linear, branched, or cyclic alkyl group or an aryl group.

The number of carbon atoms of the alkyl group is preferably 1 to 15, more preferably 1 to 10, still more preferably 1 to 6.

The alkyl group may have a substituent. The substituent is preferably a fluorine atom or a cyano group, more preferably a fluorine atom. When the alkyl group has a fluorine atom as a substituent, the alkyl group may be a perfluoroalkyl group.

Note that, in the alkyl group, when a carbon atom serving as a bonding site (which corresponds to, for example, in the case of Formulae (BX-1) and (BX-4), the carbon atom directly bonded to -CO- clearly shown in the formula of such an alkyl group; in the case of Formulae (BX-2) and (BX-3), the carbon atom directly bonded to -SO₂- clearly shown in the formula of such an alkyl group; and in the case of Formula (BX-6), the carbon atom directly bonded to -N⁻- clearly shown in the formula of the alkyl group) has a substituent, the substituent is also preferably a substituent other than a fluorine atom and a cyano group.

In the alkyl group, a carbon atom may be replaced by a carbonyl carbon.

The aryl group is preferably a phenyl group or a naphthyl group, more preferably a phenyl group.

The aryl group may have a substituent. The substituent is preferably a fluorine atom, an iodine atom, a perfluoroalkyl group (for example, preferably having 1 to 10 carbon atoms, more preferably 1 to 6 carbon atoms), a cyano group, an alkyl group (for example, preferably having 1 to 10 carbon atoms, more preferably 1 to 6 carbon atoms), an alkoxy group (for example, preferably having 1 to 10 carbon atoms, more preferably 1 to 6 carbon atoms), or an alkoxycarbonyl group (for example, preferably having 2 to 10 carbon atoms, more preferably 2 to 6 carbon atoms), more preferably a fluorine atom, an iodine atom, a perfluoroalkyl group, an alkyl group, an alkoxy group, or an alkoxycarbonyl group.

In Formula (I), examples of the divalent linking group represented by L₁ include -CO-, -NR-, -CO-, -O-, -S-, -SO-, -SO₂-, an alkylene group (which preferably has 1 to 6 carbon atoms and may be linear or branched), a cycloalkylene group (preferably having 3 to 15 carbon atoms), an alkenylene group (preferably having 2 to 6 carbon atoms), a divalent aliphatic heterocyclic group (which is preferably a five- to ten-membered ring, more preferably a five- to seven-membered ring, still more preferably a five- or six-membered ring having at least one N atom, O atom, S atom, or Se atom in the ring structure), a divalent aromatic heterocyclic group (which is preferably a five- to ten-membered ring, more preferably a five- to seven-membered ring, still more preferably a five- or six-membered ring having at least one N atom, O atom, S atom, or Se atom in the ring structure), and a divalent aromatic hydrocarbon ring group (which is preferably a six- to ten-membered ring, more preferably a six-membered ring), and a divalent linking group provided by combining the foregoing. R above is, for example, a hydrogen atom or a monovalent organic group. The monovalent organic group is preferably, for example, an alkyl group (preferably having 1 to 6 carbon atoms).

The alkylene group, the cycloalkylene group, the alkenylene group, the divalent aliphatic heterocyclic group, the divalent aromatic heterocyclic group, and the divalent aromatic hydrocarbon ring group may have a substituent. The substituent is, for example, a halogen atom (preferably a fluorine atom).

The divalent linking group represented by L₁ is particularly preferably a divalent linking group represented by Formula (L1).

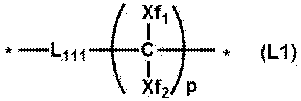

In Formula (L1), L₁₁₁ represents a single bond or a divalent linking group.

The divalent linking group represented by L₁₁₁ may be, for example, -CO-, -NH-, -O-, - SO-, -SO₂-, an alkylene group that may have a substituent (that preferably has 1 to 6 carbon atoms and may be linear or branched), a cycloalkylene group that may have a substituent (preferably having 3 to 15 carbon atoms), an arylene that may have a substituent (preferably having 6 to 10 carbon atoms), or a divalent linking group provided by combining the foregoing. The substituent is, for example, a halogen atom.

p represents an integer of 0 to 3, and preferably represents an integer of 1 to 3.

Each Xf₁ independently represents a fluorine atom or an alkyl group substituted with at least one fluorine atom. The number of carbon atoms of the alkyl group is preferably 1 to 10, more preferably 1 to 4. The alkyl group substituted with at least one fluorine atom is preferably a perfluoroalkyl group.

Each Xf₂ independently represents a hydrogen atom, an alkyl group that may have a fluorine atom as a substituent, or a fluorine atom. The number of carbon atoms of the alkyl group is preferably 1 to 10, more preferably 1 to 4. Xf₂ preferably represents a fluorine atom or an alkyl group substituted with at least one fluorine atom, more preferably a fluorine atom or a perfluoroalkyl group.

Xf₁ and Xf₂ are preferably each independently a fluorine atom or a perfluoroalkyl group having 1 to 4 carbon atoms, more preferably a fluorine atom or CF₃. In particular, Xf₁ and Xf₂ are each still more preferably a fluorine atom.

* represents a bonding site.

When L₁ in Formula (Ia-1) represents a divalent linking group represented by Formula (L1), the direct bond (*) on the L₁₁₁-side in Formula (L1) is preferably bonded to A₁₂⁻ in Formula (Ia-1).

In Formula (I), the organic cations represented by M₁₁⁺ and M₁₂⁺ are, for example, the same as the organic cation represented by M_{A}⁺ in the group represented by Formula (O1) described in an onium salt group, which is one form of the polarity-decreasing group, in the above <Polarity-decreasing group, interactive group, and polar group>, and preferred embodiments thereof are also the same.

Specific examples of the organic cations represented by M₁₁⁺ and M₁₂⁺ are as follows; however, the present invention is not limited to these.

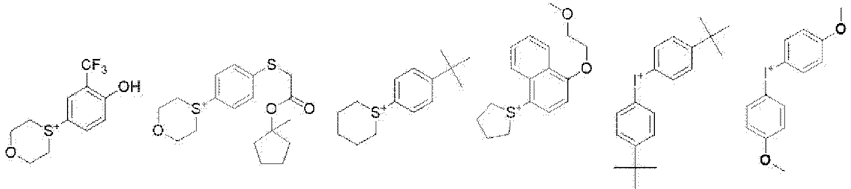

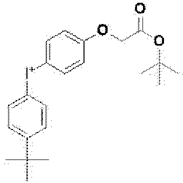

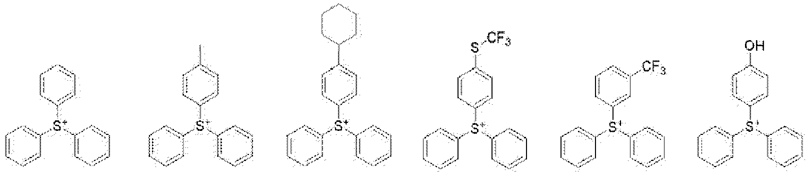

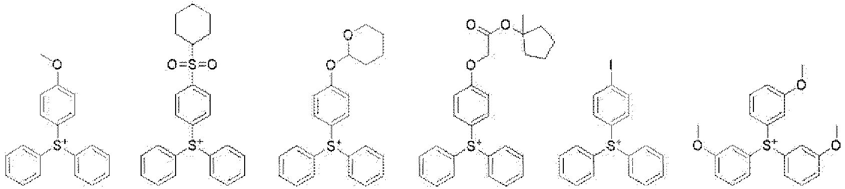

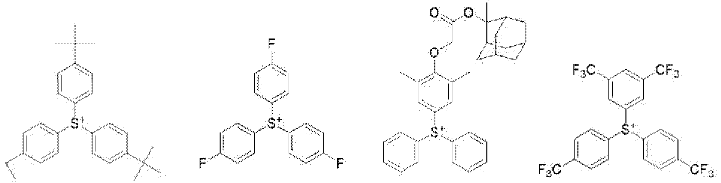

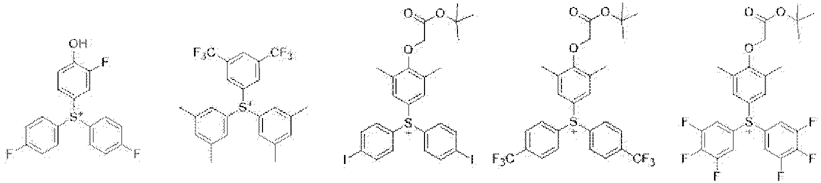

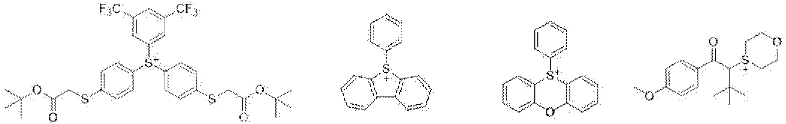

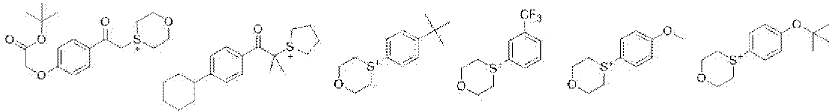

Next, Formulae (Ia-2) to (Ia-4) will be described.

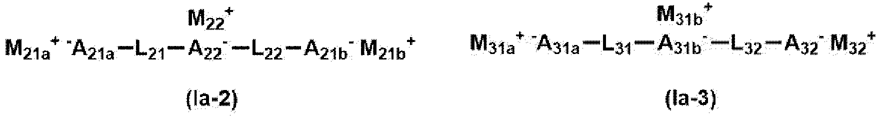

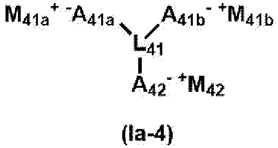

In Formula (Ia-2), A₂₁ₐ⁻ and A_{21b}⁻ each independently represent a monovalent anionic functional group. Here, each of the monovalent anionic functional groups represented by A₂₁ₐ⁻and A_{21b}⁻ means a monovalent group including the above-described anionic moiety A₁⁻. The monovalent anionic functional groups represented by A₂₁ₐ⁻ and A_{21b}⁻ each may be, for example, a monovalent anionic functional group selected from the group consisting of Formulae (AX-1) to (AX-3) above.

A₂₂⁻ represents a divalent anionic functional group. Here, the divalent anionic functional group represented by A₂₂⁻ means a divalent group including the above-described anionic moiety A₂⁻. Examples of the divalent anionic functional group represented by A₂₂⁻ include divalent anionic functional groups represented by Formulae (BX-8) to (BX-11) below.

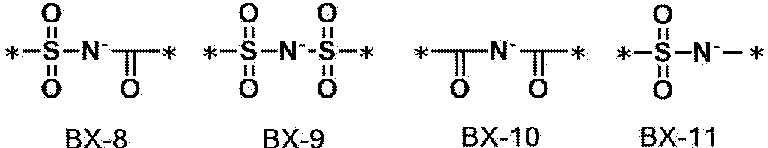

M₂₁ₐ⁺, M_{21b}⁺, and M₂₂⁺ each independently represent an organic cation. The organic cations represented by M₂₁ₐ⁺, M_{21b}⁺, and M₂₂⁺ have the same definitions and preferred embodiments as in M₁⁺ described above.

L₂₁ and L₂₂ each independently represent a divalent organic group.

In a compound PIa-2 in which, in Formula (Ia-2) above, the organic cations represented by M₂₁ₐ⁺, M_{21b}⁺, and M₂₂⁺ are replaced by H⁺, the acid dissociation constant a2 derived from the acidic moiety represented by A₂₂H is larger than the acid dissociation constant a1-1 derived from A₂₁ₐH and the acid dissociation constant a1-2 derived from the acidic moiety represented by A_{21b}H. Note that the acid dissociation constant a1-1 and the acid dissociation constant a1-2 correspond to the above-described acid dissociation constant a1.

A₂₁ₐ⁻ and A_{21b}⁻ may be the same or different. M₂₁ₐ⁺, M_{21b}⁺, and M₂₂⁺ may be the same or different.

At least one of M₂₁ₐ⁺, M_{21b}⁺, M₂₂⁺, A₂₁ₐ⁻, A_{21b}⁻, A₂₂⁻, L₂₁, or L₂₂ may have an acid-decomposable group as a substituent.

In Formula (Ia-3), A₃₁ₐ⁻ and A₃₂⁻ each independently represent a monovalent anionic functional group. The monovalent anionic functional group represented by A₃₁ₐ⁻ has the same definition and preferred embodiments as in the above-described A₂₁ₐ⁻ and A_{21b}⁻ in Formula (Ia-2).

The monovalent anionic functional group represented by A₃₂⁻ means a monovalent group including the above-described anionic moiety A₂⁻. The monovalent anionic functional group represented by A₃₂⁻ may be, for example, a monovalent anionic functional group selected from the group consisting of Formulae (BX-1) to (BX-7) above.

A_{31b}⁻ represents a divalent anionic functional group. Here, the divalent anionic functional group represented by A_{31b}⁻ means a divalent group including the above-described anionic moiety A₁⁻. The divalent anionic functional group represented by A_{31b}⁻ may be, for example, a divalent anionic functional group represented by Formula (AX-4) below.

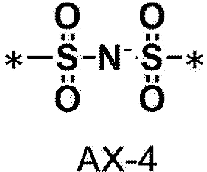

M₃₁ₐ⁺, M_{31b}⁺, and M₃₂⁺ each independently represent a monovalent organic cation. The organic cations represented by M₃₁ₐ⁺, M_{31b}⁺, and M₃₂⁺ have the same definitions and preferred embodiments as in M₁⁺ described above.

L₃₁ and L₃₂ each independently represent a divalent organic group.

In a compound PIa-3, in which, in Formula (Ia-3) above, the organic cations represented by M₃₁ₐ⁺, M_{31b}⁺, and M₃₂⁺ are replaced by H⁺, the acid dissociation constant a2 derived from the acidic moiety represented by A₃₂H is larger than the acid dissociation constant a1-3 derived from the acidic moiety represented by A₃₁ₐH and the acid dissociation constant a1-4 derived from the acidic moiety represented by A_{31b}H. Note that the acid dissociation constant a1-3 and the acid dissociation constant a1-4 correspond to the above-described acid dissociation constant a1.

A₃₁ₐ⁻ and A₃₂⁻ may be the same or different. M₃₁ₐ⁺, M_{31b}⁺, and M₃₂⁺ may be the same or different.

At least one of M₃₁ₐ⁺, M_{31b}⁺, M₃₂⁺, A₃₁ₐ⁻, A_{31b}⁻, A₃₂⁻, L₃₁, or L₃₂ may have an acid-decomposable group as a substituent.

In Formula (Ia-4), A₄₁ₐ⁻, A_{41b}⁻, and A₄₂⁻ each independently represent a monovalent anionic functional group. The definition of the monovalent anionic functional groups represented by A₄₁ₐ⁻ and A_{41b}⁻ is the same as that of the above-described A₂₁ₐ⁻ and A_{21b}⁻ in Formula (Ia-2). The monovalent anionic functional group represented by A₄₂⁻ has the same definition and preferred embodiments as in the above-described A₃₂⁻ in Formula (Ia-3).

M₄₁ₐ⁺, M_{41b}⁺, and M₄₂⁺ each independently represent an organic cation.

L₄₁ represents a trivalent organic group.

In a compound PIa-4 in which, in Formula (Ia-4) above, the organic cations represented by M₄₁ₐ⁺, M_{41b}⁺, and M₄₂⁺ are replaced by H⁺, the acid dissociation constant a2 derived from the acidic moiety represented by A₄₂H is larger than the acid dissociation constant a1-5 derived from the acidic moiety represented by A₄₁ₐH and the acid dissociation constant a1-6 derived from the acidic moiety represented by A_{41b}H. Note that the acid dissociation constant a1-5 and the acid dissociation constant a1-6 correspond to the above-described acid dissociation constant a1.

A₄₁ₐ⁻, A_{41b}⁻, and A₄₂⁻ may be the same or different. M₄₁ₐ⁺, M_{41b}⁺, and M₄₂⁺ may be the same or different.

At least one of M₄₁ₐ^{+,} M_{41b}⁺, M₄₂⁺, A₄₁ₐ⁻, A_{41b}⁻, A₄₂⁻, or L₄₁ may have an acid-decomposable group as a substituent.

Examples of the divalent organic groups represented by L₂₁ and L₂₂ in Formula (Ia-2) and L₃₁ and L₃₂ in Formula (Ia-3) include -CO-, -NR-, -O-, -S-, -SO-, -SO₂-, an alkylene group (which preferably has 1 to 6 carbon atoms and may be linear or branched), a cycloalkylene group (preferably having 3 to 15 carbon atoms), an alkenylene group (preferably having 2 to 6 carbon atoms), a divalent aliphatic heterocyclic group (which is preferably a five- to ten-membered ring, more preferably a five- to seven-membered ring, still more preferably a five- or six-membered ring having at least one N atom, O atom, S atom, or Se atom in the ring structure), a divalent aromatic heterocyclic group (which is preferably a five- to ten-membered ring, more preferably a five- to seven-membered ring, still more preferably a five- or six-membered ring having at least one N atom, O atom, S atom, or Se atom in the ring structure), a divalent aromatic hydrocarbon ring group (which is preferably a six- to ten-membered ring, more preferably a six-membered ring), and a divalent organic group provided by combining the foregoing. R above is, for example, a hydrogen atom or a monovalent organic group. The monovalent organic group is preferably, for example, an alkyl group (preferably having 1 to 6 carbon atoms).

The alkylene group, the cycloalkylene group, the alkenylene group, the divalent aliphatic heterocyclic group, the divalent aromatic heterocyclic group, and the divalent aromatic hydrocarbon ring group may have a substituent. The substituent is, for example, a halogen atom (preferably a fluorine atom).

The divalent organic groups represented by L₂₁ and L₂₂ in Formula (Ia-2) and L₃₁ and L₃₂ in Formula (Ia-3) are also preferably, for example, divalent organic groups represented by Formula (L2).

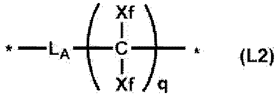

In Formula (L2), q represents an integer of 1 to 3. * represents a bonding site.

Xf's each independently represent a fluorine atom or an alkyl group substituted with at least one fluorine atom. The number of carbon atoms of the alkyl group is preferably 1 to 10, more preferably 1 to 4. The alkyl group substituted with at least one fluorine atom is preferably a perfluoroalkyl group.

Each Xf is preferably a fluorine atom or a perfluoroalkyl group having 1 to 4 carbon atoms, more preferably a fluorine atom or CF₃. In particular, both of Xf's are still more preferably fluorine atoms.

L_{A} represents a single bond or a divalent linking group.

The divalent linking group represented by L_{A} may be, for example, -CO-, -O-, -SO-, - SO₂-, an alkylene group (which preferably has 1 to 6 carbon atoms and may be linear or branched), a cycloalkylene group (preferably having 3 to 15 carbon atoms), a divalent aromatic hydrocarbon ring group (preferably a six- to ten-membered ring, more preferably a six-membered ring), or a divalent linking group provided by combining the foregoing.

The alkylene group, the cycloalkylene group, and the divalent aromatic hydrocarbon ring group may have a substituent. The substituent is, for example, a halogen atom (preferably a fluorine atom).

Examples of the divalent organic group represented by Formula (L2) include *-CF₂-*, *-CF₂-CF₂-*, *-CF₂-CF₂-CF₂-*, *-Ph-O-SO₂-CF₂-*, *-Ph-O-SO₂-CF₂-CF₂-*, *-Ph-O-SO₂-CF₂-CF₂-CF₂-*, and *-Ph-OCO-CF₂-*. Note that Ph is a phenylene group that may have a substituent, and preferably a 1,4-phenylene group. The substituent is preferably an alkyl group (for example, preferably having 1 to 10 carbon atoms, more preferably 1 to 6 carbon atoms), an alkoxy group (for example, preferably having 1 to 10 carbon atoms, more preferably 1 to 6 carbon atoms), or an alkoxycarbonyl group (for example, preferably having 2 to 10 carbon atoms, more preferably 2 to 6 carbon atoms).

When L₂₁ and L₂₂ in Formula (Ia-2) represent a divalent organic group represented by Formula (L2), the direct bond (*) on the L_{A}-side in Formula (L2) is preferably bonded to A₂₂⁻ in Formula (Ia-2).

When L₃₂ in Formula (Ia-3) represents a divalent organic group represented by Formula (L2), the direct bond (*) on the L_{A}-side in Formula (L2) is preferably bonded to A₃₂⁻ in Formula (Ia-3).

The trivalent organic group represented by L₄₁ in Formula (Ia-4) may be, for example, a trivalent organic group represented by Formula (L3).

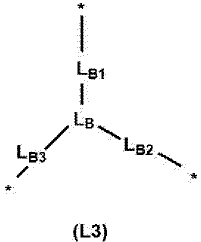

In Formula (L3), L_{B} represents a trivalent hydrocarbon ring group or a trivalent heterocyclic group. * represents a bonding site.

The hydrocarbon ring group may be an aromatic hydrocarbon ring group or an aliphatic hydrocarbon ring group. The number of carbon atoms included in the hydrocarbon ring group is preferably 6 to 18, more preferably 6 to 14. The heterocyclic group may be an aromatic heterocyclic group or an aliphatic heterocyclic group. The heterocycle is preferably a five- to ten-membered ring, more preferably a five- to seven-membered ring, still more preferably a five- or six-membered ring having at least one N atom, O atom, S atom, or Se atom in the ring structure.

L_{B} is preferably a trivalent hydrocarbon ring group, more preferably a benzene ring group or an adamantane ring group. The benzene ring group or the adamantane ring group may have a substituent. The substituent is, for example, a halogen atom (preferably a fluorine atom).

In Formula (L3), L_{B1} to L_{B3} each independently represent a single bond or a divalent linking group. Examples of the divalent linking group represented by L_{B1} to L_{B3} include -CO-, -NR-, -O-, -S-, -SO-, -SO₂-, an alkylene group (which preferably has 1 to 6 carbon atoms and may be linear or branched), a cycloalkylene group (preferably having 3 to 15 carbon atoms), an alkenylene group (preferably having 2 to 6 carbon atoms), a divalent aliphatic heterocyclic group (which is preferably a five- to ten-membered ring, more preferably a five- to seven-membered ring, still more preferably a five- or six-membered ring having at least one N atom, O atom, S atom, or Se atom in the ring structure), a divalent aromatic heterocyclic group (which is preferably a five- to ten-membered ring, more preferably a five- to seven-membered ring, still more preferably a five- or six-membered ring having at least one N atom, O atom, S atom, or Se atom in the ring structure), a divalent aromatic hydrocarbon ring group (which is preferably a six- to ten-membered ring, more preferably a six-membered ring), and a divalent linking group provided by combining the foregoing. R above is, for example, a hydrogen atom or a monovalent organic group. The monovalent organic group is preferably, for example, an alkyl group (preferably having 1 to 6 carbon atoms).

The alkylene group, the cycloalkylene group, the alkenylene group, the divalent aliphatic heterocyclic group, the divalent aromatic heterocyclic group, and the divalent aromatic hydrocarbon ring group may have a substituent. The substituent is, for example, a halogen atom (preferably a fluorine atom).

The divalent linking group represented by L_{B1} to L_{B3} is preferably -CO-, -NR-, -O-, -S-, -SO-, -SO₂-, an alkylene group that may have a substituent, and a divalent linking group provided by combining the foregoing.

In particular, the divalent linking group represented by L_{B1} to L_{B3} is more preferably a divalent linking group represented by Formula (L3-1).

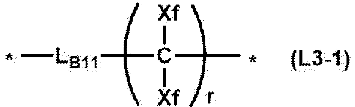

In Formula (L3-1), L_{B11} represents a single bond or a divalent linking group.

Examples of the divalent linking group represented by L_{B11} include -CO-, -O-, -SO-, - SO₂-, an alkylene group that may have a substituent (that preferably has 1 to 6 carbon atoms and may be linear or branched), and a divalent linking group provided by combining the foregoing. The substituent is, for example, a halogen atom.

r represents an integer of 1 to 3.

Xf s have the same definition and preferred embodiments as in the above-described Xf s in Formula (L2).

* represents a bonding site.

Examples of the divalent linking group represented by L_{B1} to L_{B3} include *-O-*, *-O-SO₂-CF₂-*, *-O-SO₂-CF₂-CF₂-*, *-O-SO₂-CF₂-CF₂-CF₂-*, and *-COO-CH₂-CH₂-*.

When L₄₁ in Formula (Ia-4) includes a divalent linking group represented by Formula (L3-1) and the divalent linking group represented by Formula (L3-1) is bonded to A₄₂⁻, the direct bond (*) on the carbon-atom-side clearly shown in Formula (L3-1) is preferably bonded to A₄₂⁻in Formula (Ia-4).

When L₄₁ in Formula (Ia-4) includes a divalent linking group represented by Formula (L3-1) and the divalent linking group represented by Formula (L3-1) is bonded to A₄₁ₐ⁻ and A_{41b}⁻, the direct bond (*) on the carbon-atom-side clearly shown in Formula (L3-1) is also preferably bonded to A₄₁ₐ⁻ and A_{41b}⁻ in Formula (Ia-4).

Next, Formula (Ia-5) will be described.

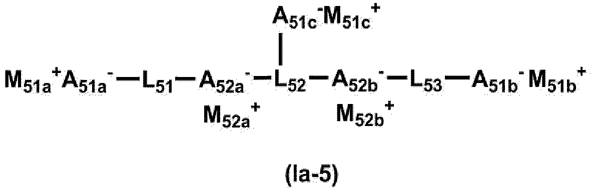

In Formula (Ia-5), A₅₁ₐ⁻, A_{51b}⁻, and A_{51c}⁻ each independently represent a monovalent anionic functional group. Here, the monovalent anionic functional groups represented by A₅₁ₐ⁻, A_{51b}⁻, and A_{51c}⁻ each mean a monovalent group including the above-described anionic moiety A₁⁻. The monovalent anionic functional groups represented by A₅₁ₐ⁻, A_{51b}⁻, and A_{51c}⁻ each may be, for example, a monovalent anionic functional group selected from the group consisting of Formulae (AX-1) to (AX-3) above.

A₅₂ₐ⁻ and A_{52b}⁻ each represent a divalent anionic functional group. Here, the divalent anionic functional groups represented by A₅₂ₐ⁻ and A_{52b}⁻ each mean a divalent group including the above-described anionic moiety A₂⁻. The divalent anionic functional group represented by A₅₂ₐ⁻ and A_{52b}⁻ may be, for example, a divalent anionic functional group selected from the group consisting of Formulae (BX-8) to (BX-11) above.

M₅₁ₐ⁺, M_{31b}⁺, M_{51c}⁺, M₅₂ₐ⁺, and M_{52b}⁺ each independently represent an organic cation. The organic cations represented by M₅₁ₐ⁺, M_{31b}⁺, M_{51c}⁺, M₅₂ₐ⁺, and M_{52b}⁺ have the same definitions and preferred embodiments as in M₁⁺ described above.

L₅₁ and L₅₃ each independently represent a divalent organic group. The divalent organic groups represented by L₅₁ and L₅₃ have the same definitions and preferred embodiments as in the above-described L₂₁ and L₂₂ in Formula (Ia-2). When L₅₁ in Formula (Ia-5) represents a divalent organic group represented by Formula (L2), the direct bond (*) on the L_{A}-side in Formula (L2) is also preferably bonded to A₅₂ₐ⁻ in Formula (Ia-5). When L₅₃ in Formula (Ia-5) represents a divalent organic group represented by Formula (L2), the direct bond (*) on the L_{A}-side in Formula (L2) is also preferably bonded to A_{52b}⁻ in Formula (Ia-5).

L₅₂ represents a trivalent organic group. The trivalent organic group represented by L₅₂ has the same definition and preferred embodiments as in the above-described L₄₁ in Formula (Ia-4). When L₅₂ in Formula (Ia-5) includes a divalent linking group represented by Formula (L3-1) and the divalent linking group represented by Formula (L3-1) is bonded to A_{51c}⁻, the direct bond (*) on the carbon-atom-side clearly shown in Formula (L3-1) is also preferably bonded to A_{51c}⁻ in Formula (Ia-5).

In a compound PIa-5 in which, in Formula (Ia-5) above, the organic cations represented by M₅₁ₐ⁺, M_{51b}⁺, M_{51c}⁺, M₅₂ₐ⁺, and M_{52b}⁺ are replaced by H⁺, the acid dissociation constant a2-1 derived from the acidic moiety represented by A₅₂ₐH and the acid dissociation constant a2-2 derived from the acidic moiety represented by A_{52b}H are larger than the acid dissociation constant a1-1 derived from A₅₁ₐH, the acid dissociation constant a1-2 derived from the acidic moiety represented by A_{51b}H, and the acid dissociation constant a1-3 derived from the acidic moiety represented by A_{51c}H. Note that the acid dissociation constants a1-1 to a1-3 correspond to the above-described acid dissociation constant a1, and the acid dissociation constants a2-1 and a2-2 correspond to the above-described acid dissociation constant a2.

A₅₁ₐ⁻, A_{51b}⁻, and A_{51c}⁻ may be the same or different. A₅₂ₐ⁻ and A_{52b}⁻ may be the same or different. M₅₁ₐ⁺, M_{51b}⁺, M_{51c}⁺, M₅₂ₐ⁺, and M_{52b}⁺ may be the same or different.

At least one of M_{51b}⁺, M_{51c}⁺, M₅₂ₐ⁺, M_{52b}⁺, A₅₁ₐ⁻, A_{51b}⁻, A_{51c}⁻, L₅₁, L₅₂, or L₅₃ may have an acid-decomposable group as a substituent.

### <Compound (II)>

The compound (II) is a compound having two or more structural moieties X described above and one or more structural moieties Z described below and is a compound that generates an acid including two or more first acidic moieties derived from the structural moieties X and the structural moiety Z upon irradiation with an actinic ray or a radiation.
Structural moiety Z: A nonionic moiety capable of neutralizing acid

In the compound (II), the structural moiety X, A₁⁻, and M₁⁺ have the same definitions and preferred embodiments as in the above-described structural moiety X, A₁⁻, and M₁⁺, respectively, in the compound (I).

In a compound PII in which, in the compound (II), the cationic moiety M₁⁺ in the structural moiety X is replaced by H⁺, the acid dissociation constant a1 derived from the acidic moiety represented by HA₁ in which the cationic moiety M₁⁺ in the structural moiety X is replaced by H⁺ has the same preferred range as in the acid dissociation constant a1 in the compound PI.

When the compound (II) is, for example, a compound that generates an acid having two first acidic moieties derived from the structural moieties X and the structural moiety Z, the compound PII corresponds to a "compound having two HA₁". When the acid dissociation constant of this compound PII is determined, the acid dissociation constant determined when the compound PII is turned into a "compound having a single A₁⁻ and a single HA₁" and the acid dissociation constant determined when the "compound having a single A₁⁻ and a single HA₁" is turned into a "compound having two A₁⁻" correspond to the acid dissociation constant a1.

The acid dissociation constant a1 can be determined by the method of measuring an acid dissociation constant described above.

The compound PII corresponds to an acid generated when the compound (II) is irradiated with an actinic ray or a radiation.

The two or more structural moieties X may be the same or different. The two or more A₁⁻and the two or more M₁⁺ may be individually the same or different.

The nonionic moiety in the structural moiety Z, the nonionic moiety being capable of neutralizing acid, is preferably, for example, a moiety including a group capable of electrostatically interacting with a proton or a functional group having an electron.

The group capable of electrostatically interacting with a proton or the functional group having an electron may be, for example, a functional group having a macrocyclic structure such as a cyclic polyether or a functional group having a nitrogen atom having an unshared electron pair that does not contribute to π conjugation. The nitrogen atom having an unshared electron pair that does not contribute to π conjugation is, for example, a nitrogen atom having a partial structure represented by any of the following formulae. 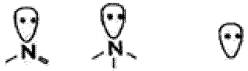 Unshared electron pair

Examples of the partial structure of the group capable of electrostatically interacting with a proton or the functional group having an electron include a crown ether structure, an azacrown ether structure, primary to tertiary amine structures, a pyridine structure, an imidazole structure, and a pyrazine structure. Of these, primary to tertiary amine structures are preferred.

Examples of the compound (II) include compounds represented by Formula (IIa-1) and Formula (IIa-2).

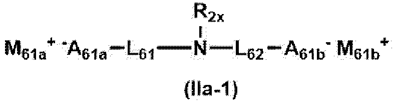

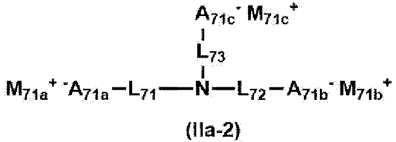

In Formula (IIa-1) above, A₆₁ₐ⁻ and A_{61b}⁻ have the same definitions and preferred embodiments as in the above-described A₁₁⁻ in Formula (Ia-1). M₆₁ₐ⁺ and M_{61b}⁺ have the same definitions and preferred embodiments as in the above-described M₁₁⁺ in Formula (Ia-1).

In Formula (IIa-1) above, L₆₁ and L₆₂ have the same definitions and preferred embodiments as in the above-described L₁ in Formula (Ia-1).

When L₆₁ in Formula (IIa-1) represents a divalent linking group represented by Formula (L1), the direct bond (*) on the L₁₁₁-side in Formula (L1) is preferably bonded to the nitrogen atom clearly shown in Formula (IIa-1). When L₆₂ in Formula (IIa-1) represents a divalent linking group represented by Formula (L1), the direct bond (*) on the L₁₁₁-side in Formula (L1) is preferably bonded to the nitrogen atom clearly shown in Formula (IIa-1).

In Formula (IIa-1), R_{2X} represents a monovalent organic group. The monovalent organic group represented by R_{2X} may be, for example, an alkyl group (which preferably has 1 to 10 carbon atoms and may be linear or branched), a cycloalkyl group (preferably having 3 to 15 carbon atoms), or an alkenyl group (preferably having 2 to 6 carbon atoms), in which -CH₂-may be substituted with one or a combination of two or more selected from the group consisting of -CO-, -NH-, -O-, -S-, -SO-, and -SO₂-.

The alkylene group, the cycloalkylene group, and the alkenylene group may have a substituent. The substituent is, for example, a halogen atom (preferably a fluorine atom).

In a compound PIIa-1 in which, in Formula (IIa-1) above, the organic cations represented by M₆₁ₐ⁺ and M_{61b}⁺ are replaced by H⁺, the acid dissociation constant a1-7 derived from the acidic moiety represented by A₆₁ₐH and the acid dissociation constant a1-8 derived from the acidic moiety represented by A_{61b}H correspond to the above-described acid dissociation constant a1.

The compound PIIa-1 in which, in the compound (IIa-1), the cationic moieties M₆₁ₐ⁺ and M_{61b}⁺ in the structural moiety X are replaced by H⁺ corresponds to HA₆₁ₐ-L₆₁-N(R_{2X})-L₆₂-A_{61b}H. The compound PIIa-1 is the same as the acid generated from the compound represented by Formula (IIa-1) upon irradiation with an actinic ray or a radiation.

At least one of M₆₁ₐ⁺, M_{61b}⁺, A₆₁ₐ⁻, A_{61b}⁻, L₆₁, L₆₂, or R_{2X} may have an acid-decomposable group as a substituent.

In Formula (IIa-2) above, A₇₁ₐ⁻, A_{71b}⁻, and A_{71c}⁻ have the same definitions and preferred embodiments as in the above-described A₁₁⁻ in Formula (Ia-1). M₇₁ₐ⁺, M_{71b}⁺, and M_{71c} have the same definitions and preferred embodiments as in the above-described M₁₁⁺ in Formula (Ia-1).

In Formula (IIa-2) above, L₇₁, L₇₂, and L₇₃ have the same definitions and preferred embodiments as in the above-described L₁ in Formula (Ia-1).

When L₇₁ in Formula (IIa-2) represents a divalent linking group represented by Formula (L1), the direct bond (*) on the L₁₁₁-side in Formula (L1) is preferably bonded to the nitrogen atom clearly shown in Formula (IIa-2). When L₇₂ in Formula (IIa-2) represents a divalent linking group represented by Formula (L1), the direct bond (*) on the L₁₁₁-side in Formula (L1) is preferably bonded to the nitrogen atom clearly shown in Formula (IIa-2). When L₇₃ in Formula (IIa-2) represents a divalent linking group represented by Formula (L1), the direct bond (*) on the L₁₁₁-side in Formula (L1) is preferably bonded to the nitrogen atom clearly shown in Formula (IIa-2).

In a compound PIIa-2 in which, in Formula (IIa-2) above, the organic cations represented by M₇₁ₐ⁺, M_{71b}⁺, and M_{71c}⁺ are replaced by H⁺, the acid dissociation constant a1-9 derived from the acidic moiety represented by A₇₁ₐH, the acid dissociation constant a1-10 derived from the acidic moiety represented by A_{71b}H, and the acid dissociation constant a1-11 derived from the acidic moiety represented by A_{71c}H correspond to the above-described acid dissociation constant a1.

The compound PIIa-2 in which, in the compound (IIa-2), the cationic moieties M₇₁ₐ⁺, M_{71b}⁺, and M_{71c}⁺ in the structural moieties X are replaced by H⁺ corresponds to HA₇₁ₐ-L₇₁-N(L₇₃-A_{71c}H)-L₇₂-A_{71b}H. The compound PIIa-2 is the same as the acid generated from the compound represented by Formula (IIa-2) upon irradiation with an actinic ray or a radiation.

At least one of M₇₁ₐ⁺, M_{71b}⁺, M_{71c}⁺, A₇₁ₐ⁻, A_{71b}⁻, A_{71c}⁻, L₇₁, L₇₂, or L₇₃ may have an acid-decomposable group as a substituent.

The molecular weight of the photoacid generator PG1 is preferably 100 to 10,000, more preferably 100 to 2,500, still more preferably 100 to 1,500.

### <Other photoacid generators>

Another preferred embodiment of the photoacid generator may be a photoacid generator (hereinafter, also referred to as "photoacid generator PG2") other than the above-described photoacid generator PG1.

The photoacid generator PG2 may be, for example, a compound represented by "M⁺X⁻" (onium salt compound) and is preferably a compound that generates an organic acid due to exposure.

Examples of the organic acid include sulfonic acids (such as aliphatic sulfonic acids, aromatic sulfonic acids, and camphorsulfonic acid), carboxylic acids (such as aliphatic carboxylic acids, aromatic carboxylic acids, and aralkyl carboxylic acids), carbonylsulfonylimidic acid, bis(alkylsulfonyl)imidic acids, and tris(alkylsulfonyl)methide acids.

In the compound represented by "M⁺ X⁻", M⁺ represents an organic cation.

The organic cation is, for example, the same as the organic cation represented by M_{A}⁺ in the group represented by Formula (O1) described as an onium salt group, which is one form of the polarity-decreasing group, in the above <Polarity-decreasing group, interactive group, and polar group>. Specifically, a cation represented by Formula (ZaI) (cation (ZaI)) or a cation represented by Formula (ZaII) (cation (ZaII)) is preferred.

In the compound represented by "M⁺ X⁻", X⁻ represents an organic anion.

The organic anion is, for example, the same as the organic cation represented by X_{B}⁻ in the group represented by Formula (O2) described as an onium salt group, which is one form of the polarity-decreasing group, in the above <Polarity-decreasing group, interactive group, and polar group>.

It is also preferable to use, as the photoacid generator PG2, for example, photoacid generators disclosed in paragraphs [0135] to [0171] of WO2018/193954A, paragraphs [0077] to [0116] of WO2020/066824A, and paragraphs [0018] to [0075] and [0334] and [0335] of WO2017/154345A.

The molecular weight of the photoacid generator PG2 is preferably 3,000 or less, more preferably 2,000 or less, still more preferably 1,000 or less.

When the resist composition includes a photoacid generator, the content thereof is preferably 0.5 mass% or more, more preferably 1.0 mass% or more, still more preferably 5.0 mass% or more relative to the total solid content of the resist composition. The content is preferably 40.0 mass% or less, more preferably 30.0 mass% or less.

Such photoacid generators may be used alone or in combination of two or more thereof. When two or more photoacid generators are used, the total content thereof is preferably within the above preferred content range.

### [Acid diffusion control agent]

The resist composition may include an acid diffusion control agent.

The acid diffusion control agent serves as a quencher that traps an acid generated from the photoacid generator or the like upon exposure and that suppresses a reaction of the resin in an unexposed region due to an excess of the generated acid. Examples of the acid diffusion control agent that can be used include a basic compound (CA), a basic compound (CB) that undergoes a decrease or loss of the basicity upon irradiation with an actinic ray or a radiation, a low-molecular-weight compound (CD) having a nitrogen atom and having a group that leaves due to action of an acid, and an onium salt compound (CE) having a nitrogen atom in a cationic moiety. In the resist composition, publicly known acid diffusion control agents can be appropriately used. For example, the publicly known compounds disclosed in paragraphs [0627] to [0664] of US2016/0070167A1, paragraphs [0095] to [0187] of US2015/0004544A1, paragraphs [0403] to [0423] of US2016/0237190A1, and paragraphs [0259] to [0328] of US2016/0274458A1 can be suitably used as acid diffusion control agents.

Examples of the basic compound (CA) include those described in paragraphs [0132] to [0136] of WO2020/066824A. Examples of the basic compound (CB) that undergoes a decrease or loss of the basicity upon irradiation with an actinic ray or a radiation include those described in paragraphs [0137] to [0155] of WO2020/066824A. Examples of the low-molecular-weight compound (CD) having a nitrogen atom and having a group that leaves due to action of an acid include those described in paragraphs [0156] to [0163] of WO2020/066824A. Examples of the onium salt compound (CE) having a nitrogen atom in a cationic moiety include those described in paragraph [0164] of WO2020/066824A.

An onium salt compound that serves as a weak acid relative to a photoacid-generating component can also be used as the acid diffusion control agent.

In the case where a photoacid generator (photoacid generator PG1 and photoacid generator PG2 are also collectively referred to as a photoacid-generating component) is used in combination with an onium salt compound that generates an acid weaker than the acid generated from the photoacid-generating component, when the acid generated from the photoacid-generating component upon irradiation with an actinic ray or a radiation collides with the onium salt compound having an unreacted weak-acid anion, the weak acid is released by salt exchange to generate an onium salt compound having a strong-acid anion. In this process, since the strong acid is exchanged with the weak acid having a lower catalytic ability, the acid is apparently deactivated and acid diffusion can be controlled.

The onium salt compound that serves as a weak acid relative to a photoacid-generating component is preferably a compound represented by any of Formulae (d1-1) to (d1-3).

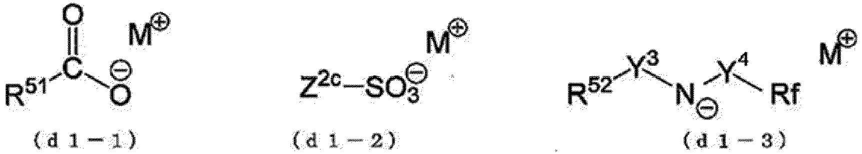

In the formula, R⁵¹ is an organic group. The number of carbon atoms is preferably 1 to 30.

Z^{2c} is an organic group. The number of carbon atoms of the organic group is preferably 1 to 30. However, in the organic group represented by Z^{2c}, when a carbon atom is adjacent to SO³⁻ clearly shown in the formula, this carbon atom (α-carbon atom) does not have a fluorine atom and/or a perfluoroalkyl group as a substituent. The α-carbon atom is other than a ring member atom of a ring structure, and is preferably a methylene group. In Z^{2c}, when the atom at the β-position with respect to SO₃⁻ is a carbon atom (β-carbon atom), the β-carbon atom also does not have a fluorine atom and/or a perfluoroalkyl group as a substituent.

R⁵² is an organic group (such as an alkyl group), Y³ is -SO₂-, a linear, branched, or cyclic alkylene group, or an arylene group, Y⁴ is -CO- or -SO₂-, and Rf is a hydrocarbon group having a fluorine atom (such as a fluoroalkyl group).

Each M⁺ is independently an ammonium cation, a sulfonium cation, or an iodonium cation. M⁺ in Formulae (d1-1) to (d1-3) is, for example, the same as the organic cation represented by M_{A}⁺ in the group represented by Formula (O1) described as an onium salt group, which is one form of the polarity-decreasing group, in the above <Polarity-decreasing group, interactive group, and polar group>.

In one embodiment, these cations also preferably have an acid-decomposable group.

A zwitterion may be used as the acid diffusion control agent. The acid diffusion control agent which is a zwitterion preferably has a carboxylate anion, and also preferably has a sulfonium cation or an iodonium cation.

When the resist composition includes an acid diffusion control agent, the content of the acid diffusion control agent (the total content in the case where a plurality of acid diffusion control agents are present) is preferably 0.1 mass% or more, more preferably 1.0 mass% or more relative to the total solid content of the resist composition. The upper limit is preferably 30.0 mass% or less, more preferably 20.0 mass% or less, still more preferably 10.0 mass% or less.

In the resist composition, such acid diffusion control agents may be used alone or in combination of two or more thereof.

### [Hydrophobic resin]

The resist composition may further include a hydrophobic resin different from the resin described above.

The hydrophobic resin is preferably designed so as to be localized in the surface of a resist film. However, unlike surfactants, the hydrophobic resin does not necessarily need to have a hydrophilic group in the molecule, and does not necessarily contribute to homogeneous mixing of a polar substance and a nonpolar substance.

Advantages due to the addition of the hydrophobic resin are, for example, the control of static and dynamic contact angles at the surface of the resist film for water, and the suppression of outgassing.

From the viewpoint of localization in the surface layer of the film, the hydrophobic resin preferably has one or more, more preferably two or more selected from the group consisting of a fluorine atom, a silicon atom, and a CH₃ moiety included in a side chain moiety of the resin. The hydrophobic resin preferably has a hydrocarbon group having 5 or more carbon atoms. The resin may have such a group in the main chain or, as a substituent, in a side chain.

Examples of the hydrophobic resin include compounds described in paragraphs [0275] to [0279] of WO2020/004306A.

When the resist composition includes a hydrophobic resin, the content of the hydrophobic resin is preferably 0.01 to 20 mass%, more preferably 0.1 to 15 mass% relative to the total solid content of the resist composition.

### [Surfactant]

The resist composition may include a surfactant. The resist composition including a surfactant enables the formation of a pattern having higher adhesiveness and less development defects.

The surfactant is preferably a fluorine-based and/or silicon-based surfactant.

Examples of the fluorine-based and/or silicon-based surfactant include surfactants disclosed in paragraphs [0218] and [0219] of WO2018/193954A.

Such surfactants may be used alone or in combination of two or more thereof.

When the resist composition includes a surfactant, the content of the surfactant is preferably 0.0001 to 2 mass%, more preferably 0.0005 to 1 mass% relative to the total solid content of the resist composition.

### [Solvent]

The resist composition may include a solvent.

The solvent preferably includes at least one of (M1) a propylene glycol monoalkyl ether carboxylate or (M2) at least one selected from the group consisting of a propylene glycol monoalkyl ether, a lactate, an acetate, an alkoxypropionate, a chain ketone, a cyclic ketone, a lactone, and an alkylene carbonate. The solvent may further include a component other than the components (M1) and (M2).

The inventors of the present invention have found that, in the case of using such a solvent and the above-described resin in combination, coatability of the resulting resist composition is improved, and a pattern having a smaller number of development defects can be formed. The reason for this is not necessarily clear; however, the inventors of the present invention consider that this is due to the fact that such solvents are well-balanced in terms of solubility of the resin described above, boiling point, and viscosity, and thus, for example, unevenness of the film thickness of the resist composition film and the generation of precipitates during spin coating can be suppressed.

Details of the component (M1) and the component (M2) are described in paragraphs [0218] to [0226] of WO2020/004306A.

When the solvent further includes a component other than the components (M1) and (M2), the content of the component other than the component (M1) and Formula (M2) is preferably 5 to 30 mass% relative to the total mass of the solvent.

In the resist composition, the content of the solvent is determined such that the concentration of solid content becomes preferably 0.5 to 30 mass%, more preferably 1 to 20 mass%. In such a case, the resist composition has further improved coatability.

### [Other additives]

The resist composition may further include a dissolution-inhibiting compound, a dye, a plasticizer, a photosensitizer, a light absorbent, and/or a compound that improves solubility in developers (for example, a phenolic compound having a molecular weight of 1,000 or less or an alicyclic or aliphatic compound including a carboxy group).

The resist composition may further include a dissolution-inhibiting compound. Herein, the "dissolution-inhibiting compound" refers to a compound that has a molecular weight of 3,000 or less and that is decomposed by the action of an acid to undergo a decrease in the degree of solubility in developers.

The resist composition is suitably used as a photosensitive resist composition for EUV light.

The EUV light has a wavelength of 13.5 nm, which is shorter than the wavelength of ArF (wavelength 193 nm) light and the like, and thus provides a smaller number of incident photons when exposure is performed with the same sensitivity. Therefore, "photon shot noise", which is stochastic variations in the number of photons, exerts a great influence, resulting in degradation of LER and bridge defects. In order to reduce the photon shot noise, a method of increasing the exposure dose to increase the number of incident photons may be employed; however, this method is a trade-off with the demand for higher sensitivity.

When a value A determined by Expression (1) is large, a resist film formed from the resist composition has high absorption efficiency for EUV light and electron beams, which is effective to reduce the photon shot noise. The value A represents the absorption efficiency of the resist film for EUV light and electron beams based on mass proportions. A = ([H] × 0.04 + [C] × 1.0 + [N] × 2.1 + [O] × 3.6 + [F] × 5.6 + [S] × 1.5 + [I] × 39.5) / ([H] × 1 + [C] × 12 + [N] × 14 + [O] × 16 + [F] × 19 + [S] × 32 + [I] × 127)

The value A is preferably 0.120 or more. If the value A is excessively large, the transmittances of the resist film for EUV light and electron beams decrease, the optical image profile in the resist film deteriorates, and as a result, a good pattern shape is less likely to be obtained. Thus, the upper limit is preferably 0.240 or less, more preferably 0.220 or less.

In Expression (1), [H] represents the molar ratio of hydrogen atoms derived from the whole solid content in the resist composition relative to all the atoms of the whole solid content, [C] represents the molar ratio of carbon atoms derived from the whole solid content in the resist composition relative to all the atoms of the whole solid content, [N] represents the molar ratio of nitrogen atoms derived from the whole solid content in the resist composition relative to all the atoms of the whole solid content, [O] represents the molar ratio of oxygen atoms derived from the whole solid content in the resist composition relative to all the atoms of the whole solid content, [F] represents the molar ratio of fluorine atoms derived from the whole solid content in the resist composition relative to all the atoms of the whole solid content, [S] represents the molar ratio of sulfur atoms derived from the whole solid content in the resist composition relative to all the atoms of the whole solid content, and [I] represents the molar ratio of iodine atoms derived from the whole solid content in the resist composition relative to all the atoms of the whole solid content.

For example, when the resist composition includes a resin (A), a photoacid generator, an acid diffusion control agent, and a solvent, the resin (A), the photoacid generator, and the acid diffusion control agent correspond to the solid content. That is, all the atoms of the whole solid content correspond to the total of all the atoms derived from the resin (A), all the atoms derived from the photoacid generator, and all the atoms derived from the acid diffusion control agent. For example, [H] represents the molar ratio of hydrogen atoms derived from the whole solid content relative to all the atoms of the whole solid content, and, in the description based on the above example, [H] represents the molar ratio of the total of the hydrogen atoms derived from the resin (A), the hydrogen atoms derived from the photoacid generator, and the hydrogen atoms derived from the acid diffusion control agent relative to the total of all the atoms derived from the resin (A), all the atoms derived from the photoacid generator, and all the atoms derived from the acid diffusion control agent.

When the structures and contents of constituent components of the whole solid content in the resist composition are known, the value A can be determined by calculating the ratio of the numbers of atoms contained. Even when the constituent components are not known, for a resist film formed by evaporating the solvent component of the resist composition, the ratio of the numbers of constituent atoms can be calculated by an analytical method such as elemental analysis.

### [Method for producing electronic device]

The present invention can also be applied to a method for producing an electronic device, the method including the pattern forming method described above.

The electronic device is suitably mounted on electric or electronic devices (such as household appliances, OA (Office Automation), media-related devices, optical devices, and communication devices).

### EXAMPLES

Hereinafter, the present invention will be described in more detail with reference to Examples. Materials, amounts used, ratios, details of processes, and procedures of processes described in the following Examples may be appropriately changed without departing from the spirit and scope of the present invention. Accordingly, the scope of the present invention should not be construed as being limited to the following Examples.

### [Preparation of resist composition]

The following components were mixed to prepare a liquid mixture.
Polymer 1 54 parts by mass
Photoacid generator 31 parts by mass
Acid diffusion control agent 15 parts by mass
Propylene glycol monomethyl ether acetate 3,430 parts by mass
Propylene glycol monomethyl ether 1,470 parts by mass

The polymer 1 was a polymer having the following two repeating units and had a weight-average molecular weight of 8,700 and a dispersity (Mw/Mn) of 1.23. The molar ratio of the repeating unit represented by U-01 to the repeating unit represented by U-19 was 1:1.

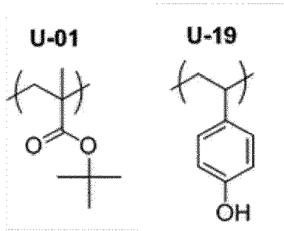

Photoacid generator (refer to the following structural formula)

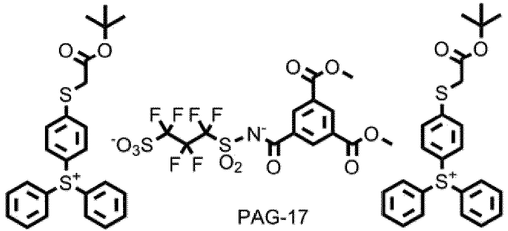

Acid diffusion control agent (refer to the following structural formula)

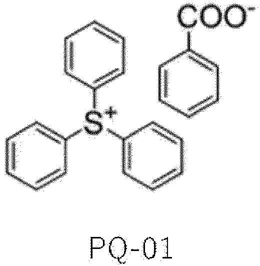

Subsequently, the liquid mixture obtained as described above was filtered through a polyethylene filter having a pore size of 0.03 µm to prepare a resist composition R-1.

### [Preparation of chemical liquid]

Mixing was performed so as to satisfy components and contents listed in tables below to prepare chemical liquids of Examples and Comparative Examples.

The content of the metal X was adjusted by passing the prepared chemical liquid through a filter until the content reached a predetermined value or by adding the metal X. The content of water in each chemical liquid was adjusted to be 20 to 1,000 mass ppm relative to the total mass of the chemical liquid. The contents of the components in each chemical liquid were calculated from the charged amounts or measured by the above-described methods for measuring the contents of the components.

Note that the content of the organic solvent is an amount determined by subtracting the total mass of the aromatic hydrocarbon, the metal X, the alcohol compound, the sulfur-containing compound, and water from the total mass of the chemical liquid.

### [Aliphatic hydrocarbon]

·Undecane
·Hexane
·Hexadecane

### [Ester-based solvent]

·Butyl acetate
·Ethyl acetate
·Hexyl acetate

### [Aromatic hydrocarbon]

·C1: 1-Ethyl-3,5-dimethyl-benzene (C₁(H₁₄)
·C2: 1,2,3,5-Tetramethyl-benzene (C₁(H₁₄)
·C3: (1-Methybutyl)-benzene (C₁₁H₁₆)
·C4: 1,2,3,4-Tetrahydro-naphthalene (C₁₀H₁₂)

### [Alcohol compound]

·1-Butanol
·Methanol

### [Sulfur-containing compound]

·Benzothiophene
·Dimethyl sulfide

### [Examples 1-1 to 1-27 and Comparative Examples 1-1 to 1-5]

### [Formation of resist film and pattern formation (Development)]

An underlayer film-forming composition SHB-A940 (manufactured by Shin-Etsu Chemical Co., Ltd.) was applied onto a 12-inch silicon wafer and baked at 205°C for 60 seconds to form an underlayer film having a film thickness of 20 nm. The resist composition R-1 prepared above was applied thereon, and baking (PB) was performed at 90°C for 60 seconds to form a resist film having a film thickness of 35 nm. Thus, a silicon wafer having a resist film was produced.

The resulting silicon wafer having the resist film was subjected to pattern irradiation using an EUV exposure apparatus (manufactured by Exitech Ltd., Micro Exposure Tool, NA 0.3, Quadrupol, outer sigma 0.68, inner sigma 0.36). A photo mask having a line size of 14 to 25 nm and line: space = 1: 1 was used as a reticle. Subsequently, baking (PEB) was performed at 100°C for 60 seconds, development was then performed with a developer shown in Tables 1 and 2 by puddling for 30 seconds, and the wafer was rotated at a rotational speed of 4,000 rpm for 30 seconds to obtain a line-and-space pattern with a pitch of 28 to 50 nm.

### [Evaluation]

### <Evaluation of resolution>

In the [Formation of resist film and pattern formation (Development)], an exposure dose at which a pattern having a line size of 14 to 25 nm and line: space = 1: 1 was reproduced was defined as an optimum exposure dose (unit: mJ/cm²) for each line size.

A limit resolving power (the minimum line width at which a line and a space are separately resolved, limit resolution) at the optimum exposure dose was defined as a resolution (unit: nm). The evaluation criteria are as follows. Practically, the evaluation result is preferably "C" or higher.
A: less than 18.0 nm
B: 18.0 nm or more and less than 19.0 nm
C: 19.0 nm or more and less than 20.0 nm
D: 20.0 nm or more and less than 21.0 nm
E: 21.0 nm or more

### <Evaluation of ability to suppress occurrence of defects>

After the formation of the pattern obtained above, the defect distribution on the silicon wafer was detected by UVision5 (manufactured by AMAT), and the shapes of the defects were observed using SEMVisionG4 (manufactured by AMAT). The number of defects per silicon wafer was counted and evaluated in accordance with the following evaluation criteria. A smaller number of defects indicates a better result.
A: less than 50
B: 50 or more and less than 200
C: 200 or more and less than 300
D: 300 or more and less than 400
E: 400 or more

### [Examples 2-1 to 2-29 and Comparative Examples 2-1 to 2-5]

### [Formation of resist film and pattern formation (Rinsing liquid)]

A resist film having a film thickness of 35 nm was formed by the same procedure as the above method for forming the resist film.

The resulting silicon wafer having the resist film was subjected to pattern irradiation using an EUV exposure apparatus (manufactured by Exitech Ltd., Micro Exposure Tool, NA 0.3, Quadrupol, outer sigma 0.68, inner sigma 0.36). A photo mask having a line size of 14 to 25 nm and line: space = 1: 1 was used as a reticle. Subsequently, baking (PEB) was performed at 100°C for 60 seconds, development was then performed with a developer shown in Tables 3 an 4 by puddling for 30 seconds, rinsing was performed by pouring a rinsing liquid shown in Tables 3 and 4 for 10 seconds while the wafer was rotated at a rotational speed of 1,000 rpm, and the wafer was then rotated at a rotational speed of 4,000 rpm for 30 seconds to obtain a line-and-space pattern with a pitch of 28 to 50 nm.

The pattern obtained above was evaluated by the same procedures and the same evaluation criteria as in the evaluation of the resolution and the evaluation of the ability to suppress the occurrence of defects.

In the tables below, the notations indicate the following.

The column of "Content (a)" of "Organic solvent" indicates the mass ratio of the content of the aliphatic hydrocarbon to the total mass of the organic solvent.

The column of "Content (b)" of "Organic solvent" indicates the content of the ester-based solvent relative to the total mass of the organic solvent.

The column of "total" of "Aromatic hydrocarbon" indicates the total content of the aromatic hydrocarbons C1 to C4 relative to the total mass of the chemical liquid.

The columns of "C1" to "C4" of "Aromatic hydrocarbon" indicate the respective contents (mass ppm) of the aromatic hydrocarbons C1 to C4 relative to the total mass of the chemical liquid.

The column of "total" of "Metal X" indicates the total content (mass ppt) of Fe, Ni, and Al relative to the total mass of the chemical liquid.

The columns of "Fe", "Ni", and "Al" of "Metal X" indicate the respective contents (mass ppt) of Fe, Ni, and Al relative to the total mass of the chemical liquid.

The column of "(c)/(e)" indicates the mass ratio of the content of the aromatic hydrocarbon to the content of the metal X (total content of Fe, Ni, and Al) (content of aromatic hydrocarbon/content of metal X (total content of Fe, Ni, and Al)). "E+n" indicates "× 10ⁿ", and "E-n" indicates "× 10⁻ⁿ". n represents an integer of 0 or more. Specifically, "1.2E+06" indicates "1.2 × 10⁶". The same meanings of the "E+n" and the "E-n" also apply to those in the other columns.

The column of "Content" of "Alcohol compound" indicates the content (mass ppm) of the alcohol compound relative to the total mass of the chemical liquid.

The column of "(c)/(f)" indicates the mass ratio of the content of the aromatic hydrocarbon to the content of the alcohol compound (content of aromatic hydrocarbon /content of alcohol compound).

The column of "Sulfur-containing compound" indicates the content (mass ppm) of the sulfur-containing compound relative to the total mass of the chemical liquid.

The column of "(c)/(g)" indicates the mass ratio of the content of the aromatic hydrocarbon to the content of the sulfur-containing compound (content of aromatic hydrocarbon/content of sulfur-containing compound).

**Table 1**

| Table 1 | Resist composition | Chemical liquid (Developer) | | | | | | | | |
|---|---|---|---|---|---|---|---|---|---|---|
| | | Organic solvent | | | | Aromatic hydrocarbon (mass ppm) | | | | |
| | | Aliphatic hydrocarbon (a) | Ester-based solvent (b) | Content (a) | Content (b) | total (c) | C1 | C2 | C3 | C4 |
| Example 1-1 | R-1 | Undecane | Butyl acetate | 1 | 99 | 12 | 5 | 3 | 3 | 1 |
| Example 1-2 | R-1 | Undecane | Butyl acetate | 5 | 95 | 60 | 22 | 19 | 14 | 5 |
| Example 1-3 | R-1 | Undecane | Butyl acetate | 10 | 90 | 50 | 19 | 18 | 11 | 3 |
| Example 1-4 | R-1 | Undecane | Butyl acetate | 10 | 90 | 120 | 42 | 38 | 28 | 12 |
| Example 1-5 | R-1 | Undecane | Butyl acetate | 10 | 90 | 190 | 69 | 66 | 33 | 22 |
| Example 1-6 | R-1 | Undecane | Butyl acetate | 10 | 90 | 192 | 48 | 42 | 22 | 40 |
| Example 1-7 | R-1 | Undecane | Butyl acetate | 15 | 85 | 180 | 69 | 68 | 31 | 12 |
| Example 1-8 | R-1 | Undecane | Butyl acetate | 20 | 80 | 240 | 87 | 63 | 60 | 30 |
| Example 1-9 | R-1 | Undecane | Butyl acetate | 25 | 75 | 300 | 107 | 97 | 66 | 30 |
| Example 1-10 | R-1 | Undecane | Butyl acetate | 45 | 55 | 540 | 197 | 195 | 98 | 51 |
| Example 1-11 | R-1 | Hexane | Butyl acetate | 10 | 90 | 100 | 38 | 33 | 23 | 6 |
| Example 1-12 | R-1 | Hexadecane | Butyl acetate | 10 | 90 | 160 | 65 | 50 | 35 | 10 |
| Example 1-13 | R-1 | Undecane | Ethyl acetate | 10 | 90 | 110 | 43 | 38 | 25 | 4 |
| Example 1-14 | R-1 | Undecane | Hexyl acetate | 10 | 90 | 130 | 55 | 50 | 23 | 3 |
| Example 1-15 | R-1 | Undecane | Butyl acetate | 10 | 90 | 120 | 46 | 40 | 28 | 7 |
| Example 1-16 | R-1 | Undecane | Butyl acetate | 10 | 90 | 120 | 38 | 35 | 35 | 12 |
| Example 1-17 | R-1 | Undecane | Butyl acetate | 10 | 90 | 90 | 35 | 30 | 21 | 4 |
| Example 1-18 | R-1 | Undecane | Butyl acetate | 10 | 90 | 115 | 43 | 40 | 28 | 4 |
| Example 1-19 | R-1 | Undecane | Butyl acetate | 10 | 90 | 1800 | 678 | 588 | 414 | 120 |
| Example 1-20 | R-1 | Undecane | Butyl acetate | 10 | 90 | 10 | 4 | 4 | 2 | 1 |
| Example 1-21 | R-1 | Undecane | Butyl acetate | 10 | 90 | 1200 | 435 | 379 | 276 | 110 |
| Example 1-22 | R-1 | Undecane | Butyl acetate | 10 | 90 | 10 | 4 | 4 | 1 | 1 |
| Example 1-23 | R-1 | Undecane | Butyl acetate | 10 | 90 | 850 | 323 | 281 | 196 | 51 |
| Example 1-24 | R-1 | Undecane | Butyl acetate | 10 | 90 | 8 | 4 | 2 | 1 | 1 |
| Example 1-25 | R-1 | Undecane | Butyl acetate | 10 | 90 | 81 | 32 | 27 | 20 | 2 |
| Example 1-26 | R-1 | Undecane | Butyl acetate | 10 | 90 | 1800 | 569 | 544 | 465 | 223 |
| Example 1-27 | R-1 | Undecane | Butyl acetate | 10 | 90 | 20 | 8 | 8 | 3 | 1 |
| Comparative Example 1-1 | R-1 | Undecane | Butyl acetate | 10 | 90 | 500000 | 179000 | 154000 | 115000 | 52000 |
| Comparative Example 1-2 | R-1 | Undecane | Butyl acetate | 10 | 90 | 400000 | 152000 | 136500 | 88500 | 23000 |
| Comparative Example 1-3 | R-1 | Undecane | Butyl acetate | 10 | 90 | 0.1 | 0.05 | 0.04 | 0.01 | 0.01 |
| Comparative Example 1-4 | R-1 | Undecane | Butyl acetate | 10 | 90 | 60 | 22.5 | 18.5 | 16 | 3 |
| Comparative Example 1-5 | R-1 | Undecane | Butyl acetate | 10 | 90 | 1 | 0.475 | 0.275 | 0.2 | 0.05 |

**Table 2**

| Table 2 | Chemical liquid (Developer) | | | | | | | | | | Evaluation results | |
|---|---|---|---|---|---|---|---|---|---|---|---|---|
| | Metal X (mass ppt) | | | | (c)/(e) | Alcohol compound | | (c)/(f) | Sulfur-containing compound (9) (mass ppm) | (c)/(g) | Resolution | Ability to suppress occurrence of defects |
| | total (e) | Fe | Ni | A1 | | Content (f) (mass ppm) | Type | | | | | |
| Example 1-1 | 10 | 7.5 | 2 | 0.5 | 1.2E+06 | 50 | 1-Butanol | 2.4E-01 | 0.05 | 240 | C | A |
| Example 1-2 | 15 | 12.8 | 0.2 | 2 | 4.0E+06 | 45 | 1-Butanol | 1.3E+00 | 0.06 | 1000 | B | A |
| Example 1-3 | 20 | 15 | 2 | 3 | 2.5E+06 | 40 | 1-Butanol | 1.3E+00 | 0.05 | 1000 | A | A |
| Example 1-4 | 20 | 15 | 2 | 3 | 6.0E+06 | 40 | 1-Butanol | 3.0E+00 | 0.05 | 2400 | A | A |
| Example 1-5 | 20 | 15 | 2 | 3 | 9.5E+06 | 40 | 1-Butanol | 4.8E+00 | 0.05 | 3800 | A | A |
| Example 1-6 | 18 | 13 | 2 | 3 | 1.1E+07 | 40 | 1-Butanol | 4.8E+00 | 0.05 | 3840 | A | B |
| Example 1-7 | 22 | 15 | 3 | 4 | 8.2E+06 | 55 | 1-Butanol | 3.3E+00 | 0.03 | 6000 | A | A |
| Example 1-8 | 23 | 17 | 2 | 4 | 1.0E+07 | 30 | 1-Butanol | 8.0E+00 | 0.07 | 3429 | B | A |
| Example 1-9 | 25 | 17 | 3 | 5 | 1.2E+07 | 35 | 1-Butanol | 8.6E+00 | 0.06 | 5000 | B | A |
| Example 1-10 | 35 | 10 | 15 | 10 | 1.5E+07 | 22 | 1-Butanol | 2.5E+01 | 0.08 | 6750 | C | A |
| Example 1-11 | 25 | 15 | 7 | 3 | 4.0E+06 | 38 | 1-Butanol | 2.6E+00 | 0.05 | 2000 | B | A |
| Example 1-12 | 18 | 13 | 2 | 3 | 8.9E+06 | 40 | 1-Butanol | 4.0E+00 | 0.04 | 4000 | B | A |
| Example 1-13 | 21 | 11 | 7 | 3 | 5.2E+06 | 39 | 1-Butanol | 2.8E+00 | 0.06 | 1833 | C | A |
| Example 1-14 | 19 | 13 | 2 | 4 | 6.8E+06 | 44 | 1-Butanol | 3.0E+00 | 0.05 | 2600 | C | A |
| Example 1-15 | 20 | 15 | 2 | 3 | 6.0E+06 | 30 | Methanol | 4.0E+00 | 0.05 | 2400 | B | A |
| Example 1-16 | 20 | 15 | 2 | 3 | 6.0E+06 | 3000 | Methanol | 4.0E-02 | 0.05 | 2400 | C | A |
| Example 1-17 | 70 | 45 | 15 | 10 | 1.3E+06 | 40 | 1-Butanol | 2.3E+00 | 0.08 | 1125 | A | C |
| Example 1-18 | 0.5 | 0.3 | 0.1 | 0.1 | 2.3E+08 | 45 | 1-Butanol | 2.6E+00 | 0.05 | 2300 | A | A |
| Example 1-19 | 18 | 14 | 2 | 2 | 1.0E+08 | 40 | 1-Butanol | 4.5E+01 | 0.05 | 36000 | B | B |
| Example 1-20 | 29 | 15 | 7 | 7 | 3.4E+05 | 55 | 1-Butanol | 1.8E-01 | 0.05 | 200 | A | A |
| Example 1-21 | 75 | 35 | 30 | 10 | 1.6E+07 | 40 | 1-Butanol | 3.0E+01 | 0.05 | 24000 | B | C |
| Example 1-22 | 8 | 2 | 3 | 3 | 1.3E+06 | 40 | 1-Butanol | 2.5E-01 | 0.05 | 200 | A | A |
| Example 1-23 | 80 | 35 | 20 | 25 | 1.1E+07 | 0.03 | 1-Butanol | 2.8E+04 | 0.05 | 17000 | B | C |
| Example 1-24 | 70 | 35 | 20 | 15 | 1.1E+05 | 7000 | 1-Butanol | 1.1E-03 | 0.05 | 160 | C | B |
| Example 1-25 | 19 | 15 | 2 | 2 | 4.3E+06 | 60 | 1-Butanol | 1.4E+00 | 10 | 8 | C | C |
| Example 1-26 | 1 | 0.7 | 0.2 | 0.1 | 1.8E+09 | 45 | 1-Butanol | 4.0E+01 | 0.05 | 36000 | B | A |
| Example 1-27 | 200 | 100 | 60 | 40 | 1.0E+05 | 40 | 1-Butanol | 5.0E-01 | 0.05 | 400 | A | C |
| Comparative Example 1-1 | 2 | 1 | 1 | 0 | 2.5E+11 | 120 | 1-Butanol | 4.2E+03 | 006 | 8333333 | D | A |
| Comparative Example 1-2 | 0.05 | 0.02 | 0.02 | 0.01 | 8.0E+12 | 120 | 1-Butanol | 3.3E+03 | 006 | 6666667 | D | A |
| Comparative Example 1-3 | 80 | 10 | 30 | 40 | 1.3E+03 | 90 | 1-Butanol | 1.1E-03 | 0.05 | 2 | A | D |
| Comparative Example 1-4 | 2000 | 450 | 670 | 880 | 3.0E+04 | 120 | 1-Butanol | 5.0E-01 | 006 | 1000 | A | D |
| Comparative Example 1-5 | 6000 | 2000 | 2200 | 1800 | 1.7E+02 | 120 | 1-Butanol | 8.3E-03 | 006 | 17 | A | E |

**Table 3**

| Table 3 | Resist composition | Developer | Chemical liquid (Rinsing liquid) | | | | | | | | |
|---|---|---|---|---|---|---|---|---|---|---|---|
| | | | Organic solvent | | | | Aromatic hydrocarbon (mass ppm) | | | | |
| | | | Aliphatic hydrocarbon (a) | Ester-based solvent (b) | Content (a) | Content (b) | total (c) | C1 | C2 | C3 | C4 |
| Example 2-1 | R-1 | Butyl acetate | Undecane | Butyl acetate | 1 | 99 | 13 | 5 | 4 | 3 | 1 |
| Example 2-2 | R-1 | Butyl acetate | Undecane | Butyl acetate | 5 | 95 | 55 | 20 | 16 | 14 | 5 |
| Example 2-3 | R-1 | Butyl acetate | Undecane | Butyl acetate | 10 | 90 | 60 | 21 | 21 | 15 | 3 |
| Example 2-4 | R-1 | Butyl acetate | Undecane | Butyl acetate | 10 | 90 | 130 | 48 | 42 | 28 | 12 |
| Example 2-5 | R-1 | Butyl acetate | Undecane | Butyl acetate | 10 | 90 | 180 | 67 | 62 | 29 | 22 |
| Example 2-6 | R-1 | Butyl acetate | Undecane | Butyl acetate | 10 | 90 | 188 | 66 | 62 | 20 | 40 |
| Example 2-7 | R-1 | Butyl acetate | Undecane | Butyl acetate | 15 | 85 | 190 | 76 | 71 | 31 | 12 |
| Example 2-8 | R-1 | Butyl acetate | Undecane | Butyl acetate | 20 | 80 | 220 | 82 | 68 | 40 | 30 |
| Example 2-9 | R-1 | Butyl acetate | Undecane | Butyl acetate | 50 | 50 | 560 | 216 | 192 | 122 | 30 |
| Example 2-10 | R-1 | Butyl acetate | Undecane | Butyl acetate | 100 | 0 | 1100 | 420 | 372 | 267 | 51 |
| Example 2-11 | R-1 | Butyl acetate | Hexane | Butyl acetate | 10 | 90 | 120 | 42 | 42 | 30 | 6 |
| Example 2-12 | R-1 | Butyl acetate | Hexadecane | Butyl acetate | 10 | 90 | 150 | 56 | 47 | 37 | 10 |
| Example 2-13 | R-1 | Butyl acetate | Undecane | Ethyl acetate | 10 | 90 | 110 | 43 | 38 | 25 | 4 |
| Example 2-14 | R-1 | Butyl acetate | Undecane | Hexyl acetate | 10 | 90 | 115 | 50 | 44 | 18 | 3 |
| Example 2-15 | R-1 | Butyl acetate | Undecane | Butyl acetate | 10 | 90 | 130 | 48 | 44 | 31 | 7 |
| Example 2-16 | R-1 | Butyl acetate | Undecane | Butyl acetate | 10 | 90 | 130 | 42 | 40 | 36 | 12 |
| Example 2-17 | R-1 | Butyl acetate | Undecane | Butyl acetate | 10 | 90 | 100 | 39 | 34 | 23 | 4 |
| Example 2-18 | R-1 | Butyl acetate | Undecane | Butyl acetate | 10 | 90 | 120 | 46 | 42 | 28 | 4 |
| Example 2-19 | R-1 | Butyl acetate | Undecane | Butyl acetate | 10 | 90 | 1800 | 744 | 702 | 234 | 120 |
| Example 2-20 | R-1 | Butyl acetate | Undecane | Butyl acetate | 10 | 90 | 10 | 4 | 3 | 2 | 1 |
| Example 2-21 | R-1 | Butyl acetate | Undecane | Butyl acetate | 10 | 90 | 1200 | 440 | 382 | 277 | 101 |
| Example 2-22 | R-1 | Butyl acetate | Undecane | Butyl acetate | 10 | 90 | 10 | 5 | 3 | 1 | 1 |
| Example 2-23 | R-1 | Butyl acetate | Undecane | Butyl acetate | 10 | 90 | 850 | 290 | 269 | 240 | 51 |
| Example 2-24 | R-1 | Butyl acetate | Undecane | Butyl acetate | 10 | 90 | 6 | 2 | 2 | 1 | 1 |
| Example 2-25 | R-1 | Butyl acetate | Undecane | Butyl acetate | 10 | 90 | 80 | 32 | 26 | 20 | 2 |
| Example 2-26 | R-1 | Butyl acetate | Undecane | Butyl acetate | 10 | 90 | 1800 | 610 | 580 | 387 | 223 |
| Example 2-27 | R-1 | Butyl acetate | Undecane | Butyl acetate | 10 | 90 | 20 | 9 | 7 | 3 | 1 |
| Example 2-28 | R-1 | Butyl acetate | Undecane | Butyl acetate | 10 | 90 | 1500 | 620 | 440 | 320 | 120 |
| Example 2-29 | R-1 | Butyl acetate:Undecane = 90:10 | Undecane | Butyl acetate | 70 | 30 | 190 | 69 | 66 | 33 | 22 |
| Comparative Example 2-1 | R-1 | Butyl acetate | Undecane | Butyl acetate | 10 | 90 | 480000 | 173000 | 156000 | 99000 | 52000 |
| Comparative Example 2-2 | R-1 | Butyl acetate | Undecane | Butyl acetate | 10 | 90 | 390000 | 151500 | 128000 | 87500 | 23000 |
| Comparative Example 2-3 | R-1 | Butyl acetate | Undecane | Butyl acetate | 10 | 90 | 0.2 | 0.08 | 0.07 | 0.04 | 0.01 |
| Comparative Example 2-4 | R-1 | Butyl acetate | Undecane | Butyl acetate | 10 | 90 | 70 | 27 | 22 | 18 | 3 |
| Comparative Example 2-5 | R-1 | Butyl acetate | Undecane | Butyl acetate | 10 | 90 | 2 | 0.7 | 0.7 | 0.5 | 0.1 |

**Table 4**

| Table 4 | Chemical liquid (Rinsing liquid) | | | | | | | | | | Evaluation results | |
|---|---|---|---|---|---|---|---|---|---|---|---|---|
| | Metal X (mass ppt) | | | | (c)/(e) | Alcohol compound | | (c)/(f) | Sulfur-containing compound (9) (mass ppm) | (c)/(g) | Resolution | Ability to suppress occurrence of defects |
| | total | Fe | Ni | Al | | Content (f) (mass ppm) | Type | | | | | |
| Example 2-1 | 11 | 9.5 | 1 | 0.5 | 1.2E+06 | 50 | 1-Butanol | 2.6E-01 | 0.05 | 260 | C | A |
| Example 2-2 | 13 | 10.8 | 0.2 | 2 | 4.2E+06 | 45 | 1-Butanol | 1.2E+00 | 0.06 | 917 | B | A |
| Example 2-3 | 21 | 16 | 2 | 3 | 2.9E+06 | 40 | 1-Butanol | 1.5E+00 | 0.05 | 1200 | A | A |
| Example 2-4 | 18 | 13 | 2 | 3 | 7.2E+06 | 40 | 1-Butanol | 3.3E+00 | 0.05 | 2600 | A | A |
| Example 2-5 | 17 | 12 | 2 | 3 | 1.1E+07 | 40 | 1-Butanol | 4.5E+00 | 0.05 | 3600 | A | A |
| Example 2-6 | 18 | 13 | 2 | 3 | 1.0E+07 | 42 | 1-Butanol | 4.5E+00 | 0.05 | 3760 | A | B |
| Example 2-7 | 25 | 18 | 3 | 4 | 7.6E+06 | 55 | 1-Butanol | 3.5E+00 | 0.03 | 6333 | A | A |
| Example 2-8 | 26 | 20 | 2 | 4 | 8.5E+06 | 30 | 1-Butanol | 7.3E+00 | 0.07 | 3143 | A | A |
| Example 2-9 | 22 | 14 | 3 | 5 | 2.5E+07 | 35 | 1-Butanol | 1.6E+01 | 0.06 | 9333 | A | A |
| Example 2-10 | 38 | 13 | 15 | 10 | 2.9E+07 | 22 | 1-Butanol | 5.0E+01 | 0.08 | 13750 | C | A |
| Example 2-11 | 20 | 13 | 4 | 3 | 6.0E+06 | 32 | 1-Butanol | 3.8E+00 | 0.05 | 2400 | B | A |
| Example 2-12 | 22 | 13 | 6 | 3 | 6.8E+06 | 44 | 1-Butanol | 3.4E+00 | 0.05 | 3000 | C | A |
| Example 2-13 | 21 | 13 | 5 | 3 | 5.2E+06 | 35 | 1-Butanol | 3.1E+00 | 0.05 | 2200 | C | A |
| Example 2-14 | 24 | 14 | 7 | 3 | 4.8E+06 | 40 | 1-Butanol | 2.9E+00 | 0.05 | 2300 | C | A |
| Example 2-15 | 18 | 13 | 2 | 3 | 7.2E+06 | 35 | Methanol | 3.7E+00 | 0.05 | 2600 | A | A |
| Example 2-16 | 18 | 13 | 2 | 3 | 7.2E+06 | 4000 | Methanol | 33E-02 | 0.05 | 2600 | B | A |
| Example 2-17 | 61 | 36 | 15 | 10 | 1.6E+06 | 40 | 1-Butanol | 2.5E+00 | 0.08 | 1250 | A | C |
| Example 2-18 | 0.8 | 0.6 | 0.1 | 0.1 | 1.5E+08 | 45 | 1-Butanol | 2.7E+00 | 0.05 | 2400 | A | A |
| Example 2-19 | 16 | 12 | 2 | 2 | 1.1E+08 | 40 | 1-Butanol | 4.5E+01 | 0.05 | 36000 | B | B |
| Example 2-20 | 25 | 11 | 7 | 7 | 4.0E+05 | 55 | 1-Butanol | 1.8E-01 | 0.05 | 200 | A | A |
| Example 2-21 | 70 | 30 | 30 | 10 | 1.7E+07 | 40 | 1-Butanol | 3.0E+01 | 0.05 | 24000 | B | C |
| Example 2-22 | 9 | 3 | 3 | 3 | 1.1E+06 | 40 | 1-Butanol | 2.5E-01 | 0.05 | 200 | A | A |
| Example 2-23 | 85 | 40 | 20 | 25 | 1.0E+07 | 0.03 | 1-Butanol | 2.8E+04 | 0.05 | 17000 | B | C |
| Example 2-24 | 68 | 33 | 20 | 15 | 8.8E+04 | 7000 | 1-Butanol | 8.6E-04 | 0.05 | 120 | C | B |
| Example 2-25 | 20 | 16 | 2 | 2 | 4.0E+06 | 60 | 1-Butanol | 1.3E+00 | 10 | 8 | C | C |
| Example 2-26 | 1.2 | 0.9 | 0.2 | 0.1 | 1.5E+09 | 45 | 1-Butanol | 4.0E+01 | 0.05 | 36000 | B | A |
| Example 2-27 | 88 | 18 | 30 | 40 | 2.3E+05 | 40 | 1-Butanol | 5.0E-01 | 0.05 | 400 | A | C |
| Example 2-28 | 15 | 10 | 4 | 1 | 1.0E+08 | 0 | 1-Butanol | - | 0.08 | 18750 | C | A |
| Example 2-29 | 22 | 15 | 3 | 4 | 3.1E+06 | 55 | 1-Butanol | 1.3E+00 | 0.03 | 6333 | A | A |
| Comparative Example 2-1 | 22 | 1.2 | 1 | 0 | 2.2E+11 | 120 | 1-Butanol | 4.0E+03 | 0.06 | 8000000 | D | A |
| Comparative Example 2-2 | 0.07 | 0.04 | 0.02 | 0.01 | 5.6E+12 | 120 | 1-Butanol | 3.3E+03 | 0.06 | 6500000 | D | A |
| Comparative Example 2-3 | 75 | 5 | 30 | 40 | 2.7E+03 | 90 | 1-Butanol | 2.2E-03 | 0.05 | 4 | A | D |
| Comparative Example 2-4 | 1600 | 50 | 670 | 880 | 4.4E+04 | 120 | 1-Butanol | 5.8E-01 | 0.06 | 1167 | A | D |
| Comparative Example 2-5 | 7600 | 3600 | 2200 | 1800 | 2.6E+02 | 120 | 1-Butanol | 1.7E-02 | 0.06 | 33 | A | E |

From the evaluation results shown in the above tables, it was confirmed that the chemical liquids according to the present invention achieved good resolution of a pattern obtained when used as a developer or a rinsing liquid, and also exhibited a good ability to suppress the occurrence of defects.

It was confirmed that when the content of the aliphatic hydrocarbon was 3 to 30 mass% (preferably 8 to 18 mass%) relative to the total mass of the organic solvent, the resolution was better (for example, comparisons of Examples 1-1 to 1-10). From the same comparisons, it was confirmed that when the content of the aliphatic hydrocarbon was 3 to 30 mass% (preferably 8 to 18 mass%) relative to the total mass of the chemical liquid, the resolution was better.

It was confirmed that when the aromatic hydrocarbon included at least one selected from the group consisting of decane, undecane, dodecane, and methyldecane, the resolution was better (for example, comparisons of Examples 1-4, 1-11, and 1-12).

It was confirmed that when the ester-based solvent included butyl acetate, the resolution was better (for example, comparisons of Examples 1-4, 1-13, and 1-14).

It was confirmed when the alcohol compound included 1-butanol, the resolution was better (for example, comparisons of Examples 1-4, 1-15, and 1-16).

It was confirmed that when the content of the alcohol compound was 0.1 to 5,000 mass ppm relative to the total mass of the chemical liquid, the resolution was better (for example, comparisons of Examples 1-4 and 1-23 to 1-24).

It was confirmed that when the content of the metal X (the total content of Fe, Ni, and Al) was 0.1 to 50 mass ppt, the ability to suppress the occurrence of defects was better (for example, comparisons of Examples 1-4, 1-17, and 1-18).

It was confirmed that when the content of the aromatic hydrocarbon was 5 to 1,000 mass ppm relative to the total mass of the chemical liquid, the resolution and the ability to suppress the occurrence of defects were better (for example, comparisons of Examples 1-4, 1-19, and 1-20).

It was confirmed that when the mass ratio of the content of the aromatic hydrocarbon to the content of the alcohol compound (content of aromatic hydrocarbon/content of alcohol compound) was 0.001 to 200, the resolution and the ability to suppress the occurrence of defects were better (for example, comparisons of Examples 1-4, 1-23, and 1-24).

It was confirmed that when the mass ratio of the content of the aromatic hydrocarbon to the content of the sulfur-containing compound (content of aromatic hydrocarbon/content of sulfur-containing compound) was 100 or more, the resolution and the ability to suppress the occurrence of defects were better (for example, a comparison of Examples 1-4 and 1-25).

It was confirmed that when the mass ratio of the content of the aromatic hydrocarbon to the content of the metals X (content of aromatic hydrocarbon/content of metal X) was 3.0 × 10⁵ to 1.0 × 10⁹, the resolution or the ability to suppress the occurrence of defects was better (for example, comparisons of Examples 1-4, 1-26, and 1-27).

It was confirmed that when the content of the aliphatic hydrocarbon was 5 to 90 mass% relative to the total mass of the chemical liquid, the resolution was better (for example, comparisons of Examples 2-1 to 2-10). In addition, from the same comparisons, it was confirmed that when the content of the aliphatic hydrocarbon was 5 to 90 mass% relative to the total mass of the chemical liquid, the resolution was better.

It was confirmed that when the aromatic hydrocarbon included at least one selected from the group consisting of hexane, decane, undecane, dodecane, and methyldecane, the resolution was better (for example, comparisons of Examples 2-4, 2-11, and 2-12).

It was confirmed that when the ester-based solvent included butyl acetate, the resolution was better (for example, comparisons of Examples 2-4, 2-13, and 2-14).

It was confirmed that when the chemical liquid included an alcohol compound, a better effect of the present invention was provided (for example, a comparison of Examples 2-6 and 2-28).

It was confirmed that when the alcohol compound included 1-butanol, the resolution was better (for example, comparisons of Examples 2-4, 2-15, and 2-16).

It was confirmed that when the content of the alcohol compound was 0.1 to 5,000 mass ppm relative to the total mass of the chemical liquid, the resolution was better (for example, comparisons of Examples 2-4, 2-23, and 2-24).

It was confirmed that when the content of the metal X (the total content of Fe, Ni, and Al) was 0.1 to 50 mass ppt, the ability to suppress the occurrence of defects was better (for example, comparisons of Examples 2-4, 2-17, and 2-18).

It was confirmed that when the content of the aromatic hydrocarbon was 5 to 1,000 mass ppm relative to the total mass of the chemical liquid, the resolution and the ability to suppress the occurrence of defects were better (for example, comparisons of Examples 2-4, 2-18, and 2-19).

It was confirmed that when the mass ratio of the content of the aromatic hydrocarbon to the content of the alcohol compound (content of aromatic hydrocarbon/content of alcohol compound) was 0.001 to 200, the resolution and the ability to suppress the occurrence of defects were better (for example, comparisons of Examples 2-4, 2-23, and 2-24).

It was confirmed that when the mass ratio of the content of the aromatic hydrocarbon to the content of the sulfur-containing compound (content of aromatic hydrocarbon/content of sulfur-containing compound) was 100 or more, the resolution and the ability to suppress the occurrence of defects were better (for example, a comparison of Examples 2-4 and 2-25).

It was confirmed that when the mass ratio of the content of the aromatic hydrocarbon to the content of the metals X (content of aromatic hydrocarbon/content of metal X) was 3.0 × 10⁵ to 1.0 × 10⁹, the resolution or the ability to suppress the occurrence of defects was better (for example, comparisons of Examples 2-4, 2-26, and 2-27).

## Claims

1. A chemical liquid comprising:
an aromatic hydrocarbon;
an organic solvent other than the aromatic hydrocarbon; and
metal X,
wherein the aromatic hydrocarbon is composed only of hydrogen atoms and carbon atoms,
a content of the aromatic hydrocarbon is 1 mass% or less relative to a total mass of the chemical liquid,
the organic solvent includes an aliphatic hydrocarbon,
the metal X is at least one metal selected from the group consisting of Al, Fe, and Ni, and
a mass ratio of the content of the aromatic hydrocarbon to a content of the metal X is 5.0 × 10⁴ to 2.0 × 10¹⁰.

2. The chemical liquid according to claim 1, wherein the chemical liquid is used as a developer or a rinsing liquid.

3. The chemical liquid according to claim 1,
wherein the aromatic hydrocarbon includes at least one selected from the group consisting of C₁₀H₁₄, C₁₁H₁₆, and C₁₀H₁₂, and
the content of the aromatic hydrocarbon is 5 to 2,000 mass ppm relative to the total mass of the chemical liquid.

4. The chemical liquid according to claim 1, further comprising:
a sulfur-containing compound,
wherein the aromatic hydrocarbon includes at least one selected from the group consisting of C₁₀H₁₄, C₁₁H₁₆, and C₁₀H₁₂, and
a content of the C₁₀H₁₄, a content of the C₁₁H₁₆, and a content of the C₁₀H₁₂ are each higher than a content of the sulfur-containing compound.

5. The chemical liquid according to claim 1, further comprising:
a sulfur-containing compound,
wherein a mass ratio of the content of the aromatic hydrocarbon to a content of the sulfur-containing compound is 1 or more.

6. The chemical liquid according to claim 1, comprising three or more of the aromatic hydrocarbons.

7. The chemical liquid according to claim 1, further comprising:
water,
wherein a content of the water is 20 to 1,000 mass ppm relative to the total mass of the chemical liquid.

8. The chemical liquid according to claim 1, wherein a content of at least one of the Al, the Fe, or the Ni is 0.1 to 100 mass ppt relative to the total mass of the chemical liquid.

9. The chemical liquid according to claim 1, wherein the aliphatic hydrocarbon includes at least one selected from the group consisting of decane, undecane, dodecane, and methyldecane.

10. The chemical liquid according to claim 1, further comprising:
an alcohol compound,
wherein a mass ratio of the content of the aromatic hydrocarbon to a content of the alcohol compound is 0.001 to 200.

11. The chemical liquid according to claim 10, wherein the alcohol compound includes at least one selected from the group consisting of ethanol, 1-propanol, 2-propanol, 1-butanol, 2-butanol, tert-butanol, 1-pentanol, 2-pentanol, 3-pentanol, and 2-methyl-1-butanol.

12. The chemical liquid according to claim 1, wherein the organic solvent further includes an ester-based solvent.

13. The chemical liquid according to any one of claims 1 to 12,
wherein, in a pattern forming method including:
a resist film-forming step of forming a resist film using an actinic ray-sensitive or radiation-sensitive resin composition,
an exposure step of exposing the resist film, and
a developing step of developing the exposed resist film with a developer,
the chemical liquid is used as the developer.

14. The chemical liquid according to any one of claims 1 to 12,
wherein, in a pattern forming method including:
a resist film-forming step of forming a resist film using an actinic ray-sensitive or radiation-sensitive resin composition,
an exposure step of exposing the resist film,
a developing step of developing the exposed resist film with butyl acetate, and
a cleaning step of performing cleaning with a rinsing liquid after the developing step,
the chemical liquid is used as the rinsing liquid.

15. The chemical liquid according to any one of claims 1 to 12,
wherein, in a pattern forming method including:
a resist film-forming step of forming a resist film using an actinic ray-sensitive or radiation-sensitive resin composition,
an exposure step of exposing the resist film,
a developing step of developing the exposed resist film with a developer, and
a cleaning step of performing cleaning with a rinsing liquid after the developing step,
the chemical liquid is used as the developer and the rinsing liquid.

16. A pattern forming method comprising:
a resist film-forming step of forming a resist film using an actinic ray-sensitive or radiation-sensitive resin composition;
an exposure step of exposing the resist film;
a developing step of developing the exposed resist film with a developer; and
a cleaning step of performing cleaning with a rinsing liquid after the developing step,
wherein the chemical liquid according to any one of claims 1 to 12 is used as the developer and the rinsing liquid, and
a content of the aliphatic hydrocarbon relative to the organic solvent in the chemical liquid used as the rinsing liquid is higher than a content of the aliphatic hydrocarbon relative to the organic solvent in the chemical liquid used as the developer.
